# EUROPEAN PATENT APPLICATION

(11) **EP 1 591 511 A2**
(43) Date of publication of application: **02.11.2005**
(21) Application number: 05009218.8
(22) Date of filing: 27.04.2005
(51) Int. Cl.: C09K 11/06, C08G 61/10, H01L 51/30, C07F 15/00

(54) **Phosphorescent polymer and production process thereof, organic electroluminescence device, and metal complex-containing compound and production process thereof**

(30) Priority: 28.04.2004 JP 2004132508; 11.06.2004 JP 2004174372; 11.06.2004 JP 2004174373; 13.05.2004 JP 2004143606
(71) Applicant: JSR Corporation, Tokyo 104-0045 (JP)
(72) Inventor: Yasuda, Hiroyuki, Tokyo 104-0045 (JP); Oh, Hyunshik, Tokyo 104-0045 (JP); Shiraki, Shinji, Tokyo 104-0045 (JP)
(74) Representative: TBK-Patent

(57) **Abstract**

The invention provides a phosphorescent polymer that has excellent luminescent properties and capable of forming a film by a wet method, and an organic electroluminescence device that has excellent luminescent properties and durability, can achieve long service life and can be easily produced. The invention also provides a novel metal complex-containing compound used as a monomer for providing the phosphorescent polymer that has excellent luminescent properties and capable of forming a film by a wet method, and a production process thereof.

The phosphorescent polymer has a metal complex-containing group having a phenylpyridine structure which is bonded to a main chain containing an aromatic compound group. The organic electroluminescence device has a luminescent layer formed by the phosphorescent polymer.

The metal complex-containing compound has a metal complex-containing group having a phenylpyridine structure which is bonded to an aromatic compound having two reactive functional groups.

## Description

### BACKGROUND OF THE INVENTION

### Field of the Invention:

The present invention relates to a phosphorescent polymer and a production process thereof, an organic electroluminescence device, and a metal complex-containing compound and a production process thereof, and particularly to a phosphorescent polymer suitably used as an organic material for forming a luminescent layer in an organic electroluminescence device and a production process thereof, an organic electroluminescence device, and a metal complex-containing compound used as a monomer for obtaining the phosphorescent polymer and a production process thereof.

### Description of the Background Art:

An organic electroluminescence device (hereinafter also referred to as "organic EL device") is expected as a display device of the coming generation, since it has such excellent properties as can be driven by DC voltage, is wide in angle of visibility and high in visibility because it is a self-luminescent device, and is fast in the speed of response, and researches thereof are being actively conducted.

In recent years, a luminescent layer of an organic EL device has been required to achieve high luminous efficiency. In order to realize high luminous efficiency, it has been recently attempted to utilize energy of a molecule in a triplet state that is an excitation state, or the like for light emission of the organic EL device.

More specifically, it has been reported that an external quantum efficiency of 8% exceeding 5% that has heretofore been considered to be a critical value of the external quantum efficiency in an organic EL device is achieved according to the organic EL device having such construction (see, for example, "Applied Physics Letters", Vol. 75, p. 4, 1999).

Since a luminescent layer of this organic EL device is formed with a low-molecular weight organic material and by a dry method, for example, a vapor deposition method, that is difficult to meet mass production because the process is complicated, however, the organic EL device involves a problem that its physical durability and thermal durability are low, and so its service life is short.

As the organic EL device utilizing energy of the molecule in the triplet state, or the like, there has been proposed that obtained by forming a luminescent layer with a composition composed of, for example, an iridium complex, which is a triplet luminescent material, polyvinylcarbazole and oxadiazole by a wet method that the process of which is relatively simple and can meet mass production (see, for example, Japanese Patent Application Laid-Open No. 2001-257076).

In this organic EL device, low-molecular weight oxadiazole is contained in the luminescent layer and the device involves a problem that its thermal stability becomes low due to the presence of this low-molecular weight oxadiazole, and so stable luminescence cannot be achieved when continuously driven.

As an organic material for forming a luminescent layer in an organic EL device, there has been proposed a polyvinyl based side chain type polymer having side chains containing an iridium complex that is a triplet luminescent material (see, for example, "Information Display", Vol. 19, p. 22, 2003).

However, the organic EL device having the luminescent layer composed of this side chain type polymer involves a problem that its electrochemical stability is low due to the presence of vinyl groups in the polymer, and so long service life cannot be achieved.

### SUMMARY OF THE INVENTION

The present invention has been completed as a result of repeated researches on polymers suitably usable as an organic material for forming a luminescent layer in an organic EL device and monomers for obtaining such polymers under the foregoing circumstances, and its object is to provide a phosphorescent polymer having excellent luminescent properties and capable of forming a film by a wet method, a production process thereof and an organic electroluminescence device that has excellent luminescent properties and durability, can achieve long service life and can be produced with ease.

Another object of the present invention is to provide a novel metal complex-containing compound used as a monomer for obtaining a phosphorescent polymer having excellent luminescent properties and capable of forming a film by a wet method, and a production process thereof.

According to the present invention, there is thus provided a phosphorescent polymer in which a metal complex-containing group having a phenylpyridine structure is bonded to a main chain containing an aromatic compound group.

The phosphorescent polymer according to the present invention may preferably comprise a metal complex-containing structural unit represented by any one of the following general formula (A) to general formula (D): 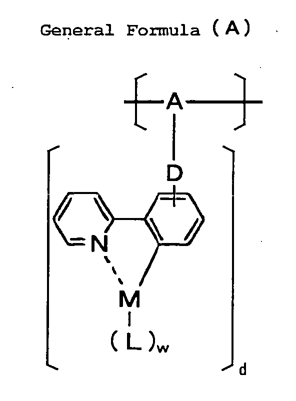 wherein A is an aromatic compound group, D is a single bond, oxygen atom, phenylene group, alkylene group or alkoxylene group, M is a divalent to tetravalent metal atom, L is an organic ligand, w is an integer of 1 to 3, and d is 1 or 2; 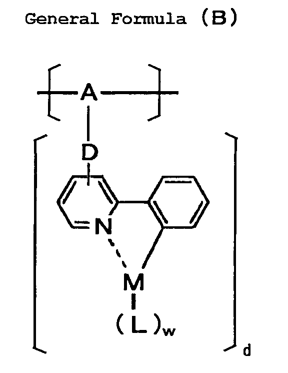 wherein A is an aromatic compound group, D is a single bond, oxygen atom, phenylene group, alkylene group or alkoxylene group, M is a divalent to tetravalent metal atom, L is an organic ligand, w is an integer of 1 to 3, and d is 1 or 2; 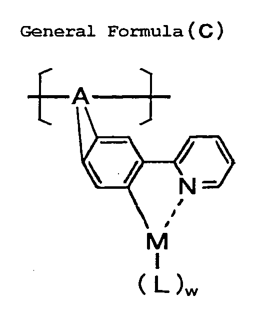 wherein A is an aromatic compound group, M is a divalent to tetravalent metal atom, L is an organic ligand, and w is an integer of 1 to 3; and 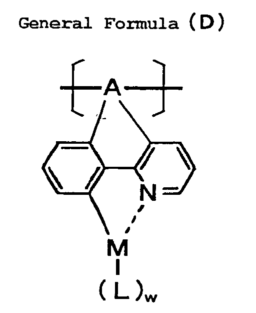 wherein A is an aromatic compound group, M is a divalent to tetravalent metal atom, L is an organic ligand, and w is an integer of 1 to 3.

In the phosphorescent polymer according to the present invention, a proportion of the metal complex-containing structural unit contained may preferably be 0.1 to 10 mol%.

The phosphorescent polymer according to the present invention may preferably have at least one skeleton of a carbazole skeleton, a fluorene skeleton and a diphenyl ether skeleton in its molecule.

In the phosphorescent polymer according to the present invention, the group A in the metal complex-containing structural unit may preferably be an aromatic compound group having at least one skeleton of a carbazole skeleton and a fluorene skeleton.

According to the present invention, there is also provided a process for producing the phosphorescent polymer described above, which comprises a step of reacting a metal complex-containing compound having 2 reactive functional groups with an aromatic compound having 2 reactive functional groups in the presence of a catalyst.

According to the present invention, there is further provided an organic electroluminescence device comprising a luminescent layer formed by the phosphorescent polymer described above.

The organic electroluminescence device according to the present invention may preferably comprise a hole blocking layer.

According to the present invention, there is still further provided a metal complex-containing compound in which a metal complex-containing group having a phenylpyridine structure is bonded to an aromatic compound having 2 reactive functional groups.

The metal complex-containing compound according to the present invention may preferably be composed of a carbazole compound represented by the following general formula (1) : 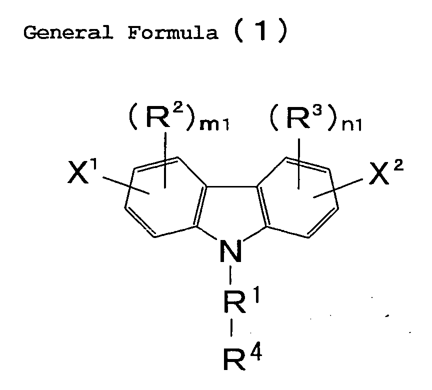 wherein X¹ and X² are, independently of each other, a reactive functional group and may be the same or different from each other, R¹ is a divalent organic group, R² and R³ are, independently of each other, a monovalent organic group and may be the same or different from each other, R⁴ is a group having a structure represented by the following general formula (1-1) or general formula (1-2), m1 is an integer of 0 to 3, and n1 is an integer of 0 to 3: 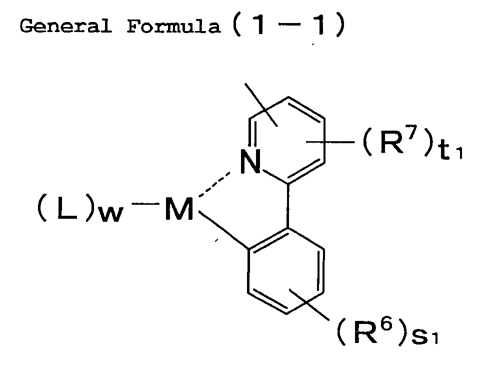 in which R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, s1 is an integer of 0 to 4, t1 is an integer of 0 to 3, and w is an integer of 1 to 3; and 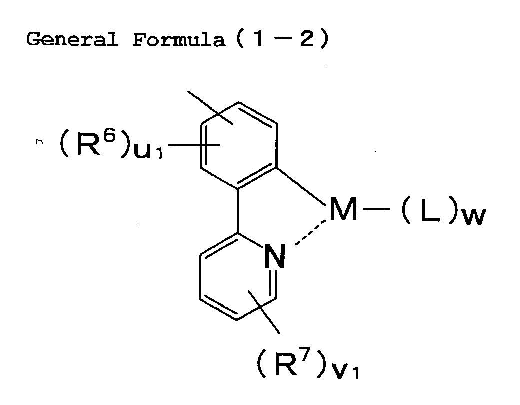 in which R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, u1 is an integer of 0 to 3, v1 is an integer of 0 to 4, and w is an integer of 1 to 3.

According to the present invention, there is yet still further provided a process for producing the metal complex-containing compound composed of the carbazole compound, which comprises steps of reacting a compound represented by the following general formula (1-3) with a compound represented by the following general formula (1-4) or general formula (1-5) to obtain an intermediate reaction product, and reacting this intermediate reaction product with a compound represented by the following general formula (1-6): 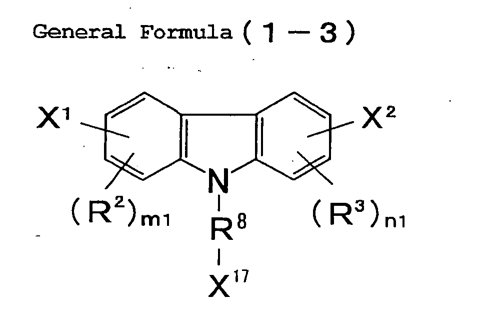 wherein X¹ and X² are, independently of each other, a reactive functional group and may be the same or different from each other, R² and R³ are, independently of each other, a monovalent organic group and may be the same or different from each other, m1 is an integer of 0 to 3, n1 is an integer of 0 to 3, X¹⁷ is a halogen atom, and R⁸ is a divalent organic group; 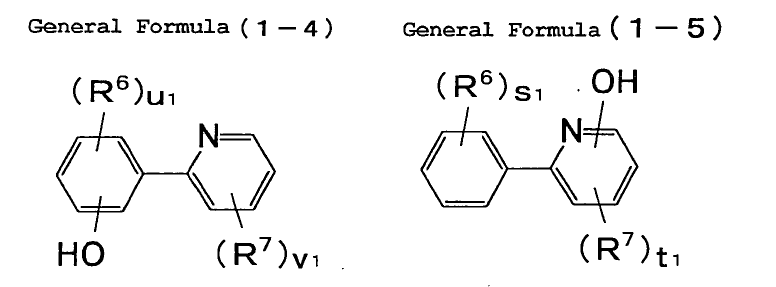 wherein R⁶ and R⁷ are, independently of each other, a fluorine atom, alkyl group or aryl group and may be the same or different from each other, with the proviso that these groups may be substituted or form a cyclic structure, s1 is an integer of 0 to 4, t1 is an integer of 0 to 3, u1 is an integer of 0 to 3, and v1 is an integer of 0 to 4; and 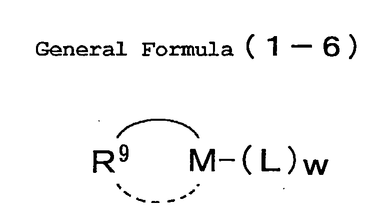 wherein R⁹ is a bidentate chelate ligand having 2 coordinating atoms, M is a divalent to tetravalent metal atom, L is an organic ligand, and w is an integer of 1 to 3.

The metal complex-containing compound according to the present invention may preferably be composed of a spirofluorene compound represented by the following general formula (2): 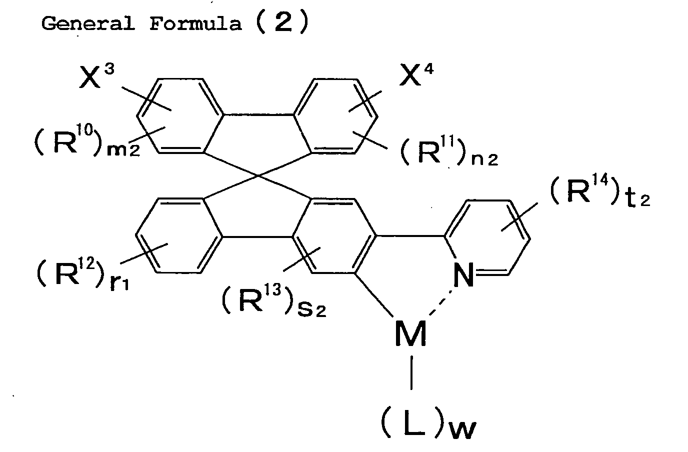 wherein X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹³ and R¹⁹ are, independently of each other, a fluorine atom, alkyl group or aryl group and may be the same or different from each other, with the proviso that these groups may be substituted or form a cyclic structure, M is a divalent to tetravalent metal atom, L is an organic ligand, m2 is an integer of 0 to 3, n2 is an integer of 0 to 3, r1 is an integer of 0 to 4, s2 is an integer of 0 to 2, t2 is an integer of 0 to 4, and w is an integer of 1 to 3.

According to the present invention, there is yet still further provided a process for producing the metal complex-containing compound of the above, composed of the spirofluorene compound, which comprises steps of reacting a compound represented by the following general formula (2-1) with a compound represented by the following general formula (2-2) to obtain an intermediate reaction product, and reacting this intermediate reaction product with a compound represented by the above general formula (1-6): 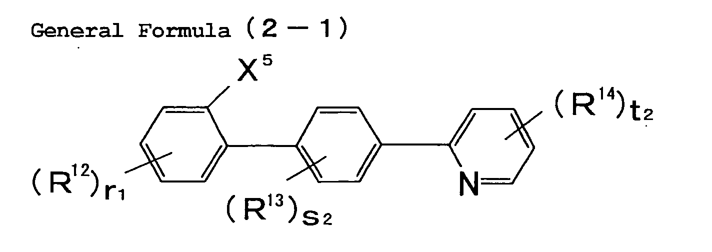 wherein X⁵ is a halogen atom, R¹² is a monovalent organic group, R¹³ and R¹⁴ are, independently of each other, a fluorine atom, alkyl group or aryl group and may be the same or different from each other, with the proviso that these groups may be substituted or form a cyclic structure, r1 is an integer of 0 to 4, s2 is an integer of 0 to 2, and t2 is an integer of 0 to 4; and 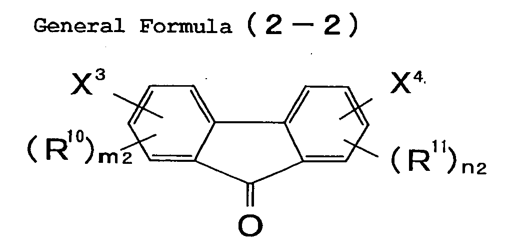 wherein X³ and X⁴ are, independently of each other, a reactive functional group and may be the same or different from each other, R¹⁰ and R¹¹ are, independently of each other, a monovalent organic group and may be the same or different from each other, m2 is an integer of 0 to 3, and n2 is an integer of 0 to 3.

The metal complex-containing compound according to the present invention may preferably be composed of a spirofluorene compound represented by the following general formula (3): 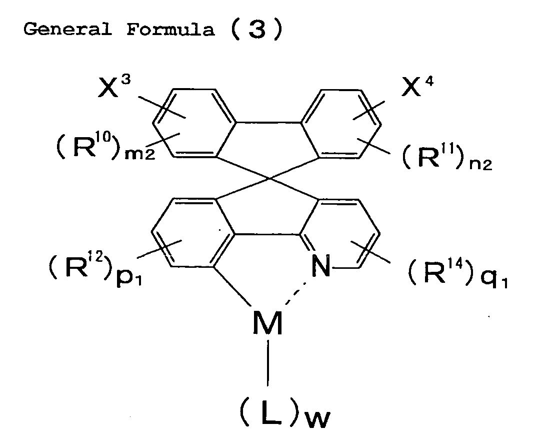 wherein X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹⁴ is a fluorine atom, alkyl group or aryl group, with the proviso that the group may be substituted or form a cyclic structure, M is a divalent to tetravalent metal atom, L is an organic ligand, m2 is an integer of 0 to 3, n2 is an integer of 0 to 3, p1 is an integer of 0 to 3, q1 is an integer of 0 to 3, and w is an integer of 1 to 3.

According to the present invention, there is yet still further provided a process for producing the metal complex-containing compound of the above, composed of the spirofluorene compound, which comprises steps of reacting a compound represented by the following general formula (3-1) with a compound represented by the above general formula (2-2) to obtain an intermediate reaction product, and reacting this intermediate reaction product with a compound represented by the above general formula (1-6): 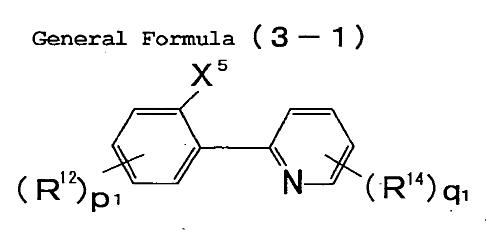 wherein X⁵ is a halogen atom, R¹² is a monovalent organic group, R¹⁴ is a fluorine atom, alkyl group or aryl group, with the proviso that the group may be substituted or form a cyclic structure, p1 is an integer of 0 to 3, and q1 is an integer of 0 to 3.

The metal complex-containing compound according to the present invention may preferably be composed of a fluorene compound represented by the following general formula (4): 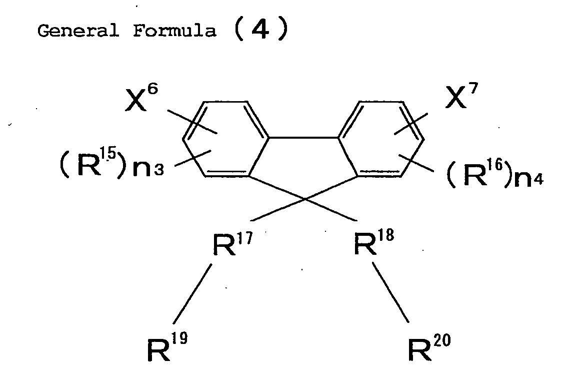 wherein X⁶ and X⁷ are, independently of each other, a halogenic functional group and may be the same or different from each other, R¹⁵ and R¹⁶ are, independently of each other, a monovalent organic group and may be the same or different from each other, R¹⁷ and R¹⁸ are single bonds or divalent organic groups and may be the same or different from each other, at least one of R¹⁹ and R²⁰ is a group having a structure represented by the above general formula (1-1) or general formula (1-2) and the other is a monovalent organic group or a group having a structure represented by the above general formula (1-1) or general formula (1-2), and R¹⁹ and R²⁰ may be the same or different from each other, n3 is an integer of 0 to 3, and n4 is an integer of 0 to 3.

According to the present invention, there is yet still further provided a process for producing the metal complex-containing compound composed of the fluorene compound, which comprises steps of reacting a compound represented by the following general formula (4-1) with a compound represented by the following general formula (4-2) to obtain an intermediate reaction product, and reacting this intermediate reaction product with a compound represented by the above general formula (1-6): 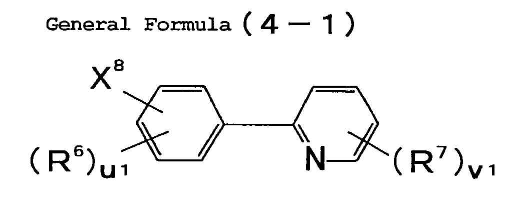 wherein X⁸ is a halogen atom, R⁶ and R⁷ are, independently of each other, a fluorine atom, alkyl group or aryl group and may be the same or different from each other, with the proviso that these groups may be substituted or form a cyclic structure, u1 is an integer of 0 to 3, and v1 is an integer of 0 to 4; and 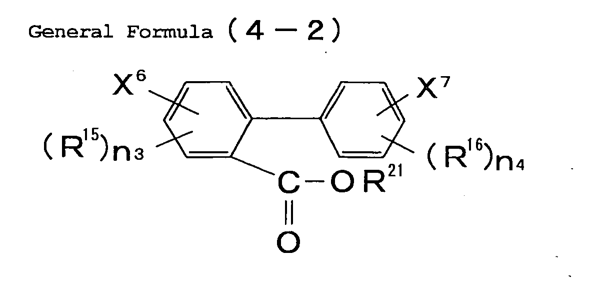 wherein X⁶ and X⁷ are, independently of each other, a halogenic functional group and may be the same or different from each other, R¹⁵ and R¹⁶ are, independently of each other, a monovalent organic group and may be the same or different from each other, R²¹ is a monovalent organic group, n3 is an integer of 0 to 3, and n4 is an integer of 0 to 3.

According to the present invention, there is yet still further provided a process for producing the metal complex-containing compound composed of the fluorene compound, which comprises steps of reacting a compound represented by the following general formula (4-3) with a compound represented by the following general formula (4-4) to obtain a first intermediate reaction product, reacting this first intermediate reaction product with a halogen to obtain a second intermediate reaction product, and reacting this second intermediate reaction product with a compound represented by the above general formula (1-6): 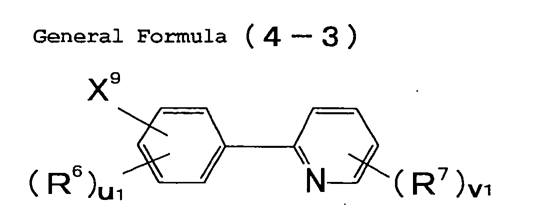 wherein R⁶ and R⁷ are, independently of each other, a fluorine atom, alkyl group or aryl group and may be the same or different from each other, with the proviso that these groups may be substituted or form a cyclic structure, X⁹ is a halogenic functional group or boron derivative functional group, u1 is an integer of 0 to 3, and v1 is an integer of 0 to 4; and 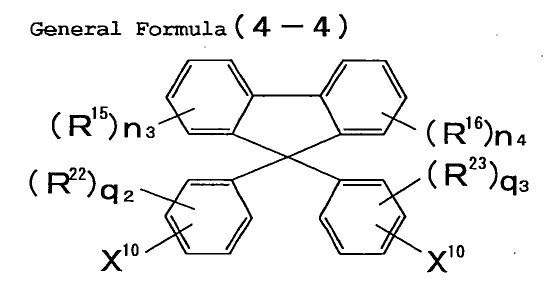 wherein X¹⁰ is a halogenic functional group or boron derivative functional group and is different from X⁹ in the above general formula (4-3), R¹⁵ and R¹⁶ are, independently of each other, a monovalent organic group and may be the same or different from each other, R²² and R²³ are, independently of each other, a monovalent organic group and may be the same or different from each other, n3 is an integer of 0 to 3, n4 is an integer of 0 to 3, q2 is an integer of 0 to 4, and q3 is an integer of 0 to 4.

According to the present invention, there is yet still further provided a process for producing the metal complex-containing compound composed of the fluorene compound, which comprises steps of reacting a compound represented by the following general formula (4-1) with a compound represented by the following general formula (4-5) to obtain a first intermediate reaction product, reacting this first intermediate reaction product with a benzene derivative having 1 to 5 substituent groups each composed of a monovalent organic group to obtain a second intermediate reaction product, and reacting this second intermediate reaction product with a compound represented by the above general formula (1-6): 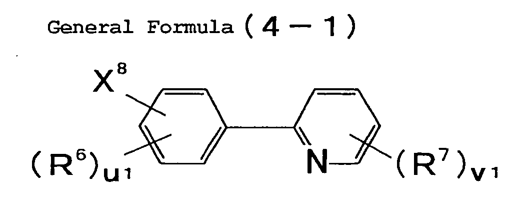 wherein X⁸ is a halogen atom, R⁶ and R⁷ are, independently of each other, a fluorine atom, alkyl group or aryl group and may be the same or different from each other, with the proviso that these groups may be substituted or form a cyclic structure, u1 is an integer of 0 to 3, and v1 is an integer of 0 to 4; and 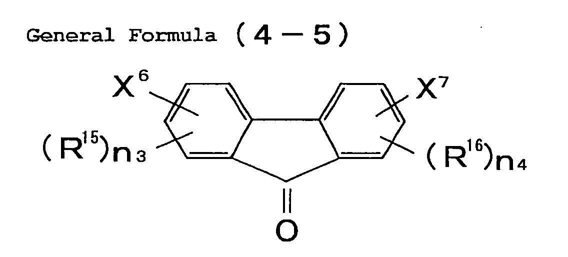 wherein X⁶ and X⁷ are, independently of each other, a halogenic functional group and may be the same or different from each other, R¹⁵ and R¹⁶ are, independently of each other, a monovalent organic group and may be the same or different from each other, n3 is an integer of 0 to 3, and n4 is an integer of 0 to 3.

According to the present invention, there is yet still further provided a process for producing the metal complex-containing compound composed of the fluorene compound, which comprises steps of reacting a compound represented by the above general formula (1-4) with an organic dihalogenide in which halogen substituents are bonded to both terminals of its main chain to obtain a first intermediate reaction product, reacting this first intermediate reaction product with a compound represented by the following general formula (4-6) to obtain a second intermediate reaction product, and reacting this second intermediate reaction product with a compound represented by the above general formula (1-6): 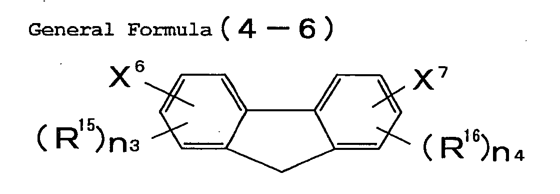 wherein X⁶ and X⁷ are, independently of each other, a halogenic functional group and may be the same or different from each other, R¹⁵ and R¹⁶ are, independently of each other, a monovalent organic group and may be the same or different from each other, n3 is an integer of 0 to 3, and n4 is an integer of 0 to 3.

According to the present invention, there is yet still further provided steps of a process for producing the metal complex-containing compound composed of the fluorene compound, which comprises steps of reacting a compound represented by the following general formula (4-7) with an organic dihalogenide in which halogen substituents are bonded to both terminals of its main chain to obtain a first intermediate reaction product, reacting this first intermediate reaction product with a compound represented by the following general formula (4-8) to obtain a second intermediate reaction product, reacting this second intermediate reaction product with a compound represented by the above general formula (4-6) to obtain a third intermediate reaction product, and reacting this third intermediate reaction product with a compound represented by the above general formula (1-6): 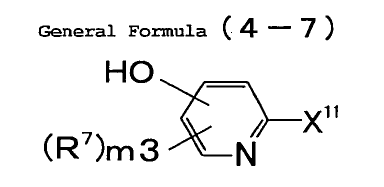 wherein R⁷ is a fluorine atom, alkyl group or aryl group, with the proviso that the group may be substituted or form a cyclic structure, X¹¹ is a halogenic functional group or boron derivative functional group, and m3 is an integer of 0 to 3; and 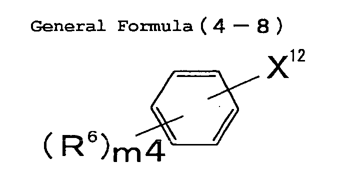 wherein R⁶ is a fluorine atom, alkyl group or aryl group, with the proviso that the group may be substituted or form a cyclic structure, X¹² is a halogenic functional group or boron derivative functional group and is different from X¹¹ in the above general formula (4-7), and m4 is an integer of 0 to 4.

According to the phosphorescent polymers of the present invention, since the phosphorescent polymers have excellent luminescent properties and is capable of forming a film by the wet method, a luminescent layer of an organic EL device can be formed with only one component of the phosphorescent polymers. Accordingly, the organic EL device of the present invention having the luminescent layer composed of the phosphorescent polymer according to the present invention is produced by a simple process and can achieve excellent durability and long service life because no low-molecular material is present in the luminescent layer thereof and can attain high luminous luminance because energy derived from the triplet luminescent material can be utilized at high efficiency in light emission thereof.

According to the process of the present invention for producing a phosphorescent polymer, the above-described phosphorescent polymers can be provided.

The metal complex-containing compounds according to the present invention are novel metal complex-containing compounds having a structure that a metal complex-containing group having a phenylpyridine structure is bonded to an aromatic compound having 2 reactive functional groups, and can be suitably used as monomers used in syntheses of polymers as organic materials excellent in luminescent properties and durability for forming, for example, a luminescent layer in an organic electroluminescence device.

According to the processes of the present invention for producing a metal complex-containing compound, the above-described metal complex-containing compounds can be provided.

### BRIEF DESCRIPTION OF THE DRAWINGS

The above and other objects, features and advantages of the present invention will become apparent from the following description and the appended claims, taken in conjunction with the accompanying drawing, in which:

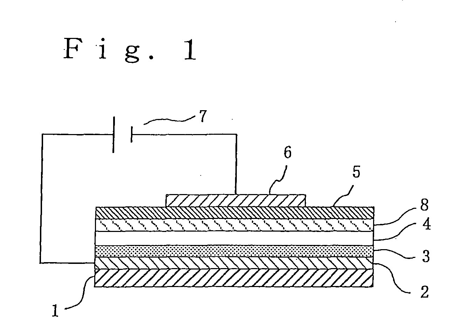

Fig. 1 is a cross-sectional view illustrating the construction of an exemplary organic electroluminescence device according to the present invention.

### DETAILED DESCRIPTION OF THE PREFERRED EMBODIMENTS

The present invention will hereinafter be described in details.

### <Phosphorescent polymer>

The phosphorescent polymer according to the present invention comprises a metal complex-containing group having a phenylpyridine structure bonded to a main chain containing an aromatic compound group.

Specific examples of the phosphorescent polymers of the present invention include those containing a metal complex-containing structural unit (hereinafter also referred to as "specific structural unit") represented by any one of the above general formula (A) to general formula (D).

These phosphorescent polymers may be either those composed of only the specific structural unit or those having other structural units. When the other structural units are contained, the specific structural unit may be present at terminal(s), in a main chain or both at terminal(s) and in the main chain of their molecules.

In each of the general formula (A) to general formula (D), M is a divalent to tetravalent metal atom. As the metal atom, may be mentioned iridium, platinum, palladium, rubidium, osmium and rhenium atoms. Among these, the iridium atom is preferred.

In each of the general formula (A) to general formula (D), L is an organic ligand. The organic ligand is formed by an organic compound having coordination property to a metal atom represented by M in the general formula (A) to general formula (D). The number w of the organic ligands is an integer of 1 to 3 and is selected in view of the valence of the metal atom used, a stable coordination number of a neutral complex by the metal atom, etc.

As the organic ligand, may be mentioned that capable of forming an ortho-metallation complex. For example, that formed by a nitrogen-containing heterocyclic derivative is used. Specific examples thereof include those formed by pyridine derivatives, pyrimidine derivatives, pyrazine derivatives, pyridazine derivatives, quinoline derivatives, phenanthroline derivatives, pyrrole derivatives, imidazole derivatives, pyrazole derivatives, oxazole derivatives, oxadiazole derivatives, triazole derivatives, thiadiazole derivatives, benzimidazole derivatives, benzoxazole derivatives and benzothiazole derivatives.

The term "ortho-metallation complex" as used herein means a generic designation of a group of compounds described in, for example, "Yuki Kinzoku Kagaku-Kiso to Oyo (Organometallic Chemistry-Principles and Applications)", pp. 150 and 232 (1982), written by Akio Yamamoto and published by SHOKABO PUBLISHING Co., Ltd., and "Photochemistry and Photophysics of Coordination Compounds", pp. 71 to 77 and 135 to 146 (1987), written by H. Yersin and published by Springer-Verlag Co..

Examples of other organic ligands than those capable of forming ortho-metallation complexes include those formed by organic compounds which is monodentate organic ligands, such as halogens, carbonyl group and cyano group and those formed by organic compounds which is multidentate organic ligands, such as β-diketones such as acetylacetone, hexafluoroacetylacetone and 5,5-dimethyl-2,4-hexadione, diamines such as ethylenediamine and dipyridyl, 9-hydroxyquinoline, picolinic acid, and salicylic acid. These organic compounds forming the organic ligands may be used either singly or in any combination thereof.

In each of the general formula (A) to general formula (D), L representing the organic ligand is preferably bidentate phenylpyridine.

A is an aromatic compound group, and this aromatic compound group preferably has at least one skeleton of a carbazole skeleton and a fluorene skeleton.

In the general formula (A) and general formula (B), D is a single bond, an oxygen atom or a divalent organic group selected from phenylene group, alkylene groups and alkoxylene groups.

The alkylene groups preferably have 1 to 20 carbon atoms.

The alkoxylene groups preferably have 1 to 20 carbon atoms, particularly 1 to 12 carbon atoms.

In the general formula (A), D is preferably bonded to a 4- or 5-position of the benzene ring, and particularly preferably bonded to a 4-position of the benzene ring. In the general formula (B), D is preferably bonded to a 3- to 5-position of the pyridine ring, and particularly preferably bonded to a 5-position of the pyridine ring.

When the phosphorescent polymers according to the present invention are composed of the specific structural unit and other structural units, the other structural units are preferably those having at least one skeletal of a carbazole skeleton, a fluorene skeleton and a diphenyl ether skeleton.

Specific preferable examples of the phosphorescent polymers according to the present invention include copolymers represented by the following general formula (E) to general formula (G).

The copolymers represented by the following general formula (E) to general formula (G) each contain, as the specific structural unit, a structural unit that in the general formula (A), A is an aromatic compound group having a fluorene skeletal, D is an alkoxylene group represented by a formula -R²⁴-O-, d is 2, M is an iridium atom, and w is 2.

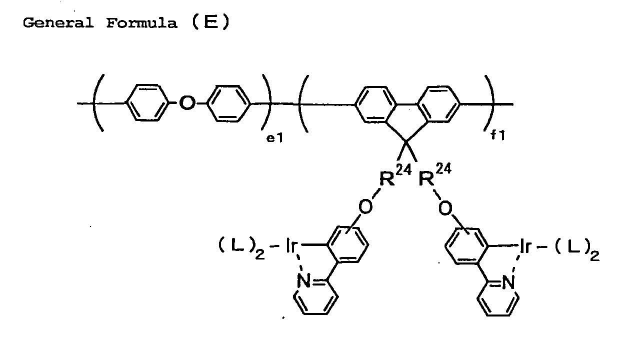

In the formula, R²⁴ is a divalent organic group, L is an organic ligand, and e1 and f1 are repetition numbers.

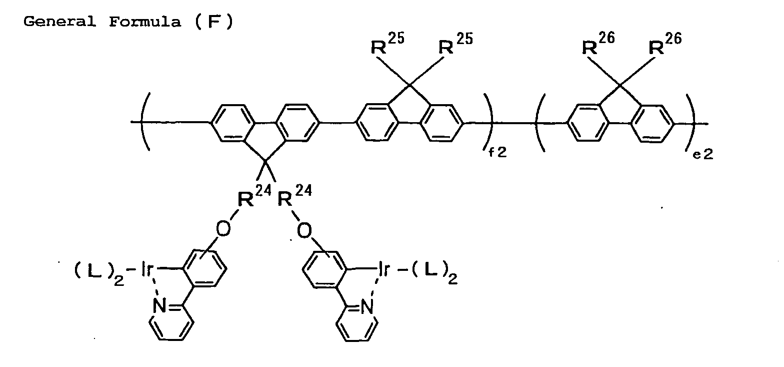

In the formula, R²⁴ is a divalent organic group, R²⁵ and R²⁶ are, independently of each other, a monovalent organic group, L is an organic ligand, and e2 and f2 are repetition numbers.

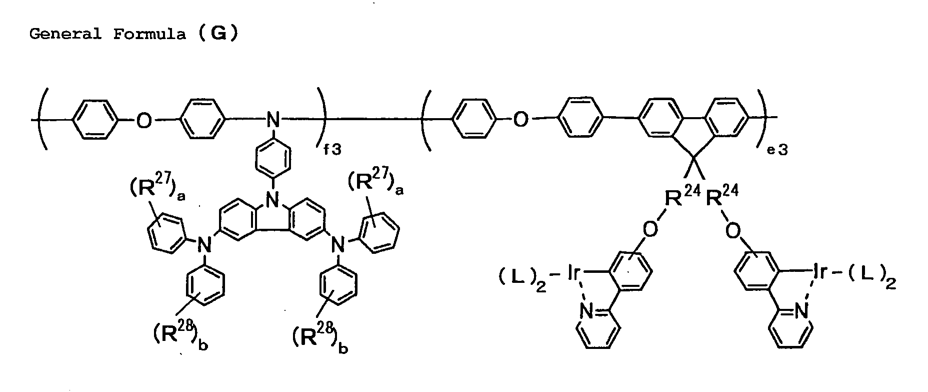

In the formula, R²⁴ is a divalent organic group, R²⁷ and R²⁸ are, independently of each other, a monovalent organic group, L is an organic ligand, a and b are individually an integer of 0 to 5, and e3 and f3 are repetition numbers.

In each of the general formula (E) to general formula (G), R²⁴ is a divalent organic group and is preferably an alkylene group having 1 to 20 carbon atoms. The oxygen atom bonded to R²⁴ is preferably bonded to a 4-position of the benzene ring bonded to the iridium atom.

In the general formula (F), R²⁵ is a monovalent organic group and is preferably an alkyl group having 1 to 20 carbon atoms, and R²⁶ is a monovalent organic group and is preferably an alkyl group having 1 to 20 carbon atoms.

In the general formula (G), R²⁷ and R²⁸ are individually a monovalent organic group and are preferably alkyl groups having 1 to 8 carbon atoms, a is preferably 0, and b is preferably 1. ) , R²⁷ and R²⁸ are each preferably bonded to 5-positions of the benzene rings.

In the general formula (G), the fact that both a and b are 0 means that, respectively, no substituent group is present, and hydrogen atoms are bonded.

A proportion of the specific structural unit contained in the phosphorescent polymers of the present invention is preferably 0.1 to 10 mol% based on the whole structural unit.

The phosphorescent polymers of the present invention preferably have a weight average molecular weight of 2,000 to 1,000,000 in terms of standard polystyrene equivalent as measured by gel permeation chromatography (GPC).

The phosphorescent polymers of the present invention are not limited to those composed of the specific structural unit so far as the metal complex-containing group having the phenylpyridine structure is bonded to the main chains having the aromatic compound group, and may be those composed of other structural units than the specific structural unit. Examples of such other structural units include structural units having a substituent group at the respective phenylpyridine structure moieties in the general formula (A) to general formula (G) and structural units that D in each of the general formula (A) to general formula (G) is a monocyclic to tricyclic divalent aromatic compound group (for example, naphthylene, anthrylene or xylylene group) which may be substituted.

The phosphorescent polymers of the present invention are obtained by reacting a metal complex-containing compound (hereinafter also referred to as "specific metal complex-containing compound") having 2 reactive functional groups and a skeletal structure containing a metal complex moiety with an aromatic compound (hereinafter also referred to as "specific aromatic compound") having 2 reactive functional groups in the presence of a catalyst and can be produced in accordance with, for example, the method (hereinafter also referred to as "Suzuki's method") disclosed in Organometallics, 3, 1261 (1984) or the method disclosed in Progress in Polymer Science, Vol. 17, 1153 (1992).

Examples of the reactive functional groups include halogenic functional groups, boron derivative functional groups and groups derived from hydroxyl, carboxyl and amino groups.

In the present specification, as "halogenic functional groups", can be mentioned a -Cl group, a -Br group, an -I group, groups derived from triflate, groups derived from tosylate and groups derived from mesylate. Among these, the -Br group and -I group are preferred.

As "boron derivative functional groups" can be mentioned a boronic group represented by a formula -B(OH)₂, boronate groups and borane groups.

As the boronate groups related to the boron derivative functional groups, are preferred groups represented by a formula -B (OR²⁹) (OR³⁰) and groups represented by the formula -B (OR³¹O). R²⁹ in the boronate groups is an alkyl group which has 1 to 6 carbon atoms and may be substituted. R³⁰ is a hydrogen atom or an alkyl group which has 1 to 6 carbon atoms and may be substituted. R³¹ is such a divalent hydrocarbon group that (OR³¹O) in the formula becomes a 5-membered or 6-membered ester ring. Specifically, it is preferably an alkylene group having 2 or 3 carbon atoms, an o-phenylene group or a m-phenylene group. These alkylene and phenylene groups may be substituted.

Examples of preferable groups as the boronate groups of such structures include groups derived from products by esterification of an alcohol having 1 to 6 carbon atoms, an ethanediol, a butanediol such as pinacol, propanediol, or an ortho-aromatic diol such as 1,2-dihydroxybenzene with boronic acid.

As the borane groups related to the boron derivative functional groups, are preferred groups represented by a formula -BR³²R³³. R³² and R³³ in the borane groups are, independently of each other, an alkyl group which has 1 to 6, and may be substituted, and these groups may or may not form a ring together.

As the specific metal complex-containing compound, is used a compound having a structure that a metal complex-containing group having a phenylpyridine structure is bonded to an aromatic compound having 2 reactive functional groups.

Specific examples thereof include metal complex-containing compounds composed of a carbazole compound (hereinafter also referred to as "specific carbazole compound") represented by the above general formula (1), metal complex-containing compounds composed of a spirofluorene compound (hereinafter also referred to as "specific spirofluorene compound") represented by the above general formula (2) or general formula (3) and metal complex-containing compounds composed of a fluorene compound (hereinafter also referred to as "specific fluorene compound") represented by the above general formula (4).

### (Specific carbazole compound)

The specific carbazole compound is a compound represented by the general formula (1) and having 2 reactive functional groups and a skeletal structure derived from carbazole having a specific metal complex moiety.

In the general formula (1) , X¹ and X² are, respectively, a reactive functional group and may be the same or different from each other. However, these groups are preferably the same. Specific examples of the reactive functional groups include a -Cl group, a -Br group, an -I group, groups derived from triflate, groups derived from tosylate, groups derived from mesylate, groups derived from hydroxyl, carboxyl and amino groups, and groups derived from boronic acid. Among these, the -Br group and -I group are preferred.

X¹ and X² are preferably bonded to carbon atoms of position numbers 3 and 6, respectively, in the carbazole skeleton.

R¹ is a divalent organic group. Specific examples of such a divalent organic group include alkoxylene groups having 1 to 20 carbon atoms, alkylene groups having 1 to 8 carbon atoms and monocyclic to tricyclic divalent aromatic compound groups (for example, phenylene, naphthylene, anthrylene and xylylene groups) which may be substituted. Alkoxylene groups having 1 to 8 carbon atoms are preferred, with alkoxylene groups having 3 to 6 carbon atoms being particularly preferred.

R² and R³ are, independently of each other, a monovalent organic group and may be the same or different from each other. However, these groups are preferably the same. Examples of the monovalent organic groups related to R² and R³ include, methyl, ethyl, propyl, isopropyl and phenyl groups.

m1 and n1 are, independently of each other, an integer of 0 to 3, and both m1 and n1 are particularly preferably 0.

In the general formula (1), the fact that both m1 and n1 are 0 means that, respectively, substituent group is not present, and hydrogen atoms are bonded.

R⁴ is a metal complex moiety composed of a group having a structure represented by the above general formula (1-1) or general formula (1-2).

In each of the general formula (1-1) and general formula (1-2), R⁶ and R⁷ are, independently of each other, a fluorine atom, alkyl group or aryl group (or a group derived from a cyclic structure when the cyclic structure is formed) and may be the same or different from each other, with the proviso that these groups may be substituted or form a cyclic structure. However, it is preferable that R⁶ and R⁷ are neither substituted nor cyclized and are the same as each other.

Each of R⁶ and R⁷ may also be bonded to carbon atoms forming the benzene ring or pyridine ring to form a polycyclic structure.

As specific examples of the alkyl groups related to R⁶ and R⁷, may be mentioned methyl, ethyl, isopropyl, t-butyl, n-butyl, isobutyl, hexyl and octyl groups.

Specific examples of the aryl groups include phenyl, tolyl, xylyl, biphenyl and naphthyl groups.

In the general formula (1-1), s1 is an integer of 0 to 4, and t1 is an integer of 0 to 3. In particular, both s1 and t1 are preferably 0.

In the general formula (1-1), the fact that both s1 and t1 are 0 means that, respectively, substituent group is not present, and hydrogen atoms are bonded.

In the general formula (1-2), v1 is an integer of 0 to 4, and u1 is an integer of 0 to 3. In particular, both u1 and v1 are preferably 0.

In the general formula (1-2), the fact that both u1 and v1 are 0 means that, respectively, substituent group is not present, and hydrogen atoms are bonded.

In each of the general formula (1-1) and general formula (1-2), M is a divalent to tetravalent metal atom. Examples of the metal atom include iridium, platinum, palladium, rubidium, osmium and rhenium atoms. Among these, the iridium atom is preferred.

L is an organic ligand. This organic ligand is formed by an organic compound having coordination property to the metal atom represented by M. The number w of the organic ligands is an integer of 1 to 3 and is selected in view of the valence of the metal atom used, a stable coordination number of a neutral complex by the metal atom, etc.

As the organic ligand, may be mentioned that capable of forming an ortho-metallation complex. For example, a nitrogen-containing heterocyclic derivative is used. Specific examples thereof include pyridine derivatives, pyrimidine derivatives, pyrazine derivatives, pyridazine derivatives, quinoline derivatives, phenanthroline derivatives, pyrrole derivatives, imidazole derivatives, pyrazole derivatives, oxazole derivatives, oxadiazole derivatives, triazole derivatives, thiadiazole derivatives, benzimidazole derivatives, benzoxazole derivatives and benzothiazole derivatives.

Examples of other organic ligands than those capable of forming ortho-metallation complexes include those formed by organic compounds which is monodentate organic ligands, such as halogens, carbonyl group and cyano group and those formed by organic compounds which is multidentate organic ligands, such as β-diketones such as acetylacetone, hexafluoroacetylacetone and 5,5-dimethyl-2,4-hexadione, diamines such as ethylenediamine and dipyridyl, 9-hydroxyquinoline, picolinic acid, and salicylic acid. These organic compounds forming the organic ligands may be used either singly or in any combination thereof.

Specific examples of the specific carbazole compound include carbazole compounds represented by the following general formula (1A).

The carbazole compounds represented by the general formula (1A) are carbazole compounds that in the general formula (1), X¹ and X² are the same reactive functional groups bonded to carbon atoms of position numbers 3 and 6, respectively, in the carbazole skeleton, R¹ is an alkoxylene group represented by a formula R³⁴-O, R⁴ is a group having a structure that M in the general formula (1-2) is an iridium atom, w is 2, and u1 and v1 are 0.

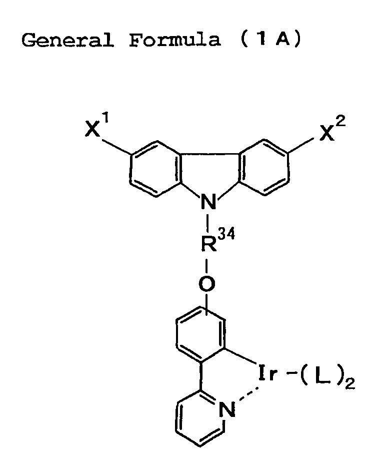

In the formula, X¹ and X² are the reactive functional groups, R³⁴ is a divalent organic group, and L is an organic ligand.

In the general formula (1A), R³⁴ is a divalent organic group and is preferably an alkylene group having 1 to 20 carbon atoms. The oxygen atom is preferably bonded to a 4-or 3-position, particularly a 4-position of the benzene ring.

Specific preferable examples of the carbazole compounds represented by the general formula (1A) include a carbazole compound represented by the following structural formula (1).

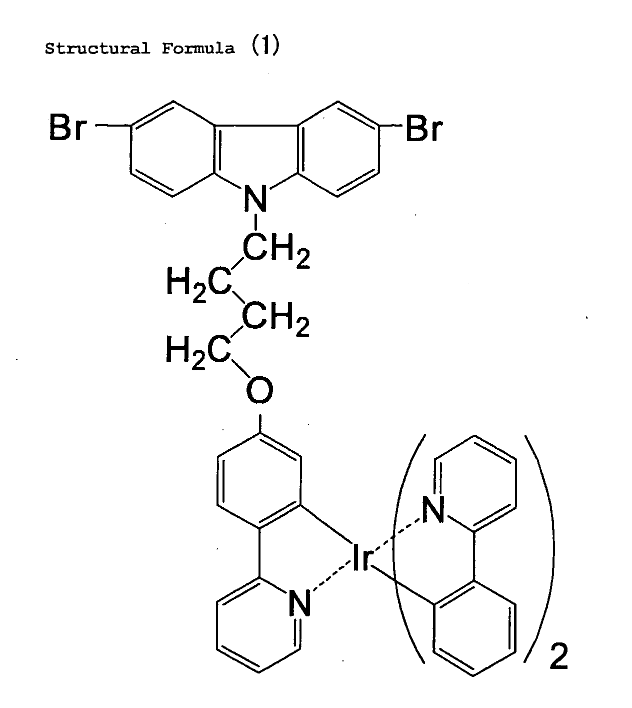

The carbazole compound represented by the structural formula (1) is a carbazole compound that in the general formula (1A) , X¹ and X² are bromine atoms, R³⁴ is a butylene group, and L is bidentate phenylpyridine.

When this carbazole compound is used as the specific metal complex-containing compound, the phosphorescent polymer according to the present invention, which has the specific structural unit represented by the general formula (A), can be obtained.

Such a specific carbazole compound as described above can be produced by reacting a compound (hereinafter also referred to as "raw carbazole compound (A)") represented by the above general formula (1-3) with a compound (hereinafter also referred to as "raw pyridine compound (A)") represented by the above general formula (1-4) or general formula (1-5) (this reaction step is hereinafter referred to as "first reaction step (A)") to obtain an intermediate reaction product (hereinafter also referred to as "intermediate reaction product (A)") represented by the following general formula (5-1) or general formula (5-2), and then reacting the resultant intermediate reaction product (A) with a compound (hereinafter also referred to as "raw metal complex-containing compound") represented by the above general formula (1-6) (this reaction step is hereinafter referred to as "second reaction step (A)").

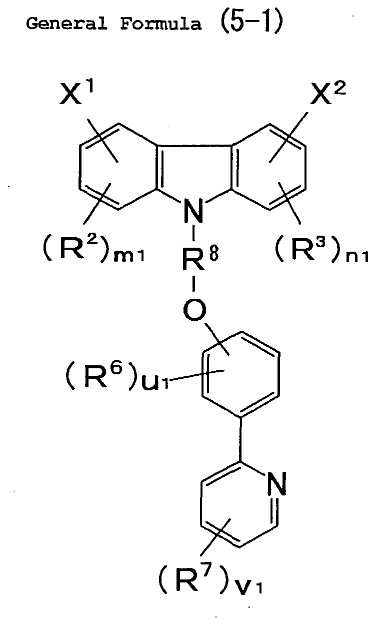

In the formula, X¹ and X² are, independently of each other, a reactive functional group and may be the same or different from each other, R² and R³ are, independently of each other, a monovalent organic group and may be the same or different from each other, R⁶ and R⁷ are, independently of each other, a fluorine atom, alkyl group or aryl group and may be the same or different from each other, with the proviso that these groups may be substituted or may form a cyclic structure, R⁸ is a divalent organic group, m1 is an integer of 0 to 3, n1 is an integer of 0 to 3, u1 is an integer of 0 to 3, and v1 is an integer of 0 to 4.

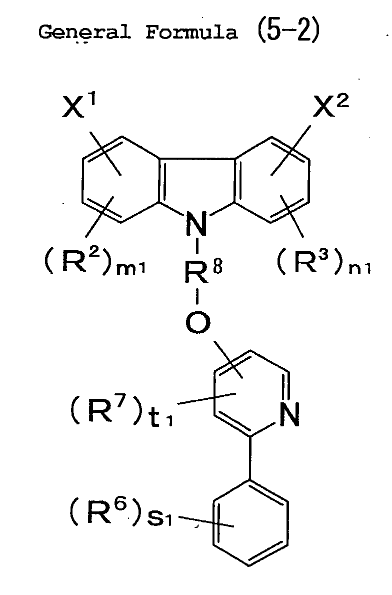

In the formula, X¹ and X² are, independently of each other, a reactive functional group and may be the same or different from each other, R² and R³ are, independently of each other, a monovalent organic group and may be the same or different from each other, R⁶ and R⁷ are, independently of each other, a fluorine atom, alkyl group or aryl group and may be the same or different from each other, with the proviso that these groups may be substituted or may form a cyclic structure, R⁸ is a divalent organic group, m1 is an integer of 0 to 3, n1 is an integer of 0 to 3, s1 is an integer of 0 to 4, and t1 is an integer of 0 to 3.

### [First reaction step (A)]

In the general formula (1-3) representing the raw carbazole compound (A) used in the first reaction step (A), R⁸ is a divalent organic group. Specific examples thereof include alkylene groups having 1 to 20 carbon atoms and monocyclic to tricyclic divalent aromatic compound groups (for example, phenylene, naphthylene, anthrylene and xylylene groups) which may be substituted. Alkylene groups having 1 to 8 carbon atoms, preferably 3 to 6 carbon atoms are preferred.

X¹⁷ is a halogen atom, for example, a bromine or iodine atom, with the bromine atom being preferred.

Specific preferable examples of the raw carbazole compound (A) include a compound represented by the following structural formula (2).

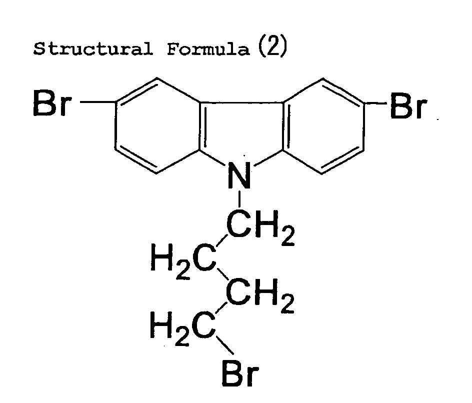

Specific examples of the raw pyridine compound (A) used in the first reaction step (A) include those that a hydroxyl group is bonded to a 3-, 4- or 5-position of the benzene ring or a 3- or 4-position of the pyridine ring when the position number of the nitrogen atom in the pyridine ring is regarded as 1. A compound represented by the following structural formula (3) that a hydroxyl group is bonded to a 4-position of the benzene ring is preferred.

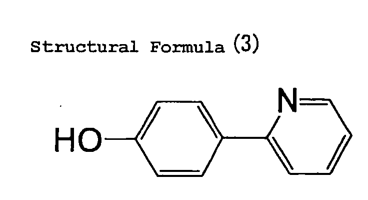

An intermediate reaction product (A) synthesized by using the raw carbazole compound represented by the structural formula (2) and the raw pyridine compound represented by the structural formula (3) in the first reaction step (A) is a compound represented by the following structural formula (4).

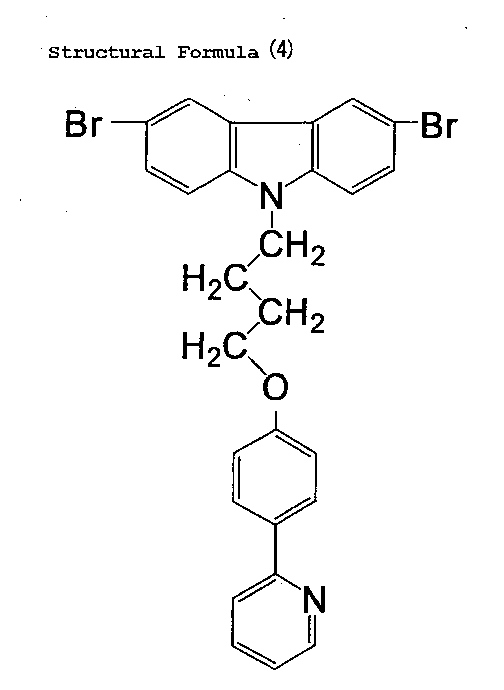

In the first reaction step (A), a proper solvent is used. Specific examples of such a solvent include dimethyl sulfoxide (DMSO), dimethylformamide and dimethylacetamide. These solvents may be used either singly or in any combination thereof.

The first reaction step (A) is preferably conducted in the presence of a basic compound. Specific examples of a usable basic compound include alkali metal hydroxides, alkaline earth metal hydroxides, alkali metal carbonates, alkaline earth metal carbonates, alkali metal acetates, alkaline earth metal acetates, alkali metal hydrogencarbonates, alkaline earth metal hydrogencarbonates, alkali metal alkoxides, alkaline earth metal alkoxides, primary amines, secondary amines and tertiary amines. Among these, potassium carbonate is preferably used.

Such a basic compound is used in a range of, for example, 1 to 10 mol, preferably 3 to 7 mol.

With respect to reaction conditions for the first reaction step (A), for example, the reaction temperature is 20 to 100°C, preferably 30 to 60°C.

The reaction time is 5 to 30 hours, preferably 10 to 20 hours.

### [Second reaction step (A)]

In the general formula (1-6) representing the raw metal complex-containing compound used in the second reaction step (A), R⁹ is a specific bidentate reactive chelate ligand having 2 coordinating atoms and bonded to M, which is a central metal, by the coordinating atoms. Specific preferable examples of such a specific reactive chelate ligand include an acetylacetonatoligand.

Specific preferable examples of the raw metal complex-containing compound include a compound represented by the following structural formula (5).

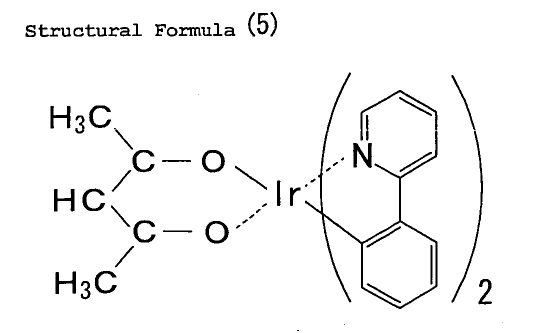

In the second reaction step (A), a proper solvent is used. Specific examples of such a solvent include glycerol, methoxyethanol and ethoxyethanol. These solvents may be used either singly or in any combination thereof. Among these, glycerol is particularly preferred.

With respect to reaction conditions for the second reaction step (A), for example, the reaction temperature is 150 to 300°C, preferably 200 to 250°C.

The reaction time is 10 to 50 hours, preferably 15 to 30 hours.

Although the production process of the specific carbazole compound has been described above, the specific carbazole compound is not limited to that produced by the above-described production process, and that produced by any other production process may also be used.

### (Specific spirofluorene compound)

The specific spirofluorene compound is a compound (hereinafter also referred to as "first spirofluorene compound") represented by the general formula (2) or a compound (hereinafter also referred to as "second spirofluorene compound") having a structure represented by the general formula (3). These compounds each have 2 reactive functional groups and a skeletal structure derived from spirofluorene having a specific metal complex moiety.

### «First spirofluorene compound »

In the general formula (2) representing the first spirofluorene compound, X³ and X⁴ are, independently of each other, a reactive functional group and may be the same or different from each other. However, these groups are preferably the same. Specific examples of the reactive functional groups include a -Cl group, a -Br group, an -I group, groups derived from triflate, groups derived from tosylate, groups derived from mesylate, groups derived from hydroxyl, carboxyl and amino groups, and groups derived from boronic acid. Among these, the -Br group and -I group are preferred.

X³ and X⁴ are preferably bonded to carbon atoms of position numbers 2 and 7, respectively, in the fluorene skeleton.

R¹⁰ and R¹¹ are, independently of each other, a monovalent organic group and may be the same or different from each other. However, these groups are preferably the same.

Examples of the monovalent organic groups related to R¹⁰ and R¹¹ include alkyl, alkoxy and aryl groups, with methyl, ethyl, propyl, isopropyl and phenyl groups being particularly preferred.

R¹² is a monovalent organic group, and specific examples thereof include alkyl, alkoxy and aryl groups. In order to enhance solubility in organic solvents, an alkyl group having 1 to 6 carbon atom or an alkoxy group having 1 to 12 carbon atom, particularly 1 to 6 carbon atoms is preferred, with a methoxy group being particularly preferred.

R¹³ and R¹⁴ are, independently of each other, a fluorine atom, alkyl group or aryl group (or a group derived from a cyclic structure when the cyclic structure is formed) and may be the same or different from each other, with the proviso that these groups may be substituted or may form a cyclic structure. However, it is preferable that R¹³ and R¹⁴ are neither substituted nor cyclized and are the same as each other.

Each of R¹³ and R¹⁴ may also be bonded to carbon atoms forming the benzene ring or pyridine ring to form a polycyclic structure.

Specific examples of the alkyl groups related to R¹³ and R¹⁴ include methyl, ethyl, isopropyl, t-butyl, n-butyl, isobutyl, hexyl and octyl groups.

Specific examples of the aryl groups related to R¹³ and R¹⁴ include phenyl, tolyl, xylyl, biphenyl and naphthyl groups.

m2 and n2 are, independently of each other, an integer of 0 to 3, and both m2 and n2 are particularly preferably 0.

In the general formula (2), the fact that both m2 and n2 are 0 means that, respectively, substituent group is not present, and hydrogen atoms are bonded.

r1 is an integer of 0 to 4 and is particularly preferably 2.

In the general formula (2), the fact that r1 is 0 means that substituent group is not present, and a hydrogen atom is bonded.

s2 is an integer of 0 to 2, t2 is an integer of 0 to 4, and both s2 and t2 are particularly preferably 0.

In the general formula (2), the fact that both s2 and t2 are 0 means that, respectively, substituent group is not present, and hydrogen atoms are bonded.

In the general formula (2), M is a divalent to tetravalent metal atom. Examples of the metal atom include iridium, platinum, palladium, rubidium, osmium and rhenium atoms. Among these, the iridium atom is preferred.

L is an organic ligand. This organic ligand is formed by an organic compound having coordination property to the metal atom represented by M. The number w of the organic ligands is an integer of 1 to 3 and is selected in view of the valence of the metal atom used, a stable coordination number of a neutral complex by the metal atom, etc.

As the organic ligand, may be mentioned that capable of forming an ortho-metallation complex. For example, a nitrogen-containing heterocyclic derivative is used. Specific examples thereof include pyridine derivatives, pyrimidine derivatives, pyrazine derivatives, pyridazine derivatives, quinoline derivatives, phenanthroline derivatives, pyrrole derivatives, imidazole derivatives, pyrazole derivatives, oxazole derivatives, oxadiazole derivatives, triazole derivatives, thiadiazole derivatives, benzimidazole derivatives, benzoxazole derivatives and benzothiazole derivatives.

Examples of other organic ligands than those capable of forming ortho-metallation complexes include those formed by organic compounds which is monodentate organic ligands, such as halogens, carbonyl group and cyano group and those formed by organic compounds which is multidentate organic ligands, such as β-diketones such as acetylacetone, hexafluoroacetylacetone and 5,5-dimethyl-2,4-hexadione, diamines such as ethylenediamine and dipyridyl, 9-hydroxyquinoline, picolinic acid, and salicylic acid. These organic compounds forming the organic ligands may be used either singly or in any combination thereof.

Specific preferable examples of the first spirofluorene compound include spirofluorene compounds represented by the following general formula (2A).

The spirofluorene compounds represented by the general formula (2A) are compounds that, in the general formula (2), X³ and X⁴ are the same reactive functional groups bonded to carbon atoms of position numbers 2 and 7, respectively, in the fluorene skeleton, R¹² is an alkoxy group represented by a formula R³⁵-O, M is an iridium atom, w is 2, m2, n2, s2 and t2 are 0, and r1 is r2.

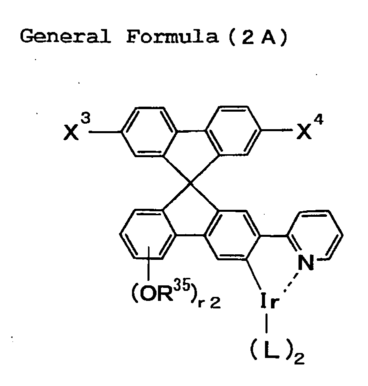

In the formula, X³ and X⁴ are reactive functional groups, R³⁵ is a monovalent organic group, L is an organic ligand, and r2 is an integer of 1 to 3.

In the general formula (2A), R³⁵ is a monovalent organic group and is preferably an alkyl group having 1 to 12 carbon atoms, and r2 is preferably 2. When r2 is 2, the OR³⁵ groups are preferably bonded to 4- and 5-positions of the benzene ring, respectively.

Specific preferable examples of the first spirofluorene compounds represented by the general formula (2A) include a spirofluorene compound represented by the following structural formula (6).

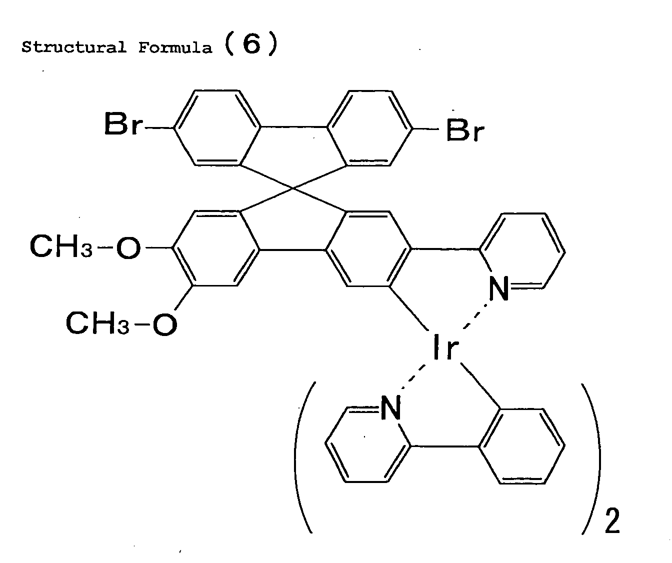

The first spirofluorene compound represented by the structural formula (6) is a spirofluorene compound that, in the general formula (2A) , X³ and X⁴ are bromine atoms, L is bidentate phenylpyridine, r2 is 2, the OR³⁵ groups are bonded to 4- and 5-positions of the benzene ring, respectively, and R³⁵ is a methyl group.

When this spirofluorene compound is used as the specific metal complex-containing compound, the phosphorescent polymer of the present invention, which has the specific structural unit represented by the general formula (C), can be obtained.

Such a first spirofluorene compound as described above can be produced in the following manner.

A compound (hereinafter also referred to as "raw pyridine compound (B-1)") represented by the above general formula (2-1) is first reacted with a compound (hereinafter also referred to as "raw fluorenone compound (B)") represented by the above general formula (2-2) (this reaction step is hereinafter referred to as "first reaction step (B-1)"), to obtain an intermediate reaction product (hereinafter also referred to as "intermediate reaction product (B-1)") having a spiro-ring structure in its structure as represented by the following general formula (6-1).

The intermediate reaction product (B-1) obtained in the first reaction step (B-1) is then reacted with a raw metal complex-containing compound represented by the general formula (1-6) (this reaction is hereinafter referred to as "second reaction step (B-1)"), thereby the intended first spirofluorene compound represented by the general formula (2) is synthesized.

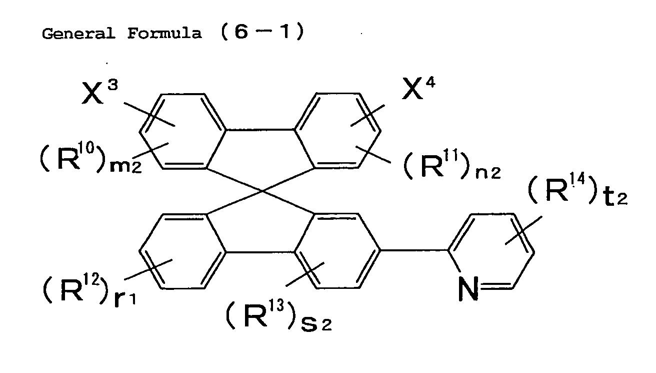

In the formula, X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹³ and R¹⁴ are, independently of each other, a fluorine atom, alkyl group or aryl group and may be the same or different from each other, with the proviso that these groups may be substituted or may form a cyclic structure, m2 is an integer of 0 to 3, n2 is an integer of 0 to 3, r1 is an integer of 0 to 4, s2 is an integer of 0 to 2, and t2 is an integer of 0 to 4.

### [First reaction step (B-1)]

In the general formula (2-1) representing the raw pyridine compound (B-1) used in the first reaction step (B-1), X⁵ is a halogen atom, for example, a fluorine, bromine or iodine atom, with the bromine atom being preferred.

Specific examples of the raw pyridine compound (B-1) include those represented by the following general formula (2-1A), in which R¹² is an alkyl group having 1 to 6 carbon atoms or an alkoxy group having 1 to 12 carbon atoms, preferably 1 to 6 carbon atoms. A compound represented by the following structural formula (7) is particularly preferred.

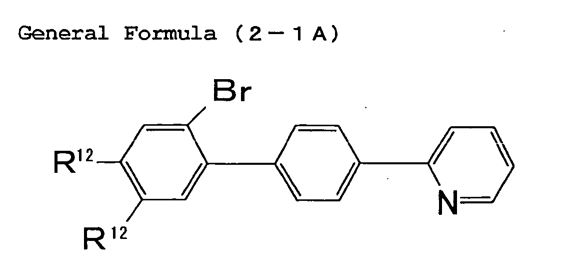

In the formula, R¹² is a monovalent organic group.

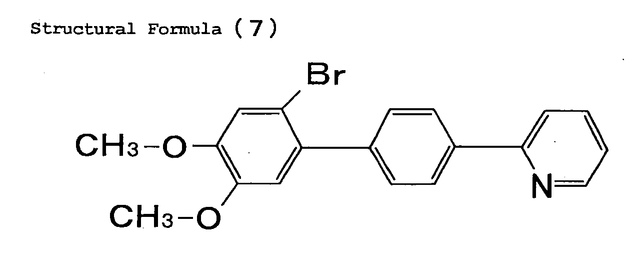

Specific preferable examples of the raw fluorenone compound (B) used in the first reaction step (B-1) include a compound represented by the following structural formula (8).

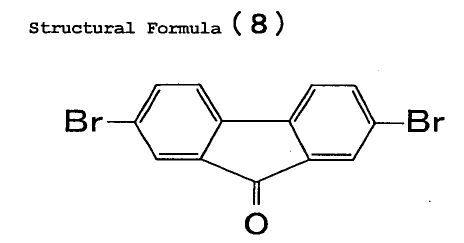

An intermediate reaction product (B-1) synthesized by using the raw pyridine compound (B-1) represented by the structural formula (7) and the raw fluorenone compound (B) represented by the structural formula (8) in the first reaction step (B-1) is a compound represented by the following structural formula (9).

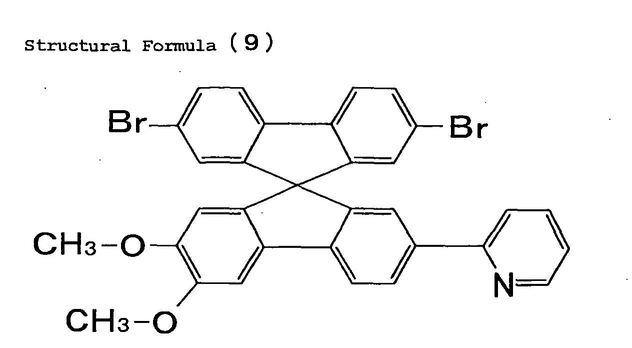

The first reaction step (B-1) comprises 2 treatment steps of a preliminary reaction treatment and a post reaction treatment.

More specifically, the preliminary reaction treatment is a treatment making good use of the Grignard reaction. In the Grignard reaction, a proper polar solvent is used. For example, tetrahydrofuran and ether are preferably used.

The post reaction treatment is a treatment conducted under acidic conditions and in the reaction treatment, for example, an acidic solvent composed of a combination of acetic acid and hydrochloric acid is preferably used as a solvent.

### [Second reaction step (B-1)]

In the general formula (1-6) representing the raw metal complex-containing compound used in the second reaction step (B-1), R⁹ is a specific bidentate reactive chelate ligand having 2 coordinating atoms and bonded to M, which is a central metal, by the coordinating atoms. Specific preferable examples of such a specific reactive chelate ligand include an acetylacetonatoligand.

Specific preferable examples of the raw metal complex-containing compound include a compound represented by the above structural formula (5).

In the second reaction step (B-1), a proper solvent is used. Specific examples of such a solvent include glycerol, methoxyethanol and ethoxyethanol. These solvents may be used either singly or in any combination thereof. Among these, glycerol is particularly preferred.

With respect to reaction conditions for the second reaction step (B-1), for example, the reaction temperature is 150 to 300°C, preferably 200 to 250°C.

The reaction time is 10 to 50 hours, preferably 15 to 30 hours.

Although the production process of the first spirofluorene compound has been described above, the first spirofluorene compound is not limited to that produced by the above-described production process, and that produced by any other production process may also be used.

### «Second spirofluorene compound »

In the general formula (3) representing the second spirofluorene compound, X³ and X⁴ are, independently of each other, a reactive functional group and may be the same or different from each other. However, these groups are preferably the same. Specific examples of the reactive functional groups include a -Cl group, a -Br group, an -I group, groups derived from triflate, groups derived from tosylate, groups derived from mesylate, groups derived from hydroxyl, carboxyl and amino groups, and groups derived from boronic acid. Among these, the -Br group and -I group are preferred.

X³ and X⁴ are preferably bonded to carbon atoms of position numbers 2 and 7, respectively, in the fluorene skeleton.

R¹⁰ and R¹¹ are, independently of each other, a monovalent organic group and may be the same or different from each other. However, these groups are preferably the same.

Examples of the monovalent organic groups related to R¹⁰ and R¹¹ include alkyl, alkoxy and aryl groups, with methyl, ethyl, propyl, isopropyl and phenyl groups being particularly preferred.

R¹² is a monovalent organic group, and examples thereof include alkyl, alkoxy and aryl groups. In order to enhance solubility in organic solvents, an alkyl group having 1 to 6 carbon atom or an alkoxy group having 1 to 12 carbon atom, particularly 1 to 6 carbon atoms is preferred, with a methoxy group being particularly preferred.

R¹⁴ is a fluorine atom, alkyl group or aryl group (or a group derived from a cyclic structure when the cyclic structure is formed) with the proviso that the group may be substituted or may form a cyclic structure. However, it is preferable that R¹⁴ is neither substituted nor cyclized.

R¹⁴ may also be bounded to a plurality of carbon atoms forming the benzene ring or pyridine ring to form a polycyclic structure.

Specific examples of the alkyl group related to R¹⁴ include methyl, ethyl, isopropyl, t-butyl, n-butyl, isobutyl, hexyl and octyl groups.

Specific examples of the aryl group related to R¹⁴ include phenyl, tolyl, xylyl, biphenyl and naphthyl groups.

R¹⁴ is preferably a methyl group.

m2 and n2 are, independently of each other, an integer of 0 to 3, and both m2 and n2 are particularly preferably 0.

In the general formula (3), the fact that both m2 and n2 are 0 means that, respectively, substituent group is not present, and hydrogen atoms are bonded.

p1 is an integer of 0 to 3 and is particularly preferably 2.

In the general formula (3), the fact that p1 is 0 means that substituent group is not present, and a hydrogen atom is bonded.

q1 is an integer of 0 to 3 and is particularly preferably 1.

In the general formula (3), the fact that q1 is 0 means that substituent group is not present, and a hydrogen atom is bonded.

In the general formula (3), M is a divalent to tetravalent metal atom. Examples of the metal atom include iridium, platinum, palladium, rubidium, osmium and rhenium atoms. Among these, the iridium atom is preferred.

L is an organic ligand. This organic ligand is formed by an organic compound having coordination property to the metal atom represented by M. The number w of the organic ligands is an integer of 1 to 3 and is selected in view of the valence of the metal atom used, a stable coordination number of a neutral complex by the metal atom, etc.

As the organic ligand, may be mentioned that capable of forming an ortho-metallation complex. For example, a nitrogen-containing heterocyclic derivative is used. Specific examples thereof include pyridine derivatives, pyrimidine derivatives, pyrazine derivatives, pyridazine derivatives, quinoline derivatives, phenanthroline derivatives, pyrrole derivatives, imidazole derivatives, pyrazole derivatives, oxazole derivatives, oxadiazole derivatives, triazole derivatives, thiadiazole derivatives, benzimidazole derivatives, benzoxazole derivatives and benzothiazole derivatives.

Examples of other organic ligands than those capable of forming ortho-metallation complexes include those formed by organic compounds which is monodentate organic ligands, such as halogens, carbonyl group and cyano group and those formed by organic compounds which is multidentate organic ligands, such as β-diketones such as acetylacetone, hexafluoroacetylacetone and 5,5-dimethyl-2,4-hexadione, diamines such as ethylenediamine and dipyridyl, 9-hydroxyquinoline, picolinic acid, and salicylic acid. These organic compounds forming the organic ligands may be used either singly or in any combination thereof.

Specific preferable examples of the second spirofluorene compound include spirofluorene compounds represented by the following general formula (3A).

The spirofluorene compounds represented by the general formula (3A) are compounds that, in the general formula (3), X³ and X⁴ are the same reactive functional groups bonded to carbon atoms of position numbers 2 and 7, respectively, in the fluorene skeleton, R¹² is an alkoxy group represented by a formula R³⁶-O, M is an iridium atom, w is 2, m2, n2 and q1 are 0, and p1 is r3.

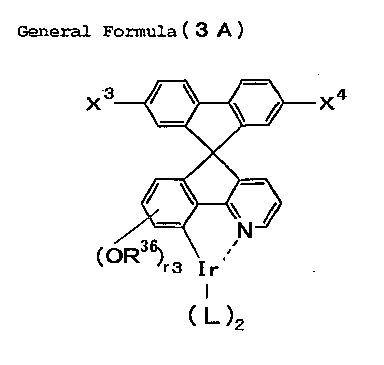

In the formula, X³ and X⁴ are reactive functional groups, R³⁶ is a monovalent organic group, L is an organic ligand, and r3 is an integer of 1 to 3.

In the general formula (3A), R³⁶ is a monovalent organic group and is preferably an alkyl group having 1 to 12 carbon atoms, and r3 is preferably 2. When r3 is 2, the OR³⁶ groups are preferably bonded to 4- and 5-positions of the benzene ring, respectively.

Specific preferable examples of the second spirofluorene compounds represented by the general formula (3A) include a spirofluorene compound represented by the following structural formula (10).

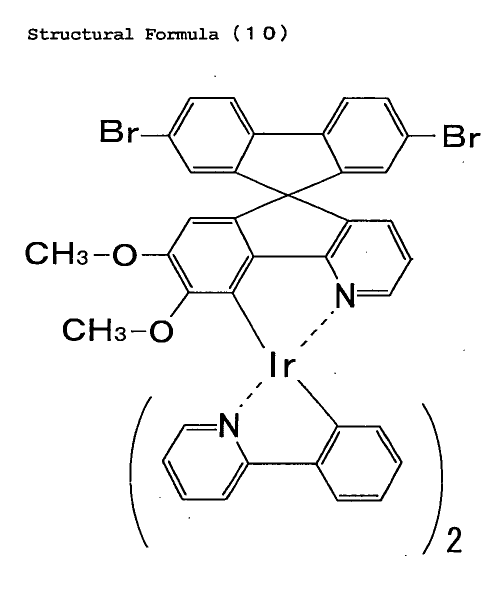

The second spirofluorene compound represented by the structural formula (10) is a spirofluorene compound that, in the general formula (3A), X³ and X⁴ are bromine atoms, L is bidentate phenylpyridine, r3 is 2, the OR³⁶ groups are bonded to 4- and 5-positions of the benzene ring, respectively, and R³⁶ is a methyl group.

When this spirofluorene compound is used as the specific metal complex-containing compound, the phosphorescent polymer of the present invention, which has the specific structural unit represented by the general formula (D), can be obtained.

Such a second spirofluorene compound as described above can be produced in the following manner.

A compound (hereinafter also referred to as "raw pyridine compound (B-2)") represented by the above general formula (3-1) is first reacted with a raw fluorenone compound (B) represented by the general formula (2-2) (this reaction step is hereinafter referred to as "first reaction step (B-2)"), to obtain an intermediate reaction product (hereinafter also referred to as "intermediate reaction product (B-2)") having a spiro-ring skeleton in its structure as represented by the following general formula (7-1).

The intermediate reaction product (B-2) obtained in the first reaction step (B-2) is then reacted with a raw metal complex-containing compound represented by the general formula (1-6) (this reaction step is hereinafter referred to as "second reaction step (B-2)"), thereby the intended second spirofluorene compound represented by the general formula (3) is synthesized.

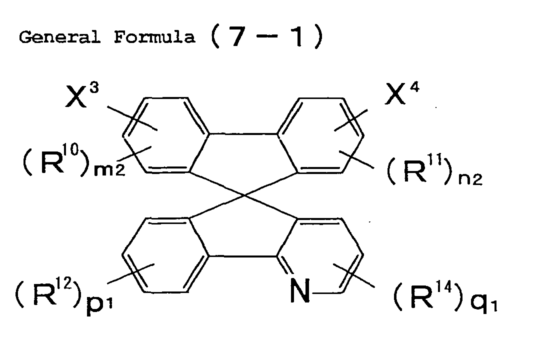

In the formula, X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹⁴ is a fluorine atom, alkyl group or aryl group, with the proviso that the group may be substituted or may form a cyclic structure, m2 is an integer of 0 to 3, n2 is an integer of 0 to 3, p1 is an integer of 0 to 3, and q1 is an integer of 0 to 3.

### [First reaction step (B-2)]

In the general formula (3-1) representing the raw pyridine compound (B-2) used in the first reaction step (B-2), X⁵ is a halogen atom, for example, a fluorine, bromine or iodine atom, with the bromine atom being preferred.

Specific examples of such a raw pyridine compound (B-2) include compounds represented by the following general formula (3-1A), in which R¹² is an alkyl group having 1 to 6 carbon atoms or an alkoxy group having 1 to 12 carbon atoms, preferably 1 to 6 carbon atoms. A compound represented by the following structural formula (11) is particularly preferred.

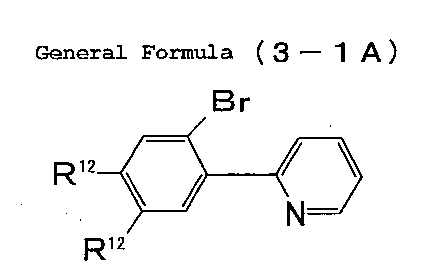

In the formula, R¹² is a monovalent organic group.

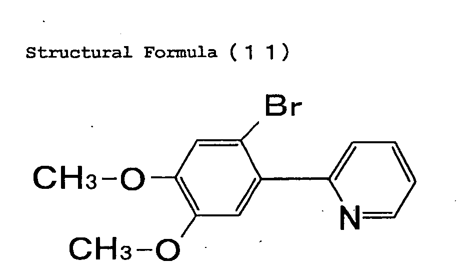

In the first reaction step (B-2), the raw fluorenone compound (B) is used in the same manner as in the first reaction step (B-1) related to the production process of the first spirofluorene. Specific preferable examples of the raw fluorenone compound (B) include a compound represented by the structural formula (8).

An intermediate reaction product (B-2) synthesized by using the raw pyridine compound (B-2) represented by the structural formula (11) and the raw fluorenone compound (B) represented by the structural formula (8) in the first reaction step (B-2) is a compound represented by the following structural formula (12).

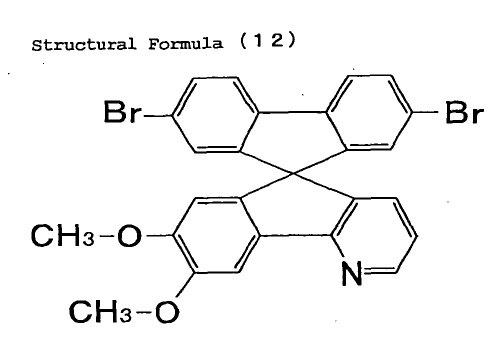

The first reaction step (B-2) is composed of 2 treatment steps of a preliminary reaction treatment and a post reaction treatment.

More specifically, the preliminary reaction treatment is a treatment making good use of the Grignard reaction. In the Grignard reaction, a proper polar solvent is used as the solvent. For example, tetrahydrofuran and ether are preferably used.

The post reaction treatment is a treatment conducted under acidic conditions and in the reaction treatment, for example, an acidic solvent composed of a combination of acetic acid and hydrochloric acid is preferably used.

### [Second reaction step (B-2)]

In the second reaction step (B-2), the raw metal complex-containing compound is used in the same manner as in the second reaction step (B-1) related to the production process of the first spirofluorene. Specific preferable examples of the raw metal complex-containing compound include a compound represented by the structural formula (5).

In the second reaction step (B-2), a proper solvent is used. Specific examples of such a solvent include glycerol, methoxyethanol and ethoxyethanol. These solvents may be used either singly or in any combination thereof. Among these, glycerol is particularly preferred.

With respect to reaction conditions for the second reaction step (B-2), for example, the reaction temperature is 150 to 300°C, preferably 200 to 250°C.

The reaction time is 10 to 50 hours, preferably 15 to 30 hours.

Although the production process of the second spirofluorene compound has been described above, the second spirofluorene compound is not limited to that produced by the above-described production process, and that produced by any other production process may also be used.

### (Specific fluorene compound)

The specific fluorene compound is a compound represented by the general formula (4) and has 2 halogenic functional groups as the reactive functional groups and a skeletal structure derived from fluorene having a specific metal complex moiety.

In the general formula (4), X⁶ and X⁷ are, independently of each other, a halogenic functional group and may be the same or different from each other. However, these groups are preferably the same. Specific examples of the halogenic functional groups include a -Cl group, a - Br group, an -I group, groups derived from triflate, groups derived from tosylate, and groups derived from mesylate. Among these, the -Br group and -I group are preferred.

X⁶ and X⁷ are preferably bonded to carbon atoms of position numbers 2 and 7, respectively, in the fluorene skeleton.

R¹⁵ and R¹⁶ are, independently of each other, a monovalent organic group and may be the same or different from each other. However, these groups are preferably the same.

Examples of the monovalent organic groups related to R¹⁵ and R¹⁶ include methyl, ethyl, propyl, isopropyl and phenyl groups. n3 and n4 are, independently of each other, an integer of 0 to 3, with both n3 and n4 being particularly preferably 0.

In the general formula (4), the fact that both n3 and n4 are 0 means that, respectively, substituent group is not present, and hydrogen atoms are bonded.

R¹⁷ and R¹⁸ are single bonds or divalent organic groups and may be the same or different from each other. However, these groups are preferably the same. Specific examples of the divalent organic groups include alkoxylene groups having 1 to 20 carbon atoms, alkylene groups having 1 to 8 carbon atoms and monocyclic to tricyclic divalent aromatic compound groups (for example, phenylene, naphthylene, anthrylene and xylylene groups) which may be substituted. In the general formula (4), R¹⁷ and R¹⁸ are preferably single bonds, alkoxylene groups having 1 to 12 carbon atoms, particularly 1 to 8 carbon atoms or phenylene groups.

At least one of R¹⁹ and R²⁰ is a metal complex moiety composed of a group having a structure represented by the above general formula (1-1) or general formula (1-2), and the other is a monovalent organic group or a metal complex moiety composed of a group having a structure represented by the above general formula (1-1) or general formula (1-2). These groups may be the same or different from each other.

In each of the general formula (1-1) and general formula (1-2), R⁶ and R⁷ are, independently of each other, a fluorine atom, alkyl group or aryl group (or a group derived from a cyclic structure when the cyclic structure is formed) and may be the same or different from each other, with the proviso that these groups may be substituted or may form a cyclic structure. However, it is preferable that R⁶ and R⁷ are neither substituted nor cyclized and are the same as each other.

Each of R⁶ and R⁷ may also be bonded to a plurality of carbon atoms forming the benzene ring or pyridine ring to form a polycyclic structure.

Specific examples of the alkyl groups related to R⁷ and R⁶ include methyl, ethyl, isopropyl, t-butyl, n-butyl, isobutyl, hexyl and octyl groups.

Specific examples of the aryl groups include phenyl, tolyl, xylyl, biphenyl and naphthyl groups.

In the general formula (1-1), s1 is an integer of 0 to 4, and t1 is an integer of 0 to 3. In particular, both s1 and t1 are preferably 0.

In the general formula (1-1), the fact that both s1 and t1 are 0 means that, respectively, substituent group is not present, and hydrogen atoms are bonded.

In the general formula (1-2), v1 is an integer of 0 to 4, and u1 is an integer of 0 to 3. In particular, both u1 and v1 are preferably 0.

In the general formula (1-2), the fact that both u1 and v1 are 0 means that, respectively, substituent group is not present, and hydrogen atoms are bonded.

In each of the general formula (1-1) and general formula (1-2), M is a divalent to tetravalent metal atom. Examples of the metal atom include iridium, platinum, palladium, rubidium, osmium and rhenium atoms. Among these, the iridium atom is preferred.

L is an organic ligand. This organic ligand is formed by an organic compound having coordination property to the metal atom represented by M. The number w of the organic ligands is an integer of 1 to 3 and is selected in view of the valence of the metal atom used, a stable coordination number of a neutral complex by the metal atom, etc.

As the organic ligand, may be mentioned that capable of forming an ortho-metallation complex. For example, a nitrogen-containing heterocyclic derivative is used. Specific examples thereof include pyridine derivatives, pyrimidine derivatives, pyrazine derivatives, pyridazine derivatives, quinoline derivatives, phenanthroline derivatives, pyrrole derivatives, imidazole derivatives, pyrazole derivatives, oxazole derivatives, oxadiazole derivatives, triazole derivatives, thiadiazole derivatives, benzimidazole derivatives, benzoxazole derivatives and benzothiazole derivatives.

Examples of other organic ligands than those capable of forming ortho-metallation complexes include those formed by organic compounds which is monodentate organic ligands, such as halogens, carbonyl group and cyano group and those formed by organic compounds which is multidentate organic ligands, such as β-diketones such as acetylacetone, hexafluoroacetylacetone and 5,5-dimethyl-2,4-hexadione, diamines such as ethylenediamine and dipyridyl, 9-hydroxyquinoline, picolinic acid, and salicylic acid. These organic compounds forming the organic ligands may be used either singly or in any combination thereof.

Specific examples of the specific fluorene compound include fluorene compounds represented by the following general formula (4A) to general formula (4E).

The fluorene compounds represented by the general formula (4A) are fluorene compounds that, in the general formula (4), X⁶ and X⁷ are the same reactive functional groups bonded to carbon atoms of position numbers 2 and 7, respectively, in the fluorene skeleton, R¹⁷ and R¹⁸ are single bonds, and R¹⁹ and R²⁰ are groups represented by the general formula (1-2), in which M is an iridium atom, w is 2, and u1 and v1 are 0.

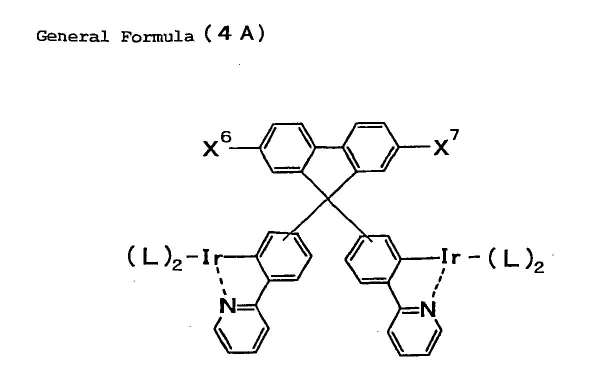

In the formula, X⁶ and X⁷ are reactive functional groups, and L is an organic ligand.

In the general formula (4A), a carbon atom, which is a spiro atom, is preferably bonded to a 4-position of the benzene ring.

Specific preferable examples of the fluorene compounds represented by the general formula (4A) include a fluorene compound represented by the following structural formula (13).

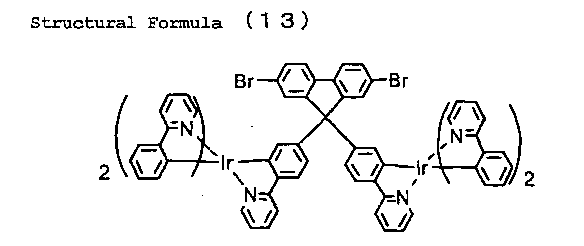

The fluorene compound represented by the structural formula (13) is a fluorene compound that, in the general formula (4A), X⁶ and X⁷ are bromine atoms, L is bidentate phenylpyridine, and the carbon atom, which is a spiro atom, is bonded to a 4-position of the benzene ring.

When this fluorene compound is used as the specific metal complex-containing compound, the phosphorescent polymer of the present invention, which has the specific structural unit represented by the general formula (A), can be obtained.

The fluorene compounds represented by the general formula (4B) are fluorene compounds that, in the general formula (4), X⁶ and X⁷ are the same reactive functional groups bonded to carbon atoms of position numbers 2 and 7, respectively, in the fluorene skeleton, R¹⁷ and R¹⁸ are phenylene groups, and R¹⁹ and R²⁰ are groups represented by the general formula (1-2), in which M is an iridium atom, w is 2, and u1 and v1 are 0.

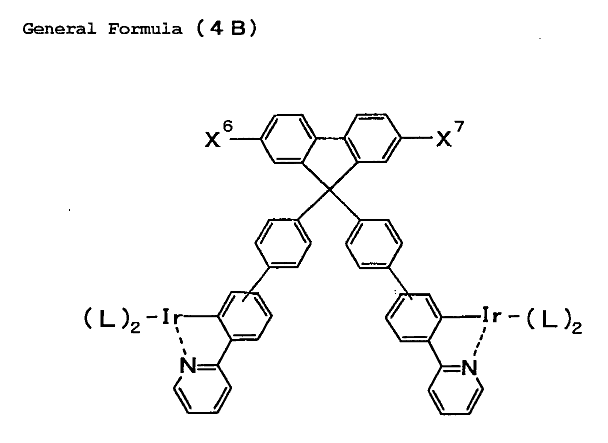

In the formula, X⁶ and X⁷ are reactive functional groups, and L is an organic ligand.

In the general formula (4B), each of the phenylene groups related to R¹⁷ and R¹⁸ in the general formula (4) is preferably bonded to a 4-position of the benzene ring.

Specific preferable examples of the fluorene compounds represented by the general formula (4B) include a fluorene compound represented by the following structural formula (14).

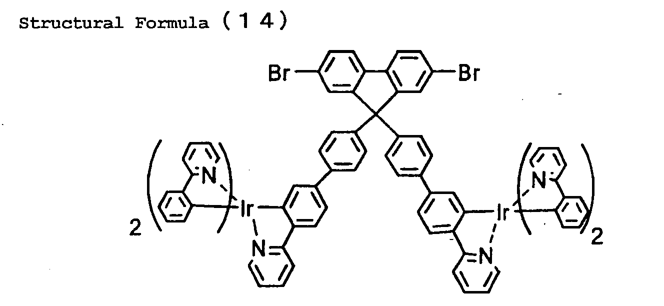

The fluorene compound represented by the structural formula (14) is a fluorene compound that, in the general formula (4B), X⁶ and X⁷ are bromine atoms, L is bidentate phenylpyridine, and each of the phenylene groups related to R¹⁷ and R¹⁸ in the general formula (4) is preferably bonded to a 4-position of the benzene ring.

When this fluorene compound is used as the specific metal complex-containing compound, the phosphorescent polymer of the present invention, which has the specific structural unit represented by the general formula (A), can be obtained.

The fluorene compounds represented by the general formula (4C) are fluorene compounds that, in the general formula (4), X⁶ and X⁷ are the same reactive functional groups bonded to carbon atoms of position numbers 2 and 7, respectively, in the fluorene skeleton, R¹⁷ and R¹⁸ are single bonds, R¹⁹ is a group represented by the general formula (1-2), in which M is an iridium atom, w is 2, and u1 and v1 are 0, and R²⁰ is a substituted phenyl group.

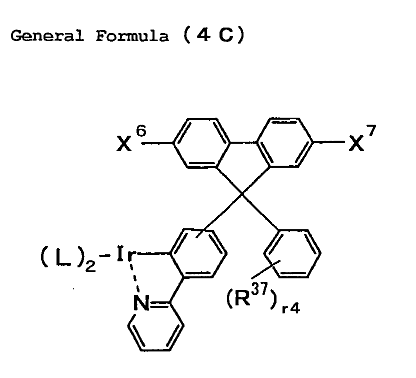

In the formula, X⁶ and X⁷ are reactive functional groups, R³⁷ is a monovalent organic group, L is an organic ligand, and r4 is an integer of 1 to 3.

In the general formula (4C), R³⁷ is a monovalent organic group and is preferably an alkyl group having 1 to 8 carbon atoms. A carbon atom, which is a spiro atom, is preferably bonded to a 4-position of the benzene ring bonded to the iridium atom. R4 is preferably 1. When r4 is 1, R³⁷ is preferably bonded to a 4-position of the benzene ring.

Specific preferable examples of the fluorene compounds represented by the general formula (4C) include a fluorene compound represented by the following structural formula (15).

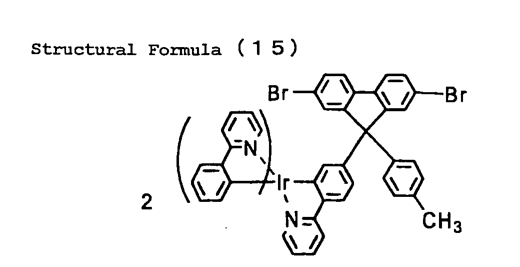

The fluorene compound represented by the structural formula (15) is a fluorene compound that, in the general formula (4C), X⁶ and X⁷ are bromine atoms, L is bidentate phenylpyridine, the carbon atom, which is a spiro atom, is bonded to a 4-position of the benzene ring bonded to the iridium atom, r4 is 1, R³⁷ is a methyl group, and this methyl group is bonded to a 4-position of the benzene ring.

When this fluorene compound is used as the specific metal complex-containing compound, the phosphorescent polymer of the present invention, which has the specific structural unit represented by the general formula (A), can be obtained.

The fluorene compounds represented by the general formula (4D) are fluorene compounds that, in the general formula (4), X⁶ and X⁷ are the same reactive functional groups bonded to carbon atoms of position numbers 2 and 7, respectively, in the fluorene skeleton, R¹⁷ and R¹⁸ are alkoxylene groups represented by a formula R³⁸-O, and R¹⁹ and R²⁰ are groups represented by the general formula (1-2), in which M is an iridium atom, w is 2, and u1 and v1 are 0.

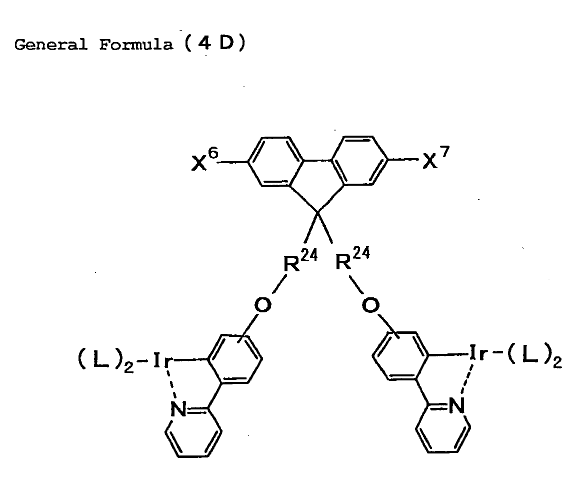

In the formula, X⁶ and X⁷ are reactive functional groups, R²⁴ is a divalent organic group, and L is an organic ligand.

In the general formula (4D), each of the oxygen atoms is preferably bonded to a 4-position of the benzene ring.

R²⁴ is preferably an alkylene group having 1 to 20 carbon atoms.

Specific preferable examples of the fluorene compounds represented by the general formula (4D) include a fluorene compound represented by the following structural formula (16).

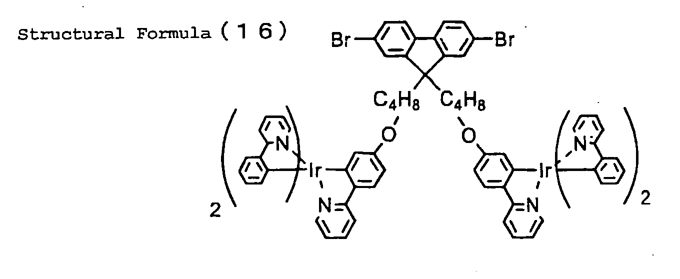

The fluorene compound represented by the structural formula (16) is a fluorene compound that, in the general formula (4D), X⁶ and X⁷ are bromine atoms, L is bidentate phenylpyridine, R²⁴ is a butylene group, and each of the oxygen atoms is bonded to a 4-position of the benzene ring.

When this fluorene compound is used as the specific metal complex-containing compound, the phosphorescent polymer of the present invention, which has the specific structural unit represented by the general formula (A), can be obtained.

The fluorene compounds represented by the general formula (4E) are fluorene compounds that, in the general formula (4) , X⁶ and X⁷ are the same reactive functional groups bonded to carbon atoms of position numbers 2 and 7, respectively, in the fluorene skeleton, R¹⁷ and R¹⁸ are alkoxylene groups represented by a formula R³⁸-O, and R¹⁹ and R²⁰ are groups represented by the general formula (1-1), in which M is an iridium atom, w is 2, and s1 and t1 are 0.

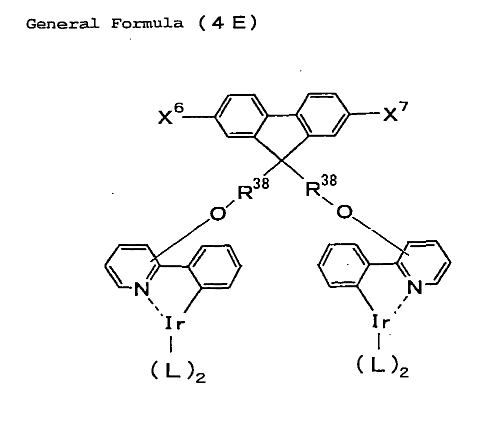

In the formula, X⁶ and X⁷ are reactive functional groups, R³⁸ is a divalent organic group, and L is an organic ligand.

In the general formula (4E), R³⁸ is a divalent organic group and is preferably an alkylene group having 1 to 20 carbon atoms. Each of the oxygen atoms is preferably bonded to a 5-position of the pyridine ring.

Specific preferable examples of the fluorene compounds represented by the general formula (4E) include a fluorene compound represented by the following structural formula (17).

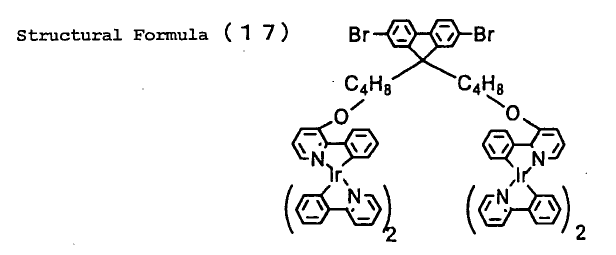

The fluorene compound represented by the structural formula (17) is a fluorene compound that, in the general formula (4E), X⁶ and X⁷ are bromine atoms, L is bidentate phenylpyridine, R³⁸ is a butylene group, and each of the oxygen atoms is bonded to a 5-position of the pyridine ring.

When this fluorene compound is used as the specific metal complex-containing compound, the phosphorescent polymer of the present invention, which has the specific structural unit represented by the general formula (B), can be obtained.

Specific 5 processes for producing such specific fluorene compounds as described above will hereinafter be described.

### « First production process»

The first production process can provide, for example, the specific fluorene compound represented by the structural formula (13).

According to the first production process, a compound (hereinafter also referred to as "raw pyridine compound (C-1)") represented by the above general formula (4-1) is reacted with a compound (hereinafter also referred to as "raw diphenyl compound (C)") represented by the above general formula (4-2) (this reaction step is hereinafter referred to as "first reaction step (C-1)"), to obtain an intermediate reaction product (hereinafter also referred to as "intermediate reaction product (C-1)"). The intermediate reaction product (C-1) is then reacted with a raw metal complex-containing compound represented by the general formula (1-6) (this reaction step is hereinafter referred to as "second reaction step (C-1)"), thereby producing the specific fluorene compound.

### [First reaction step (C-1)]

In the general formula (4-1) representing the raw pyridine compound (C-1) used in the first reaction step (C-1), X⁸ is a halogen atom, for example, a bromine or iodine atom, with the bromine atom being preferred.

Specific preferable examples of the raw pyridine compound (C-1) include that represented by the above general formula (4-1), in which both u1 and v1 are 0, and X⁸ is a bromine atom.

In the general formula (4-2) representing the raw diphenyl compound (C) used in the first reaction step (C-1), R²¹ is a monovalent organic group, with a methyl group being preferred.

Specific preferable examples of the raw diphenyl compound (C) include compounds represented by the following general formula (4-2A).

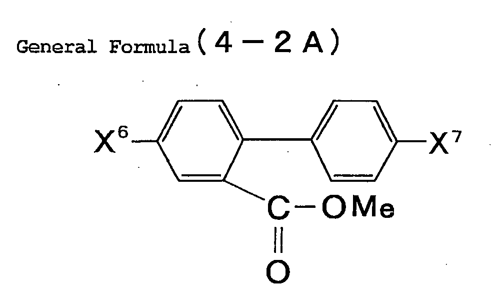

In the formula, X⁶ and X⁷ are, independently of each other, a reactive functional group.

The first reaction step (C-1) comprises 2 treatment steps of a preliminary reaction treatment and a post reaction treatment.

More specifically, the preliminary reaction treatment is a treatment in which the raw pyridine compound (C-1) is treated in the presence of a lithiolation reagent, thereby substituting the bromine atom of X⁸ with a lithium atom, and this compound is then reacted with the raw diphenyl compound (C).

Specific examples of the lithiation reagent used in the preliminary reaction treatment include n-butyllithium, s-butyllithium and t-butyllithium, with n-butyllithium being particularly preferred.

A polar solvent is used in the preliminary reaction treatment. In general, tetrahydrofuran is preferably used.

The post reaction treatment is a treatment conducted under acidic conditions and in the reaction treatment, for example, an acidic solvent composed of a combination of acetic acid and hydrochloric acid is preferably used as the solvent.

### [Second reaction step (C-1)]

In the general formula (1-6) representing the raw metal complex-containing compound used in the second reaction step (C-1) , R⁹ is a specific bidentate reactive chelate ligand having 2 coordinating atoms and bonded to M, which is a central metal, by the coordinating atoms.

Specific preferable examples of such a specific reactive chelate ligand include an acetylacetonato ligand and a phenylpyridine ligand having a reactive substituent group.

Specific preferable examples of the raw metal complex-containing compound include a compound represented by the structural formula (5).

In the second reaction step (C-1), a proper solvent is used. Specific examples of such a solvent include glycerol, methoxyethanol and ethoxyethanol. These solvents may be used either singly or in any combination thereof. Among these, glycerol is preferably used.

With respect to reaction conditions for the second reaction step (C-1), for example, the reaction temperature is 150 to 300°C, preferably 200 to 250°C.

The reaction time is 10 to 50 hours, preferably 15 to 30 hours.

### «Second production process»

The second production process can provide, for example, the specific fluorene compound represented by the structural formula (14).

According to the second production process, a compound (hereinafter also referred to as "raw pyridine compound (C-2)") represented by the above general formula (4-3) is reacted with a compound (hereinafter also referred to as "raw fluorene compound (C-2)") represented by the above general formula (4-4) (this reaction step is hereinafter referred to as "first reaction step (C-2)"), to obtain a first intermediate reaction product (hereinafter also referred to as "first intermediate reaction product (C-2)"). The first intermediate reaction product (C-2) is then reacted with a halogen (this reaction step is hereinafter referred to as "second reaction step (C-2)"), to obtain a second intermediate reaction product (hereinafter also referred to as "second intermediate reaction product (C-2)"). The second intermediate reaction product (C-2) is further reacted with a raw metal complex-containing compound represented by the general formula (1-6) (this reaction is hereinafter referred to as "third reaction step (C-2)"), thereby producing the specific fluorene compound.

### [First reaction step (C-2)]

In the general formula (4-3) representing the raw pyridine compound (C-2) used in the first reaction step (C-2), X⁹ is a halogenic functional group or boron derivative functional group and is different from X¹⁰ in the general formula (4-4) representing the raw fluorene compound (C-2).

In the general formula (4-3), a -Br or -I group is particularly preferred as the halogenic functional group, and a group represented by a formula -B(OR³¹O) is particularly preferred as the boron derivative functional group.

Specific examples of the raw pyridine compound (C-2) include that represented by the general formula (4-3), in which both u1 and v1 are 0, and X⁹ is a bromine atom.

In the general formula (4-4) representing the raw fluorene compound (C-2) used in the first reaction step (C-2) , X¹⁰ is a reactive halogenic functional group or boron derivative functional group and is different from X⁹ in the general formula (4-3) as described above.

In the general formula (4-4), a -Br or -I group is particularly preferred as the halogenic functional group, and a group represented by a formula -B (OR³¹O) is particularly preferred as the boron derivative functional group.

R²² and R²³ are, independently of each other, a monovalent organic group and may be the same or different from each other. However, these groups are preferably the same.

Examples of the monovalent organic groups related to R²² and R²³ include methyl, ethyl, propyl, isopropyl and phenyl groups.

q2 and q3 are, independently of each other, an integer of 0 to 4, with both q2 and q3 being particularly preferably 0.

In the general formula (4-4), the fact that both q2 and q3 are 0 means that, respectively, substituent group is not present, and hydrogen atoms are bonded. Specific preferable examples of the raw fluorene compound (C-2) include a compound that, in the general formula (4-4), X¹⁰ is a boron derivative functional group represented by the formula -B (OR³¹O) , in which R³¹ is an alkylene group represented by a formula -C(CH₃)₂C(CH₃)₂-, and all of n3, n4, q2 and q3 are 0.

The first reaction step (C-2) is a reaction utilizing the Suzuki's method. More specifically, the Suzuki's method is a method that a coupling reaction is conducted in the presence of a basic compound and a palladium catalyst in a reaction solvent.

As the reaction solvent, may be used water, an inert organic solvent or a mixture of water and an inert organic solvent. Among these, the mixture of water and an inert organic solvent is preferably used.

Examples of the inert organic solvent include ethers such as dimethoxyethane, diethylene glycol dimethyl ether, tetrahydrofuran, dioxane, diisopropyl ether and tert-butyl methyl ether, hydrocarbons such as hexane, heptane, cyclohexane, toluene and xylene, alcohols such as methanol, ethanol, 1-propanol, 2-propanol, 1-butyl alcohol, tert-butyl alcohol and ethylene glycol, ketones such as ethyl methyl ketone and isobutyl methyl ketone, amides such as dimethylformamide, dimethylacetamide and N-methylpyrrolidone, and mixtures thereof. These inert organic solvents may be used either singly or in any combination thereof.

Among these, dimethoxyethane, tetrahydrofuran, cyclohexane, toluene, xylene, ethanol, 1-propanol, 2-propanol, 1-butyl alcohol, tert-butyl alcohol and mixtures thereof are preferably used.

Specific preferable examples of a suitably usable reaction solvent include a mixture of water and toluene, a mixture of water, toluene and tetrahydrofuran, and a mixture of water, toluene and ethanol.

Examples of a usable basic compound include alkali metal hydroxides, alkaline earth metal hydroxides, alkali metal carbonates, alkaline earth metal carbonates, alkali metal acetates, alkaline earth metal acetates, alkali metal hydrogencarbonates, alkaline earth metal hydrogencarbonates, alkali metal alkoxides, alkaline earth metal alkoxides, primary amines, secondary amines and tertiary amines.

Among these, alkali metal hydroxides such as sodium hydroxide and potassium hydroxide, alkali metal carbonates such as lithium carbonate, sodium carbonate and potassium carbonate, alkali metal hydrogencarbonates are preferably used.

The amount of the basic compound used is preferably 150 to 400 mol%, particularly preferably 180 to 250 mol% based on the total mol of the halogenic functional group or boron derivative functional group in the raw pyridine compound (C-2) or raw fluorene compound (C-2) used in the reaction.

As the palladium catalyst, may be used a palladium(0) complex or palladium (II) salt. However, a palladium (0) complex is preferably used.

Among these, tetrakis(triphenylphosphine)palladium (Pd (PPh₃)₄) is preferably used.

The amount of the palladium catalyst used is generally 0.05 to 3 mol%, preferably 0.1 to 1.5 mol% based on the total mol of the monomers used in the reaction.

With respect to reaction conditions for the first reaction step (C-2), for example, the reaction temperature is 30 to 200°C, preferably 60 to 120°C.

The reaction time is 5 to 150 hours, preferably 10 to 100 hours.

### [Second reaction step (C-2)]

Examples of the halogen used in the second reaction step (C-2) include bromine and iodine atoms, with the bromine atom being preferred.

In the second reaction step (C-2), a halogen-containing solvent is used. Chloroform is preferably used.

The second reaction step (C-2) is preferably conducted in the presence of an oxidizing agent. Iron chloride is preferably used as the oxidizing agent.

With respect to reaction conditions for the second reaction step (C-2), for example, the reaction temperature is 30 to 150°C, preferably 50 to 100°C.

The reaction time is 5 to 30 hours, preferably 10 to 20 hours.

### [Third reaction step (C-2)]

The third reaction step (C-2) may be conducted by the same technique as in the second reaction step (C-1) related to the first production process.

### «Third production process»

The third production process can provide, for example, the specific fluorene compound represented by the structural formula (15).

According to the third production process, a raw pyridine compound (C-1) represented by the general formula (4-1) is reacted with a compound (hereinafter also referred to as "raw fluorenone compound (C-3)") represented by the above general formula (4-5) (this reaction step is hereinafter referred to as "first reaction step (C-3)"), to obtain a first intermediate reaction product (hereinafter also referred to as "first intermediate reaction product (C-3)"). The first intermediate reaction product (C-3) is then reacted with a benzene derivative (hereinafter also referred to as "benzene derivative (C)") having 1 to 5 substituent groups each composed of a monovalent organic group (this reaction step is hereinafter referred to as "second reaction step (C-3)"), to obtain a second intermediate reaction product (hereinafter also referred to as "second intermediate reaction product (C-3)"). The second intermediate reaction product (C-3) is further reacted with a raw metal complex-containing compound represented by the general formula (1-6) (this reaction step is hereinafter referred to as "third reaction step (C-3)"), thereby producing the specific fluorene compound.

### [First reaction step (C-3)]

Specific preferable examples of the raw pyridine compound (C-1) used in the first reaction step (C-3) include that, in the general formula (4-1), both u1 and v1 are 0, and X⁸ is a bromine atom.

Specific preferable examples of the raw fluorenone compound (C-3) used in the first reaction step (C-3) include a compound that, in the general formula (4-5), in which X⁶ and X⁷ are bromine atoms bonded to carbon atoms of position numbers 2 and 7, respectively, in the fluorene skeleton, and both n3 and n4 are 0.

The first reaction step (C-3) may be conducted in the same manner as in the preliminary reaction treatment of the first reaction step (C-1) related to the first production process except that the raw fluorenone compound (C-3) is used in place of the raw diphenyl compound (C) in the first reaction step (C-1).

### [Second reaction step (C-3)]

In the benzene derivative (C) used in the second reaction step (C-3), specific examples of the monovalent organic group, which is a substituent group, include methyl, ethyl, propyl, isopropyl and phenyl groups, with a tolyl group being particularly preferred.

The second reaction step (C-3) is conducted under acidic conditions and in the reaction step, for example, sulfuric acid is preferably used as a solvent.

### [Third reaction step (C-3)]

The third reaction step (C-3) may be conducted by the same technique as in the second reaction step (C-1) related to the first production process.

### « Fourth production process»

The fourth production process can provide, for example, the specific fluorene compound represented by the structural formula (16).

According to the fourth production process, a compound (hereinafter also referred to as "raw pyridine compound (C-4)") represented by the above general formula (1-4) is reacted with an organic dihalogenide (hereinafter also referred to as "raw dihalogenide (C)") with halogen substituents bonded to both terminals of its main chain (this reaction step is hereinafter referred to as "first reaction step (C-4)"), to obtain a first intermediate reaction product (hereinafter also referred to as "first intermediate reaction product (C-4)"). The first intermediate reaction product (C-4) is then reacted with a compound (hereinafter also referred to as "raw fluorene compound (C-4)") represented by the above general formula (4-6) (this reaction step is hereinafter referred to as "second reaction step (C-4)"), to obtain a second intermediate reaction product (hereinafter also referred to as "second intermediate reaction product (C-4)"). The second intermediate reaction product (C-4) is further reacted with a raw metal complex-containing compound represented by the general formula (1-6) (this reaction is hereinafter referred to as "third reaction step (C-4)"), thereby producing the specific fluorene compound.

### [First reaction step (C-4)]

Specific preferable examples of the raw pyridine compound (C-4) used in the first reaction step (C-4) include that represented by the general formula (1-4), in which both u1 and v1 are 0.

The raw dihalogenide (C) used in the first reaction step (C-4) is an organic compound having halogen substituents at both terminals thereof. Examples thereof include derivatives of alkanes having 1 to 20 carbon atoms, preferably 1 to 8 carbon atoms and derivatives of monocyclic to tricyclic divalent aromatic compounds (for example, phenol, naphthalene, anthracene and xylene) which may be substituted, with derivatives of alkanes having 1 to 8 carbon atoms being preferred.

The raw dihalogenide is preferably dibromobutane.

In the first reaction step (C-4) , a proper solvent is used. Specific examples of such a solvent include dimethyl sulfoxide (DMSO), dimethylformamide and dimethylacetamide. These solvents may be used either singly or in any combination thereof. Among these, dimethyl sulfoxide is preferably used.

The first reaction step (C-4) is preferably conducted in the presence of a basic compound. Specific examples of a usable basic compound include alkali metal hydroxides, alkaline earth metal hydroxides, alkali metal carbonates, alkaline earth metal carbonates, alkali metal acetates, alkaline earth metal acetates, alkali metal hydrogencarbonates, alkaline earth metal hydrogencarbonates, alkali metal alkoxides, alkaline earth metal alkoxides, primary amines, secondary amines and tertiary amines. Among these, potassium carbonate is preferably used.

Such a basic compound is used in a range of, for example, 1 to 10 mol, preferably 3 to 7 mol.

In order to enhance the activity of the reaction, the first reaction step (c-4) is preferably conducted in the presence of a catalytic amount (very trace amount) of potassium iodide.

With respect to reaction conditions for the first reaction step (C-4), for example, the reaction temperature is 20 to 100°C, preferably 30 to 60°C.

The reaction time is 5 to 30 hours, preferably 10 to 20 hours.

### [Second reaction step (C-4)]

Specific preferable examples of the raw fluorene compound (C-4) used in the second reaction step (C-4) include a compound that, in the above general formula (4-6), X⁶ and X⁷ are bromine atoms bonded to carbon atoms of position numbers 2 and 7, respectively, in the fluorene skeleton, and both n3 and n4 are 0.

In the second reaction step (C-4), those exemplified as the solvents in the first reaction step (C-4) may be used as solvents. The second reaction step (C-4) is preferably conducted in the presence of a basic compound. As such a basic compound, may be used those exemplified as the basic compounds in the first reaction step (C-4).

### [Third reaction step (C-4)]

The third reaction step (C-4) may be conducted by the same technique as in the second reaction step (C-1) related to the first production process.

### «Fifth production process»

The fifth production process can provide, for example, the specific fluorene compound represented by the structural formula (17).

According to the fifth production process, a compound (hereinafter also referred to as "raw pyridine compound (C-5)") represented by the above general formula (4-7) is reacted with a raw dihalogenide (C) (this reaction step is hereinafter referred to as "first reaction step (C-5)"), to obtain a first intermediate reaction product (hereinafter also referred to as "first intermediate reaction product (C-5)"). The first intermediate reaction product (C-5) is then reacted with a compound (hereinafter also referred to as "raw benzene compound (C)") represented by the above general formula (4-8) (this reaction step is hereinafter referred to as "second reaction step (C-5)"), to obtain a second intermediate reaction product (hereinafter also referred to as "second intermediate reaction product (C-5)"). The second intermediate reaction product (C-5) is further reacted with a raw fluorene compound (C-4) represented by the general formula (4-6) (this reaction step is hereinafter referred to as "third reaction step (C-5)"), to obtain a third intermediate reaction product (hereinafter also referred to as "third intermediate reaction product (C-5)"). The third intermediate reaction product (C-5) is further reacted with a raw metal complex-containing compound represented by the general formula (1-6) (this reaction is hereinafter referred to as "fourth reaction step (C-5)"), thereby producing the specific fluorene compound.

### [First reaction step (C-5)]

In the general formula (4-7) representing the raw pyridine compound (C-5) used in the first reaction step (C-5), X¹¹ is a halogenic functional group or boron derivative functional group and is different from X¹² in the general formula (4-8) representing the raw benzene compound (C).

In the general formula (4-7), a -Br or -I group is particularly preferred as the halogenic functional group, and a boronic group represented by a formula -B (OH₂) is particularly preferred as the boron derivative functional group.

Specific examples of the raw pyridine compound (C-5) include that represented by the general formula (4-7), in which m3 is 0, and X¹¹ is a bromine atom.

The raw dihalogenide (C) used in the first reaction step (C-5) is preferably dibromobutane.

The first reaction step (C-5) may be conducted by the same technique as in the first step (C-4) related to the fourth production process.

### [Second reaction step (C-5)]

In the general formula (4-8) representing the raw benzene compound (C) used in the second reaction step (C-5), X¹² is a halogenic functional group or boron derivative functional group and is different from X¹¹ in the general formula (4-7) as described above.

In the general formula (4-8), a -Br or -I group is particularly preferred as the halogenic functional group, and a boronic group represented by a formula -B(OH)₂ is particularly preferred as the boron derivative functional group.

Specific examples of the raw benzene compound (C) include that, in the general formula (4-8), X¹² is a boronic group represented by a formula -B(OH)₂, and m4 is 0.

The second reaction step (C-5) is a reaction utilizing the Suzuki's method and may be conducted in the same technique as in the first reaction step (C-2) related to the second production process.

### [Third reaction step (c-5)]

Specific preferable examples of the raw fluorene compound (C-4) used in the third reaction step (C-5) include a compound that, in the general formula (4-6), X⁶ and X⁷ are bromine atoms bonded to carbon atoms of position numbers 2 and 7, respectively, in the fluorene skeleton, and both n3 and n4 are 0.

In the third reaction step (C-5), a proper solvent is used. Specific examples of such a solvent include dimethyl sulfoxide (DMSO), dimethylformamide and dimethylacetamide. These solvents may be used either singly or in any combination thereof. Among these, dimethyl sulfoxide is preferably used.

The third reaction step (C-5) is preferably conducted in the presence of a proper catalyst and in the reaction step, for example, triethylbenzylammonium chloride is preferably used.

The third reaction step (C-5) is preferably conducted in an alkaline solution. For example, an aqueous solution of sodium hydroxide, an aqueous solution of potassium hydroxide or an aqueous solution of barium hydroxide is preferably used. The aqueous solution of sodium hydroxide is particularly preferably used.

With respect to reaction conditions for the third reaction step (C-5), for example, the reaction temperature is 20 to 100°C, preferably 30 to 60°C.

The reaction time is 5 to 70 hours, preferably 10 to 50 hours.

### [Fourth reaction step (C-5)]

The fourth reaction step (C-5) may be conducted by the same technique as in the second reaction step (C-1) related to the first production process.

Although the production processes of the specific fluorene compounds have been described above, the specific fluorene compounds are not limited to those produced by the above-described production processes, and those produced by other production processes may also be used.

As specific preferable examples of the specific aromatic compound, may be mentioned diphenyl ether derivatives such as 4,4'-bis(4,4,5,5-tetramethyl-1,3,2-dioxaboran-2-yl)phenyl ether and 4,4'-dibromophenyl ether, fluorene derivatives such as 9,9-dioctyl-2,7-bis(4,4,5,5-tetramethyl-1,3,2-dioxaboran-2-yl)fluorene and 9,9-dioctyl-2,7-dibromofluorene, and carbazole derivatives represented by the following general formula (8).

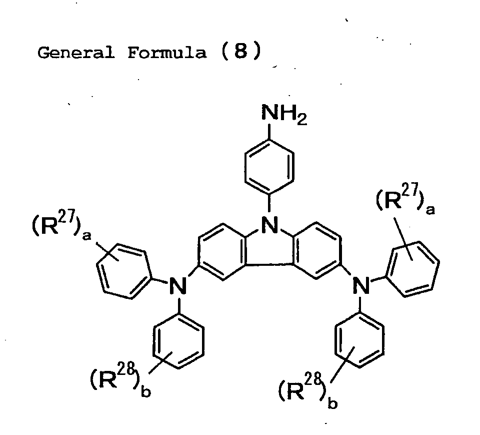

In the formula, R²⁷ and R²⁸ are, independently of each other, a monovalent organic group, and a and b are, independently of each other, an integer of 0 to 5.

Specific preferable examples of a process for producing the phosphorescent polymer of the present invention represented by the general formula (E) include a process, in which a specific fluorenone compound (hereinafter also referred to as "iridium complex-containing compound (1)") represented by the general formula (4D) as the specific metal complex-containing compound, a diphenyl ether compound (hereinafter also referred to as "diphenyl ether compound (1)") having 2 reactive functional groups as the specific aromatic compound and another diphenyl ether compound (hereinafter also referred to as "diphenyl ether compound (2)") having reactive functional groups different from those of the diphenyl ether compound (1) are used, and these compounds are reacted in the presence of a palladium compound that is a catalyst, as shown in the following reaction scheme (1).

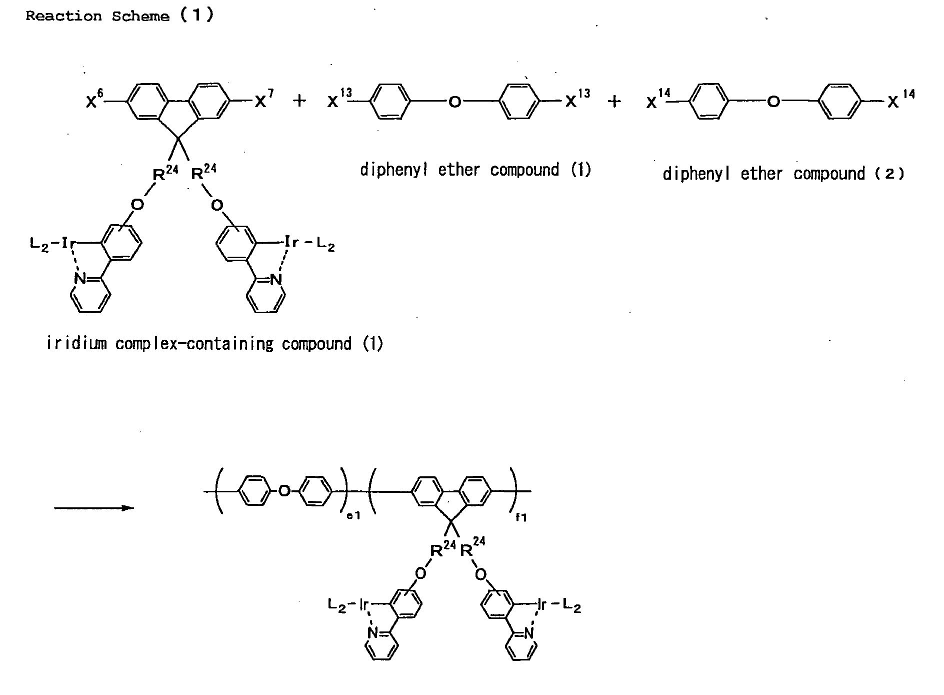

In the formula, X⁶, X⁷, X¹³ and X¹⁴ are, independently of each other, a reactive functional group, R²⁴ is a divalent organic group, L is an organic ligand, and e1 and f1 are repetition numbers.

A mixed solvent composed of a combination of an organic solvent and an alkaline aqueous solution is used as a solvent.

Examples of the organic solvent include ethers such as dimethoxyethane, dioxane and tetrahydrofuran, hydrocarbons such as toluene and xylene, and alcohols such as methanol, ethanol and t-butyl alcohol.

These solvents may be used either singly or in any combination thereof.

Examples of the alkaline aqueous solution include aqueous solutions of amines such as tetraethylammonium hydroxide, aqueous solutions of alkali metal hydroxides such as sodium hydroxide and potassium hydroxide, and aqueous solutions of alkali metal carbonates such as sodium carbonate and potassium carbonate.

Specific preferable examples of the solvent include a mixed solvent of toluene as the organic solvent and an aqueous solution of sodium carbonate as the alkaline aqueous solution.

The amount of the solvent used varies according to the kinds of the compounds used in the reaction, or the like. In general, however, it is preferably a proportion that the total concentration of the compounds used in the reaction amounts to 5 to 30 % by mass.

As the palladium compound that is a catalyst, may be used a palladium (0) complex or palladium(II) salt. However, a palladium(0) complex is preferably used. Among these, tetrakis(triphenylphosphine)palladium(0) is preferably used.

These catalysts may be used either singly or in any combination thereof.

In general, the amount of the palladium catalyst used is preferably 0.1 to 1.5 mol % based on the total mol of the compounds used in the reaction.

In the polymerization treatment, the reaction temperature is 20 to 200°C, preferably 50 to 150°C.

Terminals of a reaction product obtained by the polymerization treatment are preferably substituted with any aromatic compound, whereby a phosphorescent polymer excellent in luminous efficiency and durability can be obtained.

In the production process described above, the iridium complex-containing compound (1) used in the reaction is preferably a compound that R²⁴ is a butylene group, X⁶ and X⁷ are bromine atoms, L is bidentate phenylpyridine, and the oxygen atom is bonded to a 4-position of the benzene ring. The diphenyl ether compound (1) is preferably a compound that X¹³ is a -B (OC₂H₄O) group, and the diphenyl ether compound (2) is preferably a compound that X¹⁴ is a bromine atom.

In this case, a proportion of the specific structural unit in the resulting phosphorescent polymer can be controlled by controlling a ratio among the iridium complex-containing compound (1), diphenyl ether compound (1) and diphenyl ether compound (2) used in the reaction. However, it is necessary that a ratio between the halogenic functional group and boron derivative functional group present in the reaction system is 1:1

Specific preferable examples of a process for producing the phosphorescent polymer of the present invention represented by the general formula (F) include a process, in which an iridium complex-containing compound (1) as the specific metal complex-containing compound, a fluorene compound (hereinafter also referred to as "fluorene compound (1)") having 2 reactive functional groups as the specific aromatic compound and another fluorene compound (hereinafter also referred to as "fluorene compound (2)") having reactive functional groups different from those of the fluorene compound (1) are used, and these compounds are reacted in the presence of a palladium compound that is a catalyst, as shown in the following reaction scheme (2).

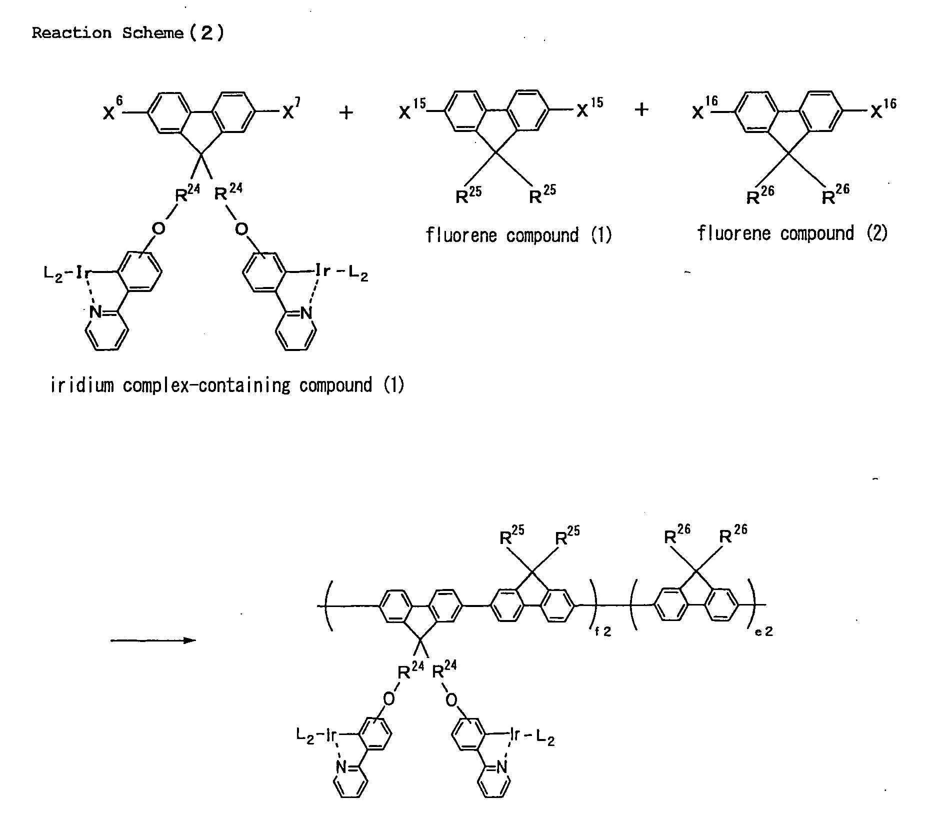

In the formula, X⁶,X⁷, X¹⁵ and X¹⁶ are, independently of each other, a reactive functional group, R²⁴ is a divalent organic group, R²⁵ and R²⁶ are, independently of each other, a monovalent organic group, L is an organic ligand, and e2 and f2 are repetition numbers.

As the solvent and the palladium compound that is a catalyst, may be used those used in the reaction process for obtaining the phosphorescent polymer represented by the general formula (E). These components may be used in the same amounts as those used in the reaction process for obtaining the phosphorescent polymer represented by the general formula (E).

In the polymerization treatment, the reaction temperature may be the same temperature as that used in the reaction process for obtaining the phosphorescent polymer represented by the general formula (E).

Terminals of a reaction product obtained by the polymerization treatment are preferably substituted with any aromatic compound, whereby a phosphorescent polymer excellent in luminous efficiency and durability can be obtained.

In the production process described above, the iridium complex-containing compound (1) used in the reaction is preferably a compound that R²⁴ is a butylene group, X⁶ and X⁷ are bromine atoms, L is bidentate phenylpyridine, and the oxygen atom is bonded to a 4-position of the benzene ring. The fluorene compound (1) is preferably a compound that R²⁵ is an octyl group, X¹⁵ is a -B(OC₂H₄O) group, and the fluorene compound (2) is preferably a compound that R²⁶ is an octyl group, and X¹⁶ is a bromine atom.

In this case, a proportion of the specific structural unit in the resulting phosphorescent polymer can be controlled by controlling a ratio among the iridium complex-containing compound (1), fluorene compound (1) and fluorene compound (2) used in the reaction. However, it is necessary that a ratio between the halogenic functional group and the boron derivative functional group present in the reaction system is 1:1.

Specific preferable examples of a process for producing the phosphorescent polymer of the present invention represented by the general formula (G) include a process, in which an iridium complex-containing compound (1) as the specific metal complex-containing compound, a diphenyl ether compound (1) as the specific aromatic compound and an aminocarbazole compound (hereinafter also referred to as "aminocarbazole compound (1)") are used, and these compounds are reacted in the presence of a palladium compound that is a catalyst and a base, as shown in the following reaction scheme (3).

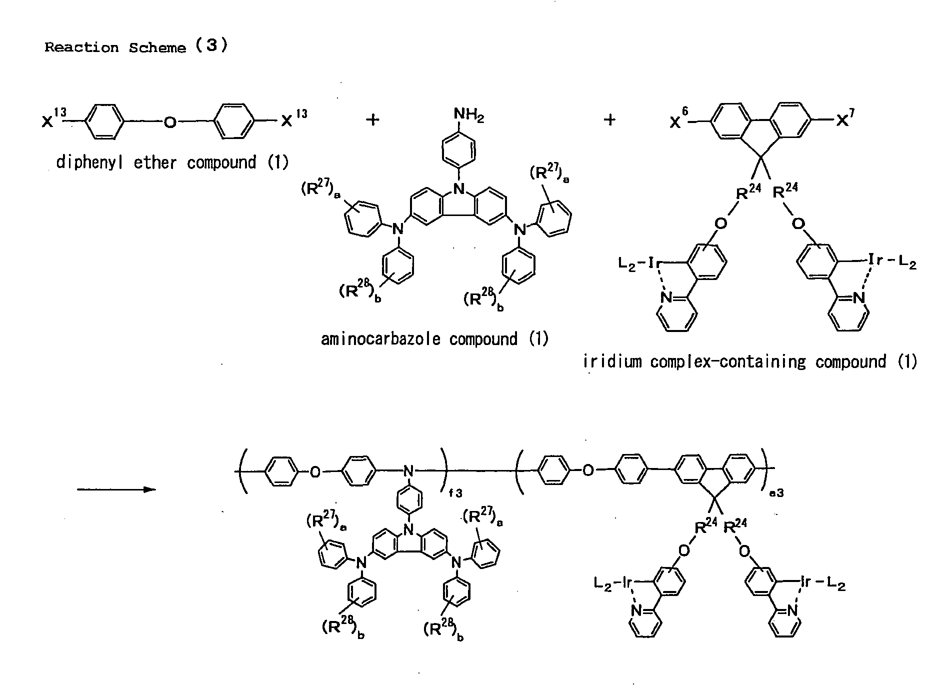

In the formula, X⁶, X⁷ and X¹³ are, independently of each other, a reactive functional group, R²⁴ is a divalent organic group, R²⁷ and R²⁸ are, independently of each other, a monovalent organic group, L is an organic ligand, e3 and f3 are repetition numbers, and a and b are individually an integer of 0 to 5.

Examples of the solvent used in this reaction process include aromatic hydrocarbon solvents such as benzene, toluene, xylene and mesitylene, ether solvents such as diethyl ether, tetrahydrofuran and dioxane, acetonitrile, dimethylformamide, and dimethyl sulfoxide.

These solvents may be used either singly or in any combination thereof.

Specific preferable examples of the solvent include aromatic hydrocarbon solvents.

The amount of the solvent used varies according to the kinds of the compounds used in the reaction, or the like. In general, however, it is preferably a proportion that the total concentration of the compounds used in the reaction amounts to 5 to 30 % by mass.

As the palladium compound that is a catalyst, may be used a palladium (0) complex or palladium(II) salt. However, a palladium (0) complex is preferably used. Among these, tetrakis(triphenylphosphine)palladium(0) is preferably used.

These catalysts may be used either singly or in any combination thereof.

In general, the amount of the palladium catalyst used is preferably 0.1 to 10 mol % based on the total mol of the compounds used in the reaction.

As a catalyst, phosphine is preferably used in combination with the palladium compound.

As such phosphine, may be used, for example, diphenylphosphinoferrocene, 2,2'-bis(diphenylphosphino)-1,1'-binaphthyl (BINAP), triphenylphosphine, tricyclohexylphosphine or tri-tert-butylphosphine.

When the palladium compound and phosphine are used in combination as catalysts, they may be separately added to the reaction system. However, a complex of the palladium compound and phosphine may be prepared in advance to add the complex to the reaction system.

When the palladium compound and phosphine are used in combination as catalysts, the amount of the phosphine used may be within a range of 0.01 to 10,000 mol per mol of the palladium compound. Since the phosphine is expensive, the amount thereof is particularly preferably within a range of 0.1 to 10 mol per mol of the palladium compound in view of profitability.

As the base, may be used, for example, sodium tert-butoxide, sodium methoxide, potassium methoxide, sodium ethoxide or potassium ethoxide.

These bases may be used either singly or in any combination thereof.

The amount of the base used is preferably 1 to 5 molar equivalents per mol of the halogen in the reaction system.

The reaction temperature in the polymerization treatment is preferably 20 to 250°C, more preferably 50 to 150°C.

Terminals of a reaction product obtained by the polymerization treatment are preferably substituted with any aromatic compound, whereby a phosphorescent polymer excellent in luminous efficiency and durability can be obtained.

In the production process described above, the iridium complex-containing compound (1) used in the reaction is preferably a compound that R¹ is an ethylene group, X⁶ and X⁷ are bromine atoms, L is bidentate phenylpyridine, and the oxygen atom is bonded to a 4-position of the benzene ring. The diphenyl ether compound (1) is preferably a compound that X¹³ is a bromine atom. The aminocarbazole compound (1) is preferably a compound that a is 0, b is 1, and R²⁸ is a methyl group bonded to a carbon atom of a position number 5 in the benzene ring.

Such a phosphorescent polymer according to the present invention as described above may be used as a material for forming a luminescent layer of an organic EL device by itself.

When the phosphorescent polymer of the present invention is used as the material for forming a luminescent layer of an organic EL device by itself, any additive such as an electron transporting low-molecular compound may be added as needed.

Examples of the electron-transporting low-molecular compound include metal complexes such as tris (8-hydroxy-quinolino)aluminum (Alq3), oxadiazole compounds such as 2-(4-biphenyl)-5-(4-tert-butylphenyl)-1,3,4-oxadiazole (PBD), and triazole compounds such as 1-phenyl-2-biphenyl-5-tert-butylphenyl-1,3,4-triazole (TAZ). Oxadiazole compounds such as 2-(4-biphenyl)-5-(4-tert-butylphenyl)-1,3,4-oxadiazole (PBD) are particularly preferably used.

A proportion of the electron-transporting low-molecular compound contained is preferably 10 to 40 parts by mass per 100 parts by mass of the phosphorescent polymer.

The phosphorescent polymer of the present invention is generally used as a polymer solution for forming a luminescent layer by dissolving it in a proper organic solvent. This polymer solution is applied to a surface of a substrate, on which a luminescent layer should be formed, and the resultant coating film is subjected to a treatment for removing the organic solvent, whereby a luminescent layer in an organic EL device can be formed.

No particular limitation is imposed on the organic solvent for preparing the polymer solution for forming the luminescent layer so far as it can dissolve the phosphorescent polymer according to the present invention to be used. Specific examples thereof include halogenated hydrocarbons such as chloroform, chlorobenzene and tetrachloroethane, amide solvents such as dimethylformamide and N-methylpyrrolidone, cyclohexanone, ethyl lactate, propylene glycol methyl ether acetate, ethyl ethoxypropionate, and methyl amyl ketone. These organic solvents may be used either singly or in any combination thereof.

Among these, that having a proper evaporation rate, specifically, an organic solvent having a boiling point of about 70 to 200°C is preferably used in that a thin film having a uniform thickness can be obtained.

A proportion of the organic solvent used varies according to the kind of the phosphorescent polymer. However, it is generally a proportion that the concentration of the phosphorescent polymer amounts to 0.5 to 10% by mass.

As a means for applying the polymer solution, may be used, for example, a spin coating method, dipping method, roll coating method, ink-jet method or printing method.

No particular limitation is imposed on the thickness of the luminescent layer formed. However, it is generally selected within a range of 10 to 200 nm, preferably 30 to 100 nm.

According to such a phosphorescent polymer, a luminescent layer that can achieve high luminous luminance can be easily formed by a wet method such as an ink-jet method. After all, an organic EL device high in luminous luminance can be provided.

### <Organic EL Device>

Fig. 1 is a cross-sectional view illustrating the construction of an exemplary organic EL device according to the present invention.

In the organic EL device of this embodiment, an anode 2 that is an electrode supplying a hole is provided by, for example, a transparent conductive film on a transparent substrate 1, and a hole injecting and transporting layer 3 is provided on this anode 2. A luminescent layer 4 is provided on the hole injecting and transporting layer 3, a hole blocking layer 8 is provided on the luminescent layer 4, and an electron injecting layer 5 is provided on the hole blocking layer 8. A cathode 6 that is an electrode supplying an electron is provided on this electron injecting layer 5. The anode 2 and cathode 6 are electrically connected to a DC power source 7.

In this organic EL device, a glass substrate, transparent resin substrate, quartz glass substrate or the like may be used as the transparent substrate 1.

As a material for forming the anode 2, is preferably used a transparent material having a work function as high as, for example, at least 4 eV. In the present invention, the work function means the magnitude of minimum work required to take out an electron from a solid into a vacuum. As the anode 2, may be used, for example, an ITO (indium tin oxide) film, tin oxide (SnO₂) film, copper oxide (CuO) film or zinc oxide (ZnO) film.

The hole injecting and transporting layer 3 is provided for efficiently supplying a hole to the luminescent layer 4 and has a function of receiving the hole from the anode 2 and transporting it to the luminescent layer 4. As a material for forming the hole injecting and transporting layer 3, may preferably be used, for example, a charge injecting and transporting material such as poly(3,4-ethylenedioxy-thiophene)-polystyrenesulfonate. The thickness of the hole injecting and transporting layer 3 is, for example, 10 to 200 nm.

The luminescent layer 4 is a layer having a function of bonding an electron to a hole to emit the bond energy thereof as light. This luminescent layer 4 is formed by the above-described phosphorescent polymer. No particular limitation is imposed on the thickness of the luminescent layer 4. However, it is generally selected within a range of 5 to 200 nm.

The hole blocking layer 8 is a layer having a function of inhibiting the hole supplied to the luminescent layer 4 through the hole injecting and transporting layer 3 from penetrating into the electron injecting layer 5 to facilitate recombination of the hole with the electron in the luminescent layer 4, thereby improving luminous efficiency.

As a material for forming the hole blocking layer 8, may preferably be used, for example, 2,9-dimethyl-4,7-diphenyl-1,10-phenanthroline (bathocuproine: BCP) represented by the following formula (1) or 1,3,5-tri(phenyl-2-benzimidazolyl)benzene (TPBI) represented by the following formula (2).

The thickness of the hole blocking layer 8 is, for example, 10 to 30 nm.

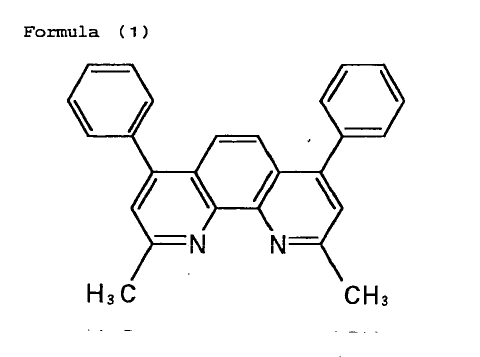

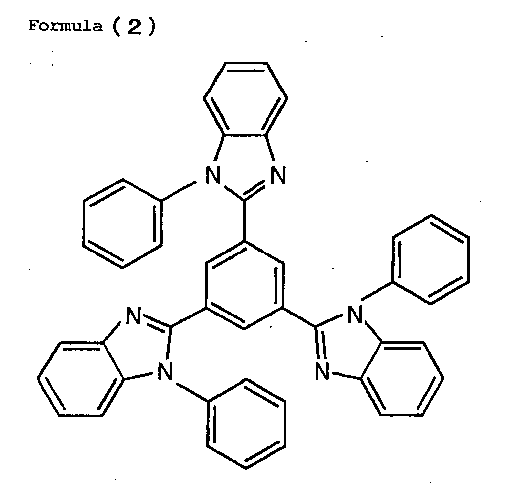

The electron injecting layer 5 is a layer having a function of transporting an electron received from the cathode 6 to the luminescent layer 4 through the hole blocking layer 8. As a material for forming the electron injecting layer 5, is preferably used a co-deposition system (BPCs) of a bathophenanthroline based material and cesium. As other materials, may be used alkali metals and their compounds (for example, lithium fluoride and lithium oxide), alkaline earth metals and their compounds (for example, magnesium fluoride and strontium fluoride), and the like. The thickness of the electron injecting layer 5 is, for example, 0.1 to 100 nm.

As a material for forming the cathode 6, is used a material having a work function as low as, for example, at most 4 eV. Specific examples of the cathode 6 include films composed of a metal such as aluminum, calcium, magnesium or indium and films composed of an alloy of these metals.

The thickness of the cathode 6 varies according to the kind of the material used. However, it is generally 10 to 1,000 nm, preferably 50 to 200 nm.

In the present invention, the above-described organic EL device is produced, for example, in the following manner.

The anode 2 is first formed on the transparent substrate 1.

As a method for forming the anode 2, may be used a vacuum deposition method, sputtering method or the like. Alternatively, a commercially available material that a transparent conductive film, for example, an ITO film, has been formed on the surface of a transparent substrate such as a glass substrate may also be used.

The hole injecting and transporting layer 3 is formed on the anode 2 formed in such a manner.

As a specific method for forming the hole injecting and transporting layer 3, may be used a method in which a charge injecting and transporting material is dissolved in a proper solvent, thereby preparing a solution for forming the hole injecting and transporting layer, this hole injecting and transporting layer-forming solution is applied to the surface of the anode 2, and the resultant coating film is subjected to a treatment for removing the organic solvent, thereby forming the hole injecting and transporting layer 3.

The polymer solution containing the phosphorescent polymer according to the present invention is used as a luminescent layer-forming solution and this luminescent layer-forming solution is applied on to the hole injecting and transporting layer 3. The resultant coating film is heat-treated, thereby forming the luminescent layer 4.

As a method for applying the luminescent layer-forming solution, may be used a spin coating method, dipping method, ink-jet method or printing method.

The hole blocking layer 8 is then formed on the luminescent layer 4 formed in such a manner, the electron injecting layer 5 is formed on this hole blocking layer 8, and the cathode 6 is further formed on the electron injecting layer 5, thereby obtaining the organic EL device having the construction illustrated in Fig. 1.

In the above-described process, as a method for forming the hole blocking layer 8, electron injecting layer 5 and cathode 6, may be used a dry method such as a vacuum deposition method.

In the above-described organic EL device, when DC voltage is applied between the anode 2 and the cathode 6 by the DC power source 7, the luminescent layer 4 emits light. This light is emitted to the outside through the hole injecting and transporting layer 3, anode 2 and transparent substrate 1.

According to the organic EL device of such construction, high luminous luminance is achieved because the luminescent layer 4 is formed by the above-described phosphorescent polymer.

In addition, the hole blocking layer 8 is provided, whereby combination of a hole injected from the anode 2 with an electron injected from the cathode 6 in the luminescent layer 4 is realized with high efficiency. As a result, high luminous luminance and luminous efficiency are achieved.

The present invention will hereinafter be described by the following Examples. However, the present invention is not limited to these examples.

### Example 1:

In this Example 1, the specific carbazole compound was prepared.

### [Synthesis of raw carbazole compound (A)]

A system with 3.3 g (20 mmol) of 3,6-dibromocarbazole and 2.8 g (20 mmol) of potassium carbonate dissolved in 50 ml of dimethyl sulfoxide was heated to 50°C and stirred for 30 minutes. Thereafter, 12 ml (100 mmol) of dibromobutane was added dropwise to this system, and the resultant mixture was then stirred for 24 hours. Ethyl acetate was then added to the resultant reaction slurry, and the slurry was washed with water and saturated brine. Thereafter, the resultant organic layer was dried over anhydrous magnesium sulfate, and the solvent was distilled off under reduced pressure.

The crude product thus obtained was purified by column chromatography, thereby obtaining 6.9 g (15 mmol) of N-bromobutyldibromocarbazole (hereinafter also referred to as "raw carbazole compound (1)") represented by the structural formula (2) as a raw carbazole compound (A).

### [Synthesis of raw pyridine compound (A)]

After a system with 10 g (38.9 mmol) of bromotetrahydropyranyloxybenzene dissolved in 80 ml of tetrahydrofuran was cooled to -78°C by means of an acetone-dry ice bath, 26 ml of n-butyllithium (1.6 M hexane solution) was added dropwise to this system, and the resultant mixture was then stirred for 2 hours. After 5 ml (44.6 mmol) of trimethoxyborane was then added dropwise, the temperature of the system was raised to room temperature by removing the acetone-dry ice bath, and the mixture was then stirred for 8 hours. The resultant reaction mixture was washed with water, and the resultant organic layer was dried over anhydrous magnesium sulfate, and the solvent was distilled off under reduced pressure, thereby obtaining 6.9 g (28 mmol) of an intermediate reaction product (1).

A system with 6.9 g (28 mmol) of the intermediate reaction product (1) thus obtained, 3.9 ml (40 mmol) of 2-bromopyridine and 2.3 g (2.16 mmol) of tetrakis-(triphenylphosphine)palladium(0) dissolved in a mixed solvent of 160 ml of toluene and 80 ml of a 2N aqueous solution of sodium carbonate was heated to 110°C and stirred for 30 hours. The system was then subjected to an extraction treatment with toluene. The resultant toluene solution was dried over anhydrous magnesium sulfate, and the solvent was distilled off under reduced pressure.

The crude product thus obtained was purified by column chromatography, thereby obtaining 5.1 g (20 mmol) of an intermediate reaction product (2).

A system obtained by dissolving 5.1 g (20 mmol) of the intermediate reaction product (2) thus obtained in 50 ml of a 75% aqueous solution of ethanol and adding 1 ml of concentrated hydrochloric acid to the solution, was heated under reflux for 6 hours, and ethanol was then distilled off under reduced pressure. The resultant reaction mixture was subjected to an extraction treatment with ether and an aqueous solution of potassium hydroxide, and an organic layer was removed. After the system of a water layer thus obtained was neutralized by adding an aqueous solution of sodium carbonate, the system was subjected to an extraction treatment with chloroform. The resultant organic layer was dried over anhydrous magnesium sulfate, and the solvent was distilled off under reduced pressure, thereby obtaining 3.2 g (18.7 mmol) of phenol-pyridine (hereinafter also referred to as "raw pyridine compound (1)") represented by the above structural formula (3) as a raw pyridine compound (A).

### [First reaction step (A)]

A system with 4.6 g (10 mmol) of the raw carbazole compound (1) and 1.7 g (10 mmol) of the raw pyridine compound (1) obtained in the above-described manner, and 6.9 g (50 mmol) of potassium carbonate dissolved in 100 ml of dimethyl sulfoxide was heated to 80°C and stirred for 12 hours. This system was then subjected to an extraction treatment with chloroform, and the resultant chloroform solution was washed with water and saturated brine. The resultant organic layer was then dried over anhydrous magnesium sulfate, and the solvent was distilled off under reduced pressure.

The resultant crude product was purified by column chromatography, thereby obtaining 3.0 g (5.45 mmol) of an intermediate reaction product (A) (hereinafter also referred to as "intermediate reaction product (3)") represented by the above structural formula (4).

### [Second reaction step (A)]

A system with 1.1 g (2 mmol) of the intermediate reaction product (3) and 1.3 g (2.2 mmol) of bis(2-phenylpyridine)iridium acetylacetonate represented by the structural formula (5) dissolved in 5 ml of glycerol was heated to 200°C and stirred for 3 hours. Thereafter, this system was cooled to room temperature and subjected to an extraction treatment with chloroform. The resultant chloroform solution was washed with saturated brine. The organic layer was dried over anhydrous magnesium sulfate, and the solvent was distilled off under reduced pressure.

The resultant crude product was purified by column chromatography, thereby obtaining 1.0 g of a final reaction product.

The chemical structure of the final reaction product thus obtained was analyzed by time of flight mass spectrometry. As a result, the final reaction product was identified as the specific carbazole compound represented by the structural formula (1).

### Example 2:

In this Example 2, the first spirofluorene compound was prepared.

### [Synthesis of raw pyridine compound (B-1)]

After a system with 24.5 g (155 mmol) of 2-bromopyridine dissolved in 400 ml of dehydrated diethyl ether was cooled to -78°C by means of an acetone-dry ice bath, 97 ml of n-butyllithium (1.6 M hexane solution) was added dropwise to this system, and the resultant mixture was then stirred for 30 minutes. After 32.2 g (310 mmol) of trimethoxyborane was then added dropwise, the temperature of the system was raised to room temperature by removing the acetone-dry ice bath, and the mixture was then stirred for 24 hours. The resultant reaction mixture was washed with water, and the resultant organic layer was dried over anhydrous magnesium sulfate, and the solvent was distilled off under reduced pressure, thereby obtaining an intermediate reaction product (4).

A system with the whole amount (155 mmol) of the intermediate reaction product (4) thus obtained, 146.3 g (620 mmol) of dibromobenzene and 5 g (4.3 mmol) of tetrakis(triphenylphosphine)palladium dissolved in a mixed solvent of 600 ml of toluene and 300 ml of a 2N aqueous solution of sodium carbonate was heated to 90°C and stirred for 30 hours. After consumption of the raw materials was confirmed, 1N hydrochloric acid was added dropwise to terminate the reaction. Thereafter, the system was subjected to an extraction treatment with toluene. The resultant toluene solution was dried over anhydrous magnesium sulfate, and the solvent was distilled off under reduced pressure.

The crude product thus obtained was purified by column chromatography, thereby obtaining 25 g (107 mmol) of bromophenylpyridine.

A system with 7.0 g (30 mmol) of bromophenylpyridine thus obtained, 8.8 g (35 mmol) of 3,4-dimethoxyphenylboronic acid and 1.0 g (0.9 mmol) of tetrakis(triphenylphosphine)palladium(0) dissolved in a mixed solvent of 100 ml of toluene and 50 ml of a 2N aqueous solution of sodium carbonate was heated to 110°C and stirred for 24 hours. This system was then cooled to room temperature, subjected to an extraction treatment with toluene and water, and the resultant toluene solution was dried over anhydrous magnesium sulfate. The solvent was distilled off under reduced pressure, and the resultant crude product was purified by column chromatography, thereby obtaining 5.7 g an intermediate reaction product (5).

After 0.9 ml (18 mmol) of bromine was added dropwise at room temperature to a system with 5.0 g (17.1 mmol) of the intermediate reaction product (5) and 0.5 g (3 mmol) of iron(III) chloride dissolved in 50 ml of chloroform, the resultant mixture was stirred for 6 hours. An aqueous solution of sodium thiosulfate was then added dropwise to this system, and the system was subjected to an extraction treatment with chloroform and water. The resultant reaction mixture was washed 3 times with water and dried over anhydrous magnesium sulfate, and the solvent was distilled off under reduced pressure.

The resultant crude product was purified by column chromatography, thereby obtaining 4.8 g (13 mmol) of a pyridine compound (hereinafter also referred to as "raw pyridine compound (2)") represented by the structural formula (7) as a raw pyridine compound (B-1).

### [First reaction step (B-1)]

### <Preliminary reaction treatment>

In 20 ml of ether, was immersed 1.8 g (68.6 mmol) of magnesium, and a minute amount of dibromoethane was added to initiate a Grignard reaction. A solution obtained by dissolving 4.5 g (12 mmol) of the raw pyridine compound (2) in 70 ml of ether was added dropwise to this system while suitably heating by a heat gun so as not to break off the Grignard reaction. The system was then heated under reflux for 3 hours to age the Grignard reaction mixture.

Under a nitrogen atmosphere, the Grignard reaction mixture cooled to room temperature was then added dropwise by cannulation to a solution obtained by dissolving 3.4 g (10 mmol) of 2,7-dibromofluorenon represented by the structural formula (8) in 50 ml of ether. After the resultant mixture was heated under reflux for 8 hours, the thus-treated Grignard reaction mixture was cooled to room temperature, an aqueous solution of ammonium chloride was added, and the resultant mixture was stirred for 30 minutes. Thereafter, an organic layer was extracted from the resultant reaction mixture, and this organic layer was washed with water and saturated brine in this order and dried over anhydrous magnesium sulfate. The solvent was distilled off under reduced pressure to obtain a solid intermediate reaction product (6).

### <Post reaction treatment>

To a system with the whole amount of the intermediate reaction product (7) dissolved in 200 ml of acetic acid, was added 1 ml of concentrated hydrochloric acid, and the mixture was heated under reflux for 4 hours. The resultant reaction mixture was cooled to room temperature, and crystals deposited thereby were collected by filtration. Thereafter, the crystals were stirred for 12 hours in hexane to dissolve out impurities, thereby obtaining 2.7 g (4.4 mmol) of an intermediate reaction product (B-1) (hereinafter also referred to as "intermediate reaction product (7)") represented by the structural formula (9).

### [Second reaction step (B-1)]

A system with 2.0 g (3.3 mmol) of the intermediate reaction product (7) and 2.1 g (3.5 mmol) of bis(2-phenylpyridine)iridium acetylacetonate dissolved in 10 ml of glycerol was heated to 200°C and stirred for 3 hours. Thereafter, chloroform was added to the system cooled to room temperature, and the resultant chloroform solution was washed with saturated brine. The organic layer was then dried over anhydrous magnesium sulfate, and the solvent was distilled off under reduced pressure.

The resultant crude product was purified by column chromatography, thereby obtaining 1.6 g of a final reaction product.

The chemical structure of the final reaction product thus obtained was analyzed by time of flight mass spectrometry. As a result, the final reaction product was identified as the first spirofluorene compound represented by the structural formula (6).

### Example 3:

In this Example 3, the second spirofluorene compound was prepared.

### [Synthesis of raw pyridine compound (B-2)]

After a system with 15.4 g (100 mmol) of 2-bromopyridine, 27.6 g (110 mmol) of 3,4-dimethoxyphenylboronic acid and 5.0 g (4.3 mmol) of tetrakis(triphenylphosphine)-palladium (0) dissolved in a mixed solvent of 600 ml of toluene and 300 ml of a 2N aqueous solution of sodium carbonate was heated to 110°C and then stirred for 24 hours. The system was then subjected to an extraction treatment with toluene, the organic layer was dried over anhydrous magnesium sulfate, and the solvent was distilled off under reduced pressure. The resultant crude product was purified by column chromatography using chloroform as a developing solvent, thereby obtaining 14.9 g (69 mmol) of an intermediate reaction product (8).

At room temperature, 3.6 ml (70 mmol) of bromine was added dropwise to a system with 14.0 g (61 mmol) of the intermediate reaction product (8) and 1.0 g (6 mmol) of iron(III) chloride dissolved in 150 ml of chloroform, and the resultant mixture was stirred for 6 hours. An aqueous solution of sodium thiosulfate was then added dropwise to this system, and the system was subjected to an extraction treatment with chloroform. The resultant reaction mixture was fractionally washed 3 times with water and dried over anhydrous magnesium sulfate, and the solvent was distilled off under reduced pressure.

The resultant crude product was purified by column chromatography, thereby obtaining 13.5 g (46 mmol) of a pyridine compound (hereinafter also referred to as "raw pyridine compound (3)") represented by the structural formula (11) as a raw pyridine compound (B-2).

### [First reaction step (B-2)]

### <Preliminary reaction treatment>

In 50 ml of ether, was immersed 1.2 g (50 mmol) of magnesium, and a minute amount of dibromoethane was added to initiate a Grignard reaction. A solution obtained by dissolving 12.3 g (40 mmol) of the raw pyridine compound (3) in 50 ml of ether was added dropwise to this system while suitably heating by a heat gun so as not to break off the Grignard reaction. The system was then heated under reflux for 3 hours to age the Grignard reaction mixture.

Under a nitrogen atmosphere, the Grignard reaction mixture cooled to room temperature was then added dropwise by cannulation to a solution obtained by dissolving 12.8 g (38 mmol) of 2,7-dibromofluorenon represented by the structural formula (8) in 100 ml of ether. After the resultant mixture was heated under reflux for 8 hours, the thus-treated Grignard reaction mixture was cooled to room temperature, an aqueous solution of ammonium chloride was added, and the resultant mixture was stirred for 30 minutes. Thereafter, an organic layer was extracted from the resultant reaction mixture, and this organic layer was washed with water and saturated brine in this order and dried over anhydrous magnesium sulfate. The solvent was distilled off under reduced pressure to obtain a solid intermediate reaction product (9).

### <Post reaction treatment>

To a system with the whole amount of the intermediate reaction product (9) dissolved in 200 ml of acetic acid, was added 3 ml of concentrated hydrochloric acid, and the mixture was heated under reflux for 4 hours. The resultant reaction mixture was cooled to room temperature, and crystals deposited thereby were collected by filtration. Thereafter, the crystals were stirred for 12 hours in hexane to dissolve out impurities, thereby obtaining 8.6 g (16 mmol) of an intermediate reaction product (B-2) (hereinafter also referred to as "intermediate reaction product (10)") represented by the structural formula (12).

### [Second reaction step (B-2)]

A system with 0.6 g (1 mmol) of the intermediate reaction product (10) and 0.7 g (1.1 mmol) of bis(2-phenylpyridine)iridium acetylacetonate dissolved in 3 ml of glycerol was heated to 200°C and stirred for 3 hours. Thereafter, chloroform was added to the system cooled to room temperature, and the resultant chloroform solution was washed with saturated brine. The organic layer was then dried over anhydrous magnesium sulfate, and the solvent was distilled off under reduced pressure.

The resultant crude product was purified by column chromatography, thereby obtaining 0.5 g of a final reaction product.

The chemical structure of the final reaction product thus obtained was analyzed by time of flight mass spectrometry. As a result, the final reaction product was identified as the second spirofluorene compound represented by the structural formula (10).

### Example 4:

In this Example 4, the specific fluorene compound was prepared in accordance with the first production process.

### [Synthesis of raw pyridine compound (C-1)]

After a system with 24.5 g (155 mmol) of 2-bromopyridine dissolved in 400 ml of dehydrated diethyl ether was cooled to -78°C by means of an acetone-dry ice bath, 97 ml of n-butyllithium (1.6 M hexane solution) was added dropwise to this system, and the resultant mixture was then stirred for 30 minutes. After 32.2 g (310 mmol) of trimethoxyborane was then added dropwise, the temperature of the system was raised to room temperature by removing the acetone-dry ice bath, and the mixture was then stirred for 24 hours. The resultant reaction mixture was washed with water, and the resultant organic layer was dried over anhydrous magnesium sulfate, and the solvent was distilled off under reduced pressure, thereby obtaining an intermediate reaction product (11).

A system with the whole amount (155 mmol) of the intermediate reaction product (11) obtained above, 146.3 g (620 mmol) of dibromobenzene and 5 g (4.3 mmol) of tetrakis(triphenylphosphine)palladium dissolved in a mixed solvent of 600 ml of toluene and 300 ml of a 2N aqueous solution of sodium carbonate was heated to 90°C and stirred for 30 hours. After consumption of the raw materials was confirmed, 1N hydrochloric acid was added dropwise to terminate the reaction. Thereafter, the system was subjected to an extraction treatment with toluene. The resultant toluene solution was dried over anhydrous magnesium sulfate, and the solvent was distilled off under reduced pressure.

The crude product thus obtained was purified by column chromatography, thereby obtaining 25 g (107 mmol) of bromophenylpyridine (hereinafter also referred to as "raw pyridine compound (4)") as a raw pyridine compound (C-1).

### [First reaction step (C-1)]

### <Preliminary reaction treatment>

After a system with 20 g (85.4 mmol) of the resultant raw pyridine compound (4) dissolved in 150 ml of tetrahydrofuran was cooled to -78°C by means of an acetone-dry ice bath, 53.3 ml of n-butyllithium (1.6 M hexane solution) was added dropwise to this system, and the resultant mixture was then stirred for 60 minutes. After a solution with 15.5 g (42 mmol) of 4,4'-dibromobiphenyl carboxyl ethoxide methyl ester (JACS, 78, 3196 (1956)) as a raw diphenyl compound dissolved in 40 ml of tetrahydrofuran was then added dropwise, the temperature of the system was raised to room temperature by removing the acetone-dry ice bath, and the system was then stirred for 24 hours. The resultant reaction mixture was washed with water, the resultant organic layer was dried over anhydrous magnesium sulfate, and the solvent was distilled off under reduced pressure, thereby obtaining an intermediate reaction product (12).

### <Post reaction treatment>

The intermediate reaction product (12) obtained in the preliminary reaction treatment was mixed with 200 ml of acetic acid, to which 4 ml of sulfuric acid was added, and the resultant mixture was heated under reflux until white precipitate was formed.

The thus-obtained precipitate was collected by filtration and purified by column chromatography, thereby obtaining 20 g of an intermediate reaction product (C-1) (hereinafter also referred to as "intermediate reaction product (13)").

### [Second reaction step (C-1)]

A system with 2.0 g (3 mmol) of the intermediate reaction product (13) and 3.7 g (6.2 mmol) of bis(2-phenylpyridine)iridium acetylacetonate as a raw metal complex-containing compound dissolved in 50 ml of glycerol was heated to 200°C and stirred for 3 hours. Thereafter, chloroform was added to the system cooled to room temperature, and the resultant chloroform solution was washed with saturated brine. The organic layer was then dried over anhydrous magnesium sulfate, and the solvent was distilled off under reduced pressure.

The resultant crude product was purified by column chromatography, thereby obtaining 2.5 g of a final reaction product.

The final reaction product thus obtained was analyzed by time of flight mass spectrometry. As a result, the final reaction product was identified as the specific fluorene compound represented by the structural formula (13).

The first reaction step (C-1) and second reaction step (C-1) related to Example 4 are shown in the following reaction scheme (4).

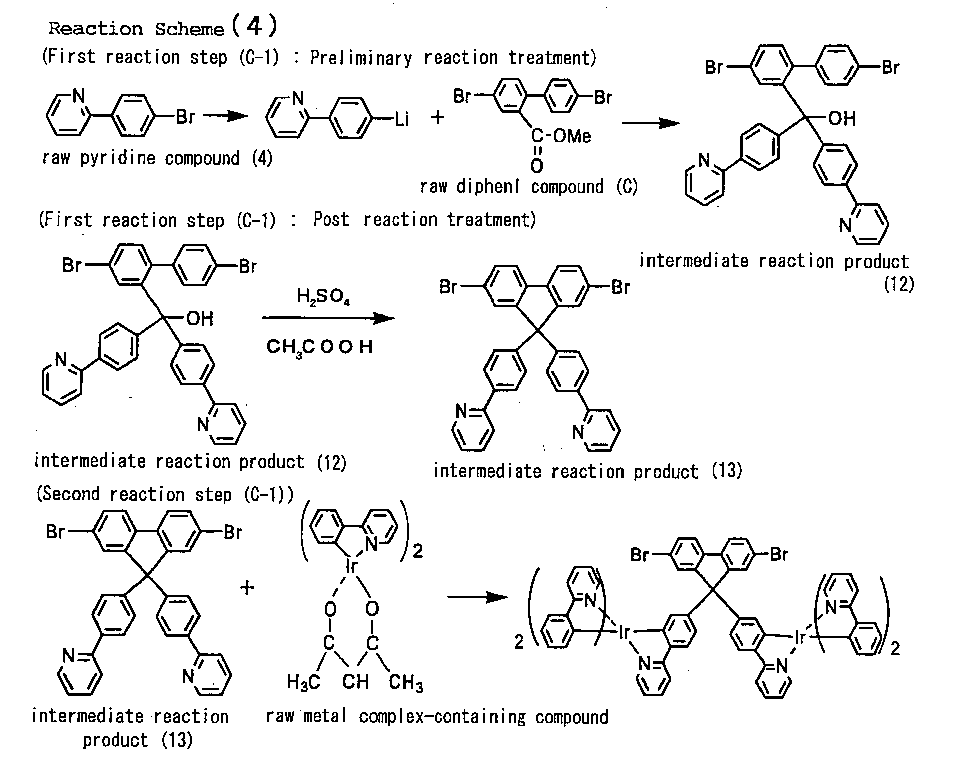

### Example 5:

In this Example 5, the specific fluorene compound was prepared in accordance with the second production process.

### [Synthesis of raw fluorene compound (C-2)]

After a system with 24.1 g (94.3 mmol) of 1,4-dibromobenzene dissolved in 150 ml of tetrahydrofuran was cooled to -78°C by means of an acetone-dry ice bath, 126 ml of n-butyllithium (1.5 M hexane solution) was added dropwise to this system, and the resultant mixture was then stirred for 1 hour. After a solution with 10 g (48 mmol) of methyl 2-phenylbenzoate dissolved in 50 ml of tetrahydrofuran was added dropwise, the temperature of the system was raised to room temperature by removing the acetone-dry ice bath, and the mixture was then stirred for 12 hours. The resultant reaction mixture was washed with saturated brine, the resultant organic layer was dried over anhydrous magnesium sulfate, and the solvent was distilled off under reduced pressure. The resultant product was added into 100 g of polyphosphoric acid, this system was heated to 80°C, and the heating was continued until white precipitate was formed. Ether was then added to the system to conduct an extraction treatment, the resultant organic layer was dried over anhydrous magnesium sulfate, and the solvent was distilled off under reduced pressure. The resultant crude product was purified by column chromatography, thereby obtaining 20 g of a fluorene derivative precursor.

After a system with 9.5 g (20 mmol) of the fluorene derivative precursor dissolved in 200 ml of tetrahydrofuran (THF) was cooled to -78°C by means of an acetone-dry ice bath, 26.2 ml of n-butyllithium (1.6 M hexane solution) was added dropwise to this system, and the resultant mixture was then stirred for 2 hours. After 11.2 g (60 mmol) of 2-isopropoxy-4,4,5,5-tetramethyl-1,3,2-dioxaborolane was then added dropwise, the temperature of the system was raised to room temperature by removing the acetone-dry ice bath, and the mixture was then stirred for 24 hours. The resultant reaction mixture was washed with water, and the resultant organic layer was dried over anhydrous magnesium sulfate, and the solvent was distilled off under reduced pressure. The resultant solid product was purified by recrystallization with methanol to obtain 8.5 g of a compound (hereinafter also referred to as "raw fluorene compound (1)") represented by the general formula (4-4), in which n3, n4, q2 and q3 are 0, and X¹⁰ is an ester of boronic acid, as a raw fluorene compound (C-2).

### [First reaction step (C-2)]

A system with 2.8 g (5 mmol) of the raw fluorene compound (1), 2.6 g (11 mmol) of the raw pyridine compound (4) obtained as the raw pyridine compound (C-2) in Example 4 and 0.2 g (0.15 mmol) of tetrakis (triphenylphosphine) - palladium (0) dissolved in a mixed solvent of 15 ml of toluene and 7.5 ml of a 2N aqueous solution of sodium carbonate was heated to 90°C and stirred for 24 hours. After consumption of the raw materials was confirmed, 1N hydrochloric acid was added dropwise to terminate the reaction. The resultant reaction mixture was subjected to an extraction treatment with toluene, the resultant organic layer was dried over anhydrous magnesium sulfate, and the solvent was distilled off under reduced pressure.

The resultant crude product was purified by column chromatography, thereby obtaining 2.0 g of a first intermediate reaction product (C-2) (hereinafter also referred to as "intermediate reaction product (14)").

### [Second reaction step (C-2)]

At room temperature, 0.4 ml (7.2 mmol) of bromine as a halogen was added dropwise to a system with 2.0 g (3.3 mmol) of the intermediate reaction product (14) and 0.05 g (0.3 mmol) of iron(III) chloride dissolved in 5 ml of chloroform. Thereafter, the system was stirred for 8 hours, and an aqueous solution of sodium thiosulfate was then added dropwise to this system. The resultant reaction mixture was washed 3 times with water, the resultant organic layer was dried over anhydrous magnesium sulfate, and the solvent was distilled off under reduced pressure.

The resultant crude product was purified by column chromatography, thereby obtaining 2.2 g of a second intermediate reaction product (C-2) (hereinafter also referred to as "intermediate reaction product (15)").

### [Third reaction step (C-2)]

A reaction treatment and purification of the resulting crude product were conducted in the same manner as in the second reaction step (C-1) of Example 4 except that a system with 2.0 g (2.6 mmol) of the intermediate reaction product (15) and 3.4 g (5.6 mmol) of bis(2-phenylpyridine)iridium acetylacetonate as a raw metal complex-containing compound dissolved in 50 ml of glycerol was used, thereby obtaining 1.5 g of a final reaction product.

The final reaction product thus obtained was analyzed by time of flight mass spectrometry. As a result, the final reaction product was identified as the specific fluorene compound represented by the structural formula (14).

The first reaction step (C-2) to third reaction step (C-2) related to Example 5 are shown in the following reaction scheme (5).

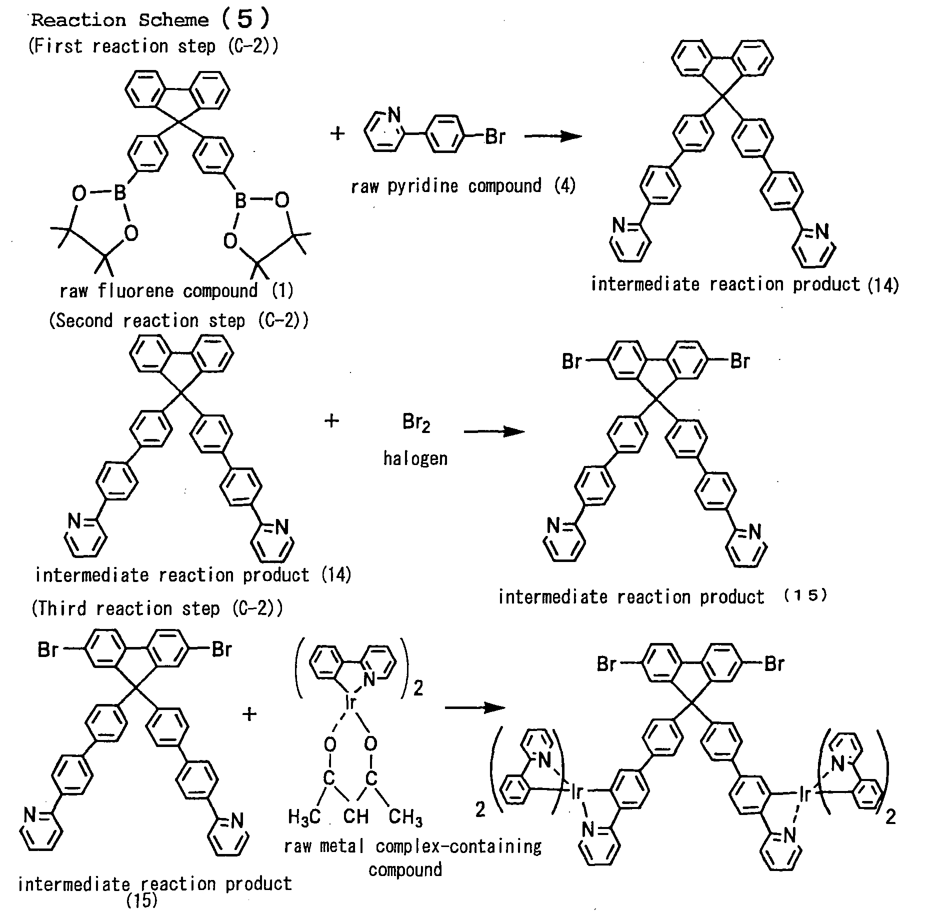

### Example 6:

In this Example 6, the specific fluorene compound was prepared in accordance with the third production process.

### [First reaction step (C-3)]

After a system with 2.3 g (10 mmol) of the raw pyridine compound (4) as the raw pyridine compound (C-1) obtained in Example 4 dissolved in 20 ml of tetrahydrofuran was cooled to -78°C by means of an acetone-dry ice bath, 6.8 ml of n-butyllithium (1.6 M hexane solution) was added dropwise to this system, and the resultant mixture was then stirred for 60 minutes. After a solution with 3.4 g (10 mmol) of 2,7-dibromofluorenone as a raw fluorenone compound (C-3) dissolved in 5 ml of tetrahydrofuran was then added dropwise, the temperature of the system was raised to room temperature by removing the acetone-dry ice bath, and the system was then stirred for 24 hours. Chloroform was added to the resultant reaction mixture, the resultant chloroform solution was washed with water, and the organic layer was dried over anhydrous magnesium sulfate, and the solvent was distilled off under reduced pressure.

The resultant crude product was purified by column chromatography, thereby obtaining 3.6 g of a first intermediate reaction product (C-3) (hereinafter also referred to as "intermediate reaction product (16)").

### [Second reaction step (C-3)]

To a system with 3.5 g (7.1 mmol) of the intermediate reaction product (16) dissolved in 50 ml of toluene as a benzene derivative (C), was added 2 ml of sulfuric acid, and the resultant mixture was heated under reflux until white precipitate was formed.

The thus-obtained precipitate was collected by filtration and purified by column chromatography using chloroform as a developing solvent, thereby obtaining 2.9 g of a second intermediate reaction product (C-3) (hereinafter also referred to as "intermediate reaction product (17)").

### [Third reaction step (C-2)]

A reaction treatment and purification of the resulting crude product were conducted in the same manner as in the second reaction step (C-1) of Example 4 except that a system with 3.0 g (6.3 mmol) of the intermediate reaction product (17) and 3.9 g (6.5 mmol) of bis (2-phenylpyridine)iridium acetylacetonate as a raw metal complex-containing compound dissolved in 65 ml of glycerol was used, thereby obtaining 2.7 g of a final reaction product.

The final reaction product thus obtained was analyzed by time of flight mass spectrometry. As a result, the final reaction product was identified as the specific fluorene compound represented by the structural formula (15).

The first reaction step (C-3) to third reaction step (C-3) related to Example 6 are shown in the following reaction scheme (6).

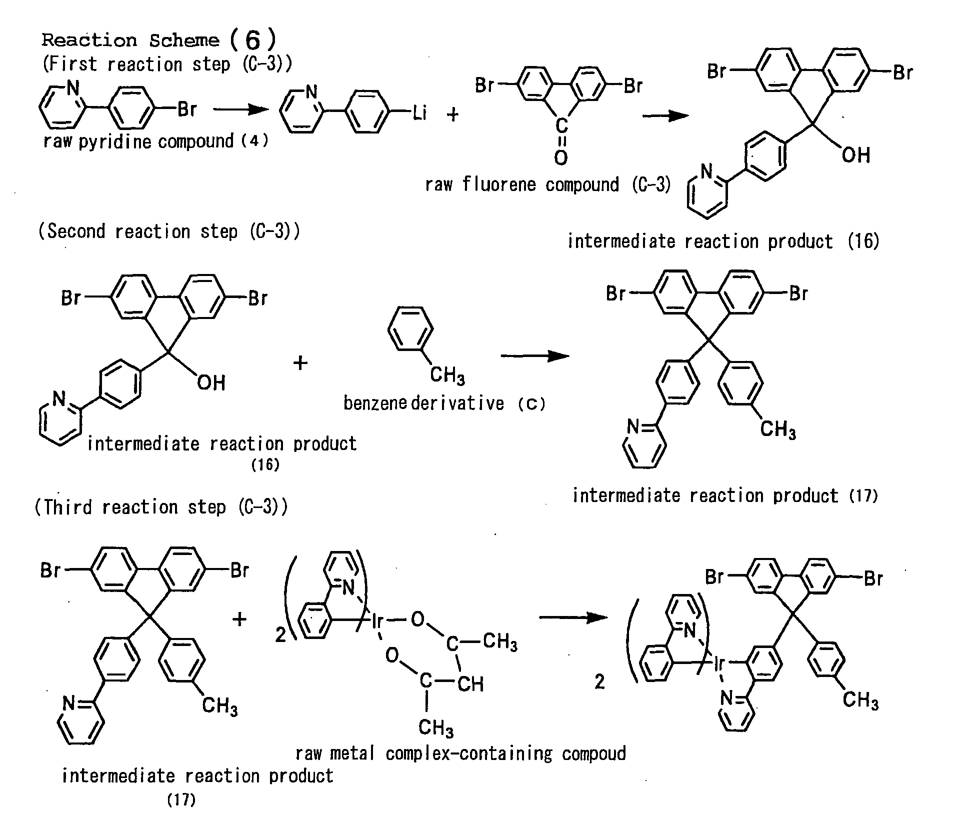

### Example 7:

In this Example 7, the specific fluorene compound was prepared in accordance with the fourth production process.

### [Synthesis of raw pyridine compound (C-4)]

After a system with 10 g (38.9 mmol) of bromotetrahydropyranyloxybenzene dissolved in 80 ml of tetrahydrofuran was cooled to -78°C by means of an acetone-dry ice bath, 26 ml of n-butyllithium (1.6 M hexane solution) was added dropwise to this system, and the resultant mixture was then stirred for 2 hours. After 5 ml (44.6 mmol) of trimethoxyborane was then added dropwise, the temperature of the system was raised to room temperature by removing the acetone-dry ice bath, and the mixture was then stirred for 8 hours. The resultant reaction mixture was washed with water, and the resultant organic layer was dried over anhydrous magnesium sulfate, and the solvent was distilled off under reduced pressure, thereby obtaining 6.9 g of an intermediate reaction product (18) .

A system with 6.9 g (28 mmol) of the intermediate reaction product (18), 3.9 ml (40 mmol) of 2-bromopyridine and 2.3 g (2.16 mmol) of tetrakis(triphenylphosphine)-palladium (0) dissolved in a mixed solvent of 160 ml of toluene and 80 ml of a 2N aqueous solution of Na₂CO₃ was heated to 110°C and stirred for 30 hours. Thereafter, the system was subjected to an extraction treatment with toluene, the resultant organic layer was dried over anhydrous magnesium sulfate, and the solvent was distilled off under reduced pressure.

The crude product thus obtained was purified by column chromatography, thereby obtaining 5.1 g of an intermediate reaction product (19).

To a system 5.1 g of the intermediate reaction product (19) dissolved in 50 ml of a 75% aqueous solution of ethanol, was added 1 ml of concentrated hydrochloric acid, and the system was heated under reflux for 6 hours. Ethanol was then distilled off under reduced pressure, and ether and an aqueous solution of potassium hydroxide were added to the residual solution to conduct an extraction treatment, thereby removing an organic layer. The pH of the resultant aqueous layer was then acidified by adding hydrochloric acid, and ether was added to conduct an additional extraction treatment. An organic layer was removed, the pH of the resultant aqueous layer was neutralized by adding an aqueous solution of sodium carbonate, and chloroform was added to conduct a further extraction treatment. The resultant organic layer was dried over anhydrous magnesium sulfate, and the solvent was distilled off under reduced pressure, thereby obtaining 3.2 g of phenol-pyridine (hereinafter also referred to as "raw pyridine compound (5)") as a raw pyridine compound (C-4).

### [First reaction step (C-4)]

A solution with 19.3 g of dibromobutane as a raw dihalogen compound (C) dissolved in 30 ml of dimethyl sulfoxide was added dropwise to a system with 3.0 g (17.5 mmol) of the raw pyridine compound (5), 0.01 g of potassium iodide and 6.9 g (50 mmol) of potassium carbonate dissolved in 50 ml of dimethyl sulfoxide, and the system was heated to 50 °C and stirred for 12 hours. Thereafter, 5 ml of water was added to the resultant reaction mixture to terminate the reaction, and the reaction mixture was subjected to an extraction treatment with chloroform. The resultant chloroform solution was washed 3 times with water, the organic layer was dried over anhydrous magnesium sulfate, and the solvent was distilled off under reduced pressure, thereby obtaining 3.7 g of a first intermediate reaction product (C-4) (hereinafter also referred to as "intermediate reaction product (20)").

### [Second reaction step (C-4)]

A system with 3.1 g (10 mmol) of the intermediate reaction product (20), 1.5 g (4.5 mmol) of 2,7-dibromofluorene as a raw fluorenone compound (C-4) and 10 g (72 mmol) of potassium carbonate dissolved in 50 ml of dimethyl sulfoxide was heated to 80°C and stirred for 12 hours. The resultant reaction mixture was cooled to room temperature and subjected to an extraction process by adding chloroform and water. The reaction mixture was washed with water and saturated brine in this order and the organic layer was dried over anhydrous magnesium sulfate, and the solvent was distilled off under reduced pressure.

The thus-obtained crude product was purified by column chromatography, thereby obtaining 4.3 g of a second intermediate reaction product (C-4) (hereinafter also referred to as "intermediate reaction product (21)").

### [Third reaction step (C-4)]

A reaction treatment and purification of the resulting crude product were conducted in the same manner as in the second reaction step (C-1) of Example 4 except that a system with 1.0 g (1.3 mmol) of the intermediate reaction product (21) and 1.5 g (2.6 mmol) of bis(2-phenylpyridine)iridium acetylacetonate as a raw metal complex-containing compound dissolved in 5 ml of glycerol was used, thereby obtaining 2.7 g of a final reaction product.

The final reaction product thus obtained was analyzed by time of flight mass spectrometry. As a result, the final reaction product was identified as the specific fluorene compound represented by the structural formula (16).

The first reaction step (C-4) to third reaction step (C-4) related to Example 7 are shown in the following reaction scheme (7).

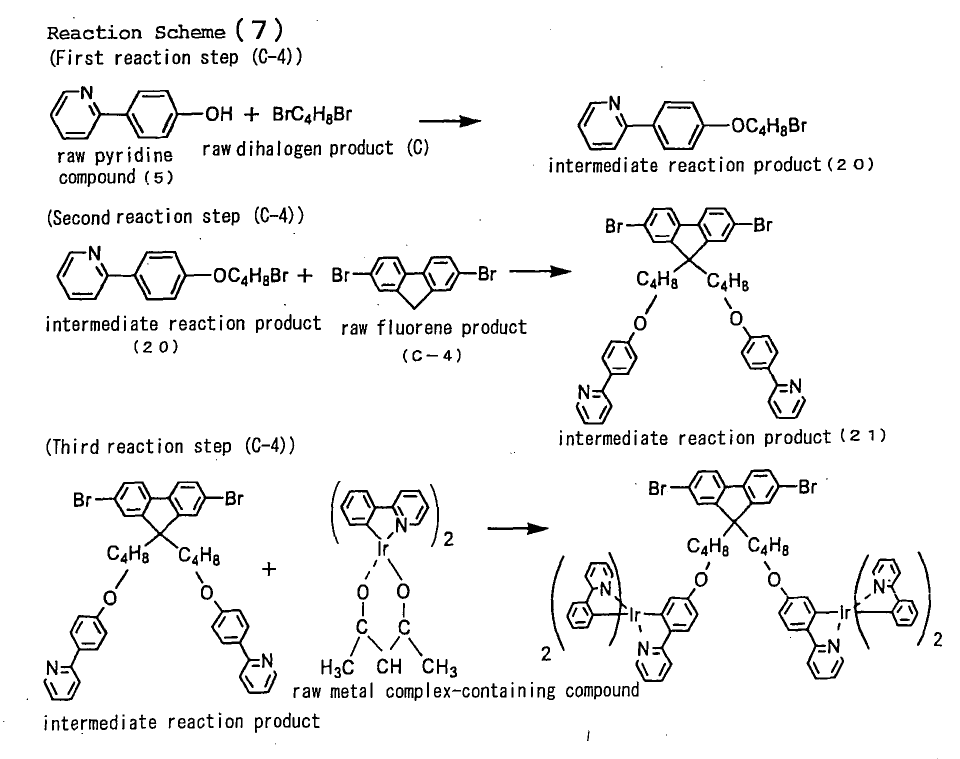

### Example 8:

In this Example 8, the specific fluorene compound was prepared in accordance with the fifth production process.

### [First reaction step (C-5)]

A solution with 54 ml (448 mmol) of dibromobutane as a raw dihalogen compound (C) dissolved in 100 ml of dimethyl sulfoxide was added dropwise to a system with 17.4 g (100 mmol) of 2-bromo-3-hydroxypyridine as a raw pyridine compound (C-5) , 0.82 g (5 mmol) of potassium iodide and 41.4 g (300 mmol) of potassium carbonate dissolved in 200 ml of dimethyl sulfoxide, and the resultant mixture was stirred at 50°C for 24 hours. After consumption of the raw materials was confirmed, the reaction mixture was subjected to an extraction treatment by adding chloroform and water. The resultant organic layer was washed with saturated brine, and dried over anhydrous magnesium sulfate, and the solvent was distilled off under reduced pressure.

The resultant crude product was purified by column chromatography, thereby obtaining 26.0 g of a first intermediate reaction product (C-5) (hereinafter also referred to as "intermediate reaction product (22)").

### [Second reaction step (C-5)]

A system with 26 g (84 mmol) of the intermediate reaction product (22), 15.2 g (126 mmol) of phenylboronic acid as a raw benzene compound (C) and 2.9 g (2.51 mmol) of tetrakis(triphenylphosphine)palladium(0) dissolved in a mixed solvent of 100 ml of toluene and 50 ml of a 2N aqueous solution of sodium carbonate was heated to 110°C and stirred for 48 hours. The resultant reaction mixture was cooled to room temperature and subjected to an extraction treatment by adding toluene and water. The resultant organic layer was dried over anhydrous magnesium sulfate, and the solvent was distilled off under reduced pressure.

The thus-obtained crude product was purified by column chromatography using chloroform as a developing solvent, thereby obtaining 4.1 g of a second intermediate reaction product (C-5) (hereinafter also referred to as "intermediate reaction product (23)").

### [Third reaction step (C-5)]

To a system with 3.2 g (10 mmol) of 2,7-dibromofluorene as a raw fluorene compound (C-4) and 4.5 g (20 mmol) of triethylbenzylammonium chloride dissolved in 20 ml of dimethyl sulfoxide, was added dropwise 10 ml of a 50% aqueous solution of sodium hydroxide. Thereafter, a solution obtained by dissolving 4.1 g (13 mmol) of the intermediate reaction product (23) in 20 ml of dimethyl sulfoxide was added dropwise to this system, and the resultant mixture was stirred at 50°C for 24 hours. The resultant reaction mixture was cooled to room temperature and subjected to an extraction treatment by adding chloroform and water. The resultant organic layer was washed with saturated brine and dried over anhydrous magnesium sulfate, and the solvent was distilled off under reduced pressure.

The thus-obtained crude product was purified by column chromatography, thereby obtaining 6.7 g of a third intermediate reaction product (C-5) (hereinafter also referred to as "intermediate reaction product (24)").

### [Fourth reaction step (C-5)]

A reaction treatment and purification of the resulting crude product were conducted in the same manner as in the second reaction step (C-1) of Example 4 except that a system with 7.0 g (9 mmol) of the intermediate reaction product (24) and 12.0 g (20 mmol) of bis(2-phenylpyridine)iridium acetylacetonate as a raw metal complex-containing compound dissolved in 150 ml of glycerol was used, thereby obtaining 4.0 g of a final reaction product.

The final reaction product thus obtained was analyzed by time of flight mass spectrometry. As a result, the final reaction product was identified as the specific fluorene compound represented by the structural formula (17).

The first reaction step (C-5) to fourth reaction step (C-5) related to Example 8 are shown in the following reaction scheme (8).

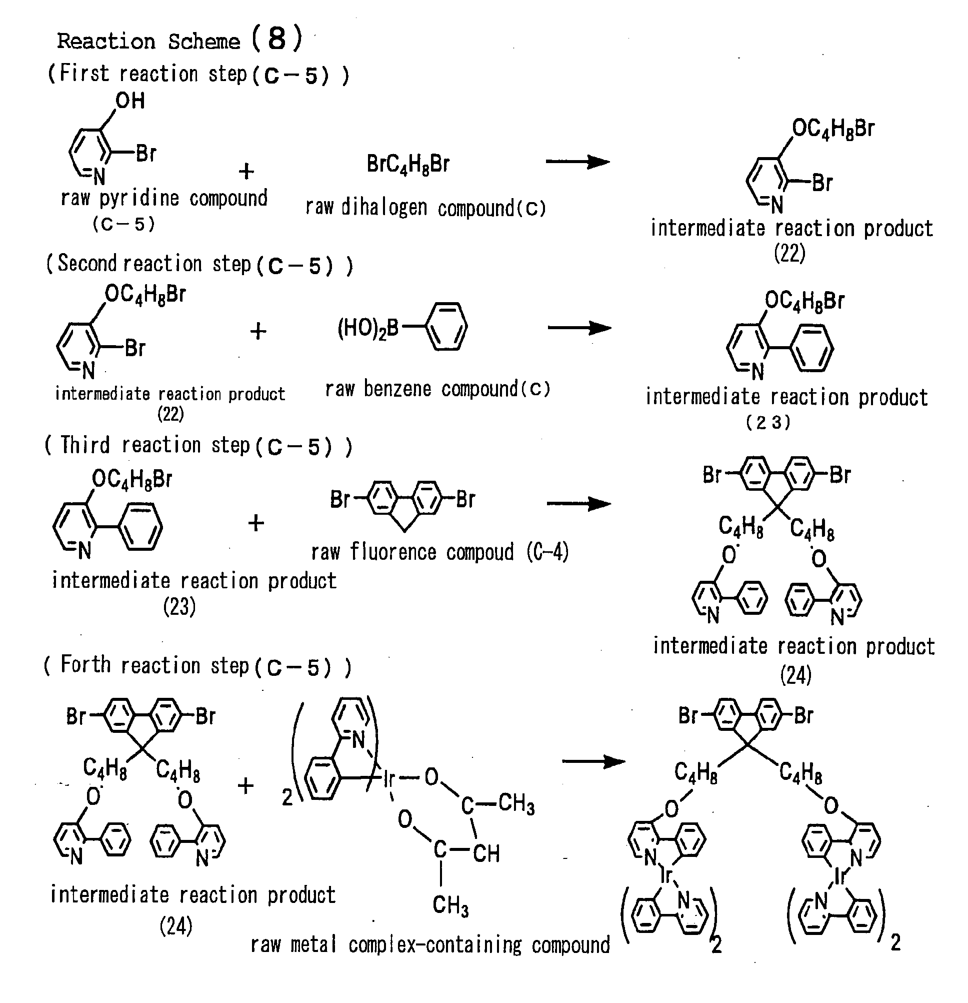

### Example 9:

### [Synthesis Example of phosphorescent polymer]

In a mixed solvent of 2 ml of toluene and 1 ml of a 2N aqueous solution of sodium carbonate, were dissolved 0.02 g (0.01 mmol) of the specific fluorene compound obtained in Example 7, 0.04 g (0.2 mmol) of 4,4'-bis-(4,4,5,5-tetramethyl-1,3,2-dioxaborolan-2-yl)phenyl ether, 0.06 g (0.19 mmol) of 4,4-bromodiphenyl ether as a halogen phenyl ether compound and 0.007 g (0.006 mmol) of tetrakis-(triphenylphosphine)palladium(0). The resultant solution was heated to 110°C, thereby conducting a polymerization treatment over 25 hours. Thereafter, 0.06 g (0.5 mmol) of phenylboronic acid was added to this reaction system at the same temperature to conduct a reaction for 4 hours. Then, 0.16 g (1 mmol) of bromobenzene was added to conduct an additional reaction for 4 hours, thereby substituting the terminals of a polymer formed.

The resultant reaction mixture was fractionally washed with 1N hydrochloric acid and an aqueous solution of dimethylamine in this order, and the resultant organic layer was dried over anhydrous magnesium sulfate. After the organic solvent was then distilled off under reduced pressure, a reprecipitation treatment was conducted with acetone, thereby obtaining 0.13 g of a polymer (hereinafter also referred to as "polymer (A)").

By NMR analysis, the resultant polymer (A) was identified as a polymer that contains a specific structural unit represented by the general formula (E), in which R²⁴ is a butylene group, L is bidentate phenylpyridine, and each oxygen atom is bonded to a 4-position of the benzene ring, the content of said specific structural unit being 2.5 mol%, and has phenyl groups at both terminals thereof.

The polymer (A) was also identified as that having a weight average molecular weight (Mw) of 11,000 in terms of polystyrene as measured by gel permeation chromatography.

### [Fabrication Example of organic EL device]

An organic EL device having a luminescent layer formed by the polymer (A) was fabricated in accordance with the construction illustrated in Fig. 1.

More specifically, a glass-made transparent substrate, in which a transparent conductive film composed of ITO had been formed on its surface, was provided, and this substrate was subjected to ultrasonic cleaning by using a neutral detergent, ultrapure water, isopropyl alcohol, ultrapure water and acetone in that order and then subjected to additional cleaning by irradiating it with ultraviolet light in an ozone atmosphere.

A solution of poly(3,4-ethylenedioxythiophene)-polystyrenesulfonate (PEDOT/PSS) was applied on to the transparent conductive film of this substrate by a spin coating method, and the resultant coating film having a thickness of 65 nm was then dried at 250°C for 30 minutes under a nitrogen atmosphere, thereby forming a hole injecting and transporting layer.

A cyclohexanone solution (concentration: 3 % by mass) of the polymer (A) was then applied to the surface of the hole injecting and transporting layer thus obtained by a spin coating method, and the resultant coating film having a thickness of 40 nm was dried at 120°C for 10 minutes under a nitrogen atmosphere, thereby forming a luminescent layer.

Bathocuproine was vapor-deposited in a thickness of 30 nm on the surface of the luminescent layer within a vacuum device reduced to a pressure of 1 x 10⁻⁴ Pa or lower to form a hole blocking layer. Lithium fluoride was vapor-deposited in a thickness of 0.5 nm thereon to form an electron injecting layer, on which calcium and aluminum were then vapor-deposited in thicknesses of 30 nm and 100 nm, respectively, thereby forming a cathode. Thereafter, sealing was conducted with a glass material, thereby fabricating an organic EL device (A1).

With respect to the organic EL device (A1) thus obtained, the luminescent properties were confirmed. As a result, light emission was achieved only in the vicinity of 515 nm that is a wavelength derived from the iridium complex component of the specific structural unit.

An organic EL device (A2) was additionally fabricated in the same manner as in the fabrication process of the organic EL device (A1) except that the drying temperature upon the formation of the luminescent layer in the fabrication process of the organic EL device (A1) was changed from 120°C to 160°C, and the luminescent properties of this organic EL device (A2) were confirmed. As a result, luminous luminance equivalent to the organic EL device (A1) was achieved.

From this result, it was confirmed that the polymer (A) related to the luminescent layers of the organic EL device (A1) and organic EL device (A2) has high thermal stability compared with a composition related to luminescent layers of a comparative organic EL device (1) and a comparative organic EL device (2), which will be described subsequently, whereby excellent durability is achieved in organic EL devices having a luminescent layer composed of the polymer (A).

### Example 10:

### [Synthesis Example of phosphorescent polymer]

In a mixed solvent of 6 ml of toluene and 3 ml of a 2N aqueous solution of sodium carbonate, were dissolved 0.09 g (0.05 mmol) of the specific fluorene compound obtained in Example 7, 0.64 g (1 mmol) of 9,9'-dioctyl-2,7-bis(4,4,5,5-tetramethyl-1,3,2-dioxaborolan-2-yl)fluorene, 0.52 g (0.95 mmol) of 9,9'-dioctyl-2,7-dibromofluorene and 0.03 g (0.03 mmol) of tetrakis(triphenylphosphine)-palladium (0). The resultant solution was heated to 110°C, thereby conducting a polymerization treatment over 25 hours. Thereafter, 0.06 g (0.5 mmol) of phenylboronic acid was added to this reaction system at the same temperature to conduct a reaction for 4 hours. Then, 0.16 g (1 mmol) of bromobenzene was added to conduct an additional reaction for 4 hours, thereby substituting the terminals of a polymer formed.

The resultant reaction mixture was fractionally washed with 1N hydrochloric acid and an aqueous solution of dimethylamine in this order, and the resultant organic layer was dried over anhydrous magnesium sulfate. After the organic solvent was then distilled off under reduced pressure, a reprecipitation treatment was conducted with acetone, thereby obtaining 0.25 g of a polymer (hereinafter also referred to as "polymer (B)").

By NMR analysis, the resultant polymer (B) was identified as a polymer that contains a specific structural unit represented by the general formula (F), in which R²⁴ is a butylene group, both R² and R³ are octyl groups, L is bidentate phenylpyridine, and each oxygen atom is bonded to a 4-position of the benzene ring, the content of said specific structural unit being 2.5 mol%, and has phenyl groups at both terminals thereof.

The polymer (B) was also identified as that having a weight average molecular weight (Mw) of 22,000 in terms of standard polystyrene equivalent as measured by gel permeation chromatography.

### [Fabrication Example of organic EL device]

An organic EL device (B1) was fabricated in the same manner as in Fabrication Example of organic EL device in Example 9 except that the polymer (B) was used in place of the polymer (A) in Example 9, and the luminescent properties of this organic EL device (B1) were confirmed. As a result, light emission was achieved only in the vicinity of 515 nm that is a wavelength derived from the iridium complex component of the specific structural unit.

An organic EL device (B2) was additionally fabricated in the same manner as in the fabrication process of the organic EL device (B1) except that the drying temperature upon the formation of the luminescent layer in the fabrication process of the organic EL device (B1) was changed from 120°C to 160°C, and the luminescent properties of this organic EL device (B2) were confirmed. As a result, luminous luminance equivalent to the organic EL device (B1) was achieved.

From this result, it was confirmed that the polymer (B) related to the luminescent layers of the organic EL device (B1) and organic EL device (B2) has high thermal stability compared with a composition related to luminescent layers of a comparative organic EL device (1) and a comparative organic EL device (2), which will be described subsequently, whereby excellent durability is achieved in organic EL devices having a luminescent layer composed of the polymer (B).

### Example 11:

### [Synthesis Example of phosphorescent polymer]

In 10 ml of mesitylene, were dissolved 0.087 g (0.05 mmol) of the specific fluorene compound obtained in Example 7, 0.620 g (1 mmol) of a compound represented by the general formula (8), in which a is 0, b is 1, and R²⁸ bonded to a 5-position of the benzene ring is a methyl group, 0.31 g (0.95 mmol) of 4,4'-dibromodiphenyl ether, 0.03 g (0.03 mmol) of tris(dibenzylideneacetone) dipalladium (Pd₂(dba)₃) and 0.05 g (0.09 mmol) of diphenylphosphino-ferrocene as catalysts, and 0.29 g (3 mmol) of sodium t-butoxide as a base. The resultant solution was heated to 140°C, thereby conducting a polymerization treatment over 35 hours. Thereafter, 0.08 g (0.5 mmol) of diphenylamine was added to this reaction system at the same temperature to conduct a reaction for 4 hours. Then, 0.16 g (1 mmol) of bromobenzene was added to conduct an additional reaction for 4 hours, thereby substituting the terminals of a polymer formed.

An aqueous solution of ethylenediamine was added to the resultant reaction mixture, separatory extraction was conducted with chloroform, and the resultant organic layer was dried over anhydrous magnesium sulfate. After the organic solvent was then distilled off under reduced pressure, a reprecipitation treatment was conducted with acetone, thereby obtaining 0.21 g of a polymer (hereinafter also referred to as "polymer (C)").

By NMR analysis, the resultant polymer (C) was identified as a polymer that contains a specific structural unit represented by the general formula (G), in which R²⁴ is a butylene group, a is 0, b is 0, R²⁸ bonded to a 5-position of the benzene ring is a methyl group, L is bidentate phenylpyridine, and each oxygen atom is bonded to a 4-position of the benzene ring, the content of said specific structural unit being 2.5 mol%, and has a structure that a terminal related to a structural unit, to which the repetition number e3 is affixed, is a phenyl groups, and a terminal related to a structural unit, to which the repetition number f3 is affixed, is a diphenylamino group.

The polymer (C) was also identified as having a weight average molecular weight (Mw) of 16,000 in terms of standard polystyrene equivalent as measured by gel permeation chromatography.

### [Fabrication Example of organic EL device]

An organic EL device (C1) was fabricated in the same manner as in Fabrication Example of organic EL device in Example 9 except that the polymer (C) was used in place of the polymer (A) in Example 9, and the luminescent properties of this organic EL device (C1) were confirmed. As a result, light emission was achieved only in the vicinity of 515 nm that is a wavelength derived from the iridium complex component of the specific structural unit.

An organic EL device (C2) was additionally fabricated in the same manner as in the fabrication process of the organic EL device (C1) except that the drying temperature upon the formation of the luminescent layer in the fabrication process of the organic EL device (C1) was changed from 120°C to 160°C, and the luminescent properties of this organic EL device (C2) were confirmed. As a result, luminous luminance equivalent to the organic EL device (C1) was achieved.

From this result, it was confirmed that the polymer (C) related to the luminescent layers of the organic EL device (C1) and organic EL device (C2) has high thermal stability compared with a composition related to luminescent layers of a comparative organic EL device (1) and a comparative organic EL device (2), which will be described subsequently, whereby excellent durability is achieved in organic EL devices having a luminescent layer composed of the polymer (C).

### Comparative Example 1:

A comparative organic EL device (1) was fabricated in the same manner as in Example 9 except that a cyclohexanone solution (concentration: 3 % by mass) of a composition comprising polyvinylcarbazole (PVK) and 2-(4-t-butylphenyl)-1,3,4-oxadiazole (PBD) in a molar ratio of 8:2 and containing an iridium complex compound Ir (ppy)₃ in a proportion of 1 mol% was used in place of the cyclohexanone solution of the polymer (A) in Example 9, and the luminescent properties of this comparative organic EL device (1) were confirmed. As a result, light emission derived from the iridium complex compound Ir (ppy)₃ was attained.

A comparative organic EL device (2) was additionally fabricated in the same manner as in the fabrication process of the comparative organic EL device (1) except that the drying temperature upon the formation of the luminescent layer in the fabrication process of the comparative organic EL device (1) was changed from 120°C to 160°C, and the luminescent properties of this comparative organic EL device (2) were confirmed. As a result, the luminous luminance thereof was reduced by 40% compared with the comparative organic EL device (1).

The invention provides a phosphorescent polymer that has excellent luminescent properties and capable of forming a film by a wet method, and an organic electroluminescence device that has excellent luminescent properties and durability, can achieve long service life and can be easily produced. The invention also provides a novel metal complex-containing compound used as a monomer for providing the phosphorescent polymer that has excellent luminescent properties and capable of forming a film by a wet method, and a production process thereof.

The phosphorescent polymer has a metal complex-containing group having a phenylpyridine structure which is bonded to a main chain containing an aromatic compound group. The organic electroluminescence device has a luminescent layer formed by the phosphorescent polymer. The metal complex-containing compound has a metal complex-containing group having a phenylpyridine structure which is bonded to an aromatic compound having two reactive functional groups.

## Claims

1. A phosphorescent polymer in which a metal complex-containing group having a phenylpyridine structure is bonded to a main chain containing an aromatic compound group.

2. The phosphorescent polymer according to claim 1, which comprises a metal complex-containing structural unit represented by any one of the following general formula (A) to general formula (D): 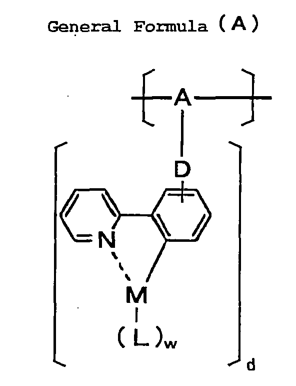 wherein A is an aromatic compound group, D is a single bond, oxygen atom, phenylene group, alkylene group or alkoxylene group, M is a divalent to tetravalent metal atom, L is an organic ligand, w is an integer of 1 to 3, and d is 1 or 2; 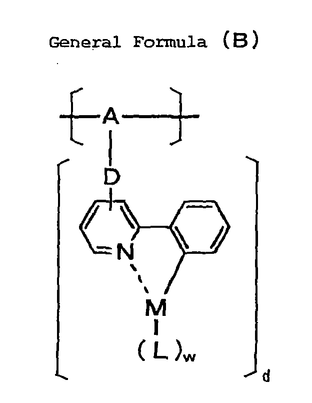 wherein A is an aromatic compound group, D is a single bond, oxygen atom, phenylene group, alkylene group or alkoxylene group, M is a divalent to tetravalent metal atom, L is an organic ligand, w is an integer of 1 to 3, and d is 1 or 2; 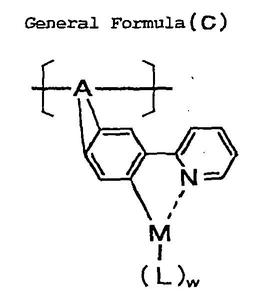 wherein A is an aromatic compound group, M is a divalent to tetravalent metal atom, L is an organic ligand, and w is an integer of 1 to 3; and 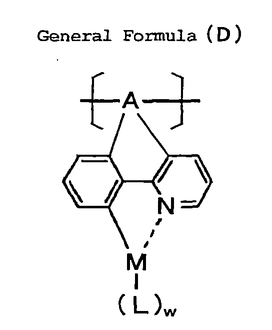 wherein A is an aromatic compound group, M is a divalent to tetravalent metal atom, L is an organic ligand, and w is an integer of 1 to 3.

3. The phosphorescent polymer according to claim 2, wherein a proportion of the metal complex-containing structural unit contained is 0.1 to 10 mol%.

4. The phosphorescent polymer according to any one of claims 1 to 3, which has at least one skeleton of a carbazole skeleton, a fluorene skeleton and a diphenyl ether skeleton in its molecule.

5. The phosphorescent polymer according to any one of claims 2 to 4, wherein the group A in the metal complex-containing structural unit is an aromatic compound group having at least one skeleton of a carbazole skeleton and a fluorene skeleton.

6. A process for producing the phosphorescent polymer according to any one of claims 1 to 5, which comprises a step of reacting a metal complex-containing compound having 2 reactive functional groups with an aromatic compound having 2 reactive functional groups in the presence of a catalyst.

7. An organic electroluminescence device comprising a luminescent layer formed by the phosphorescent polymer according to any one of claims 1 to 5.

8. The organic electroluminescence device according to claim 7, which comprises a hole blocking layer.

9. A metal complex-containing compound in which a metal complex-containing group having a phenylpyridine structure is bonded to an aromatic compound having 2 reactive functional groups.

10. The metal complex-containing compound according to claim 9, which is composed of a carbazole compound represented by the following general formula (1): 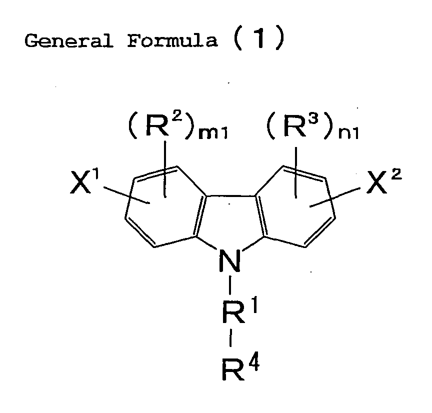 wherein X¹ and X² are, independently of each other, a reactive functional group and may be the same or different from each other, R¹ is a divalent organic group, R² and R³ are, independently of each other, a monovalent organic group and may be the same or different from each other, R⁴ is a group having a structure represented by the following general formula (1-1) or general formula (1-2), m1 is an integer of 0 to 3, and n1 is an integer of 0 to 3: 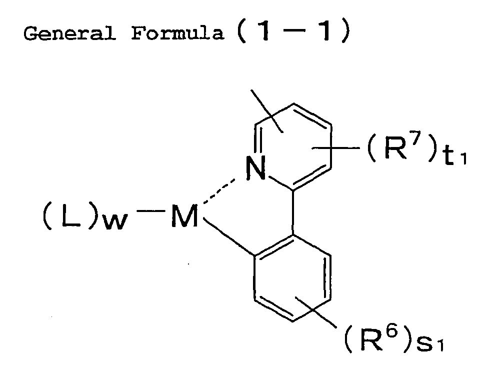 in which R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, s1 is an integer of 0 to 4, t1 is an integer of 0 to 3, and w is an integer of 1 to 3; and 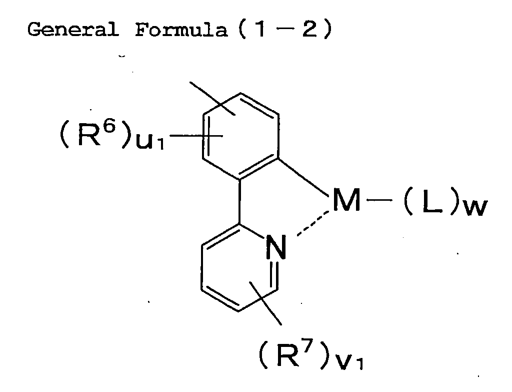 in which R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, u1 is an integer of 0 to 3, v1 is an integer of 0 to 4, and w is an integer of 1 to 3.

11. A process for producing the metal complex-containing compound according to claim 10, which comprises steps of reacting a compound represented by the following general formula (1-3) with a compound represented by the following general formula (1-4) or general formula (1-5) to obtain an intermediate reaction product, and reacting this intermediate reaction product with a compound represented by the following general formula (1-6): 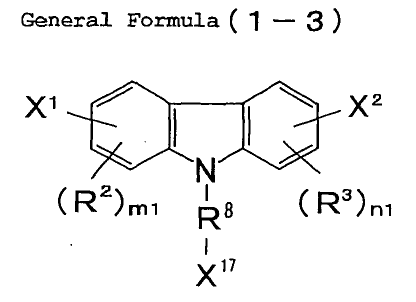 wherein X¹ and X² are, independently of each other, a reactive functional group and may be the same or different from each other, R² and R³ are, independently of each other, a monovalent organic group and may be the same or different from each other, m1 is an integer of 0 to 3, n1 is an integer of 0 to 3, X¹⁷ is a halogen atom, and R⁸ is a divalent organic group; 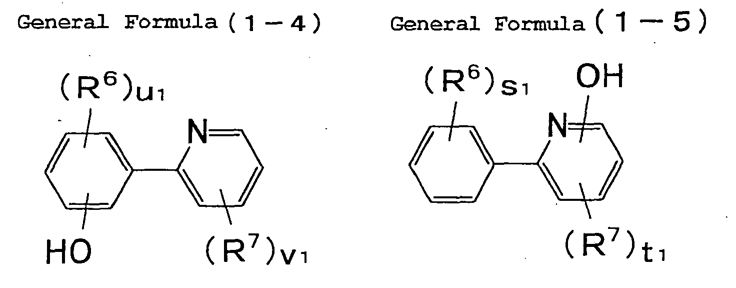 wherein R⁶ and R⁷ are, independently of each other, a fluorine atom, alkyl group or aryl group and may be the same or different from each other, with the proviso that these groups may be substituted or form a cyclic structure, s1 is an integer of 0 to 4, t1 is an integer of 0 to 3, u1 is an integer of 0 to 3, and v1 is an integer of 0 to 4; and 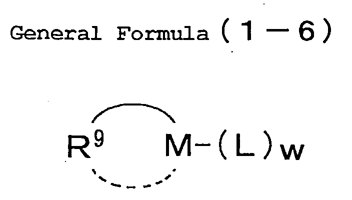 wherein R⁹ is a bidentate chelate ligand having 2 coordinating atoms, M is a divalent to tetravalent metal atom, L is an organic ligand, and w is an integer of 1 to 3.

12. The metal complex-containing compound according to claim 9, which is composed of a spirofluorene compound represented by the following general formula (2): 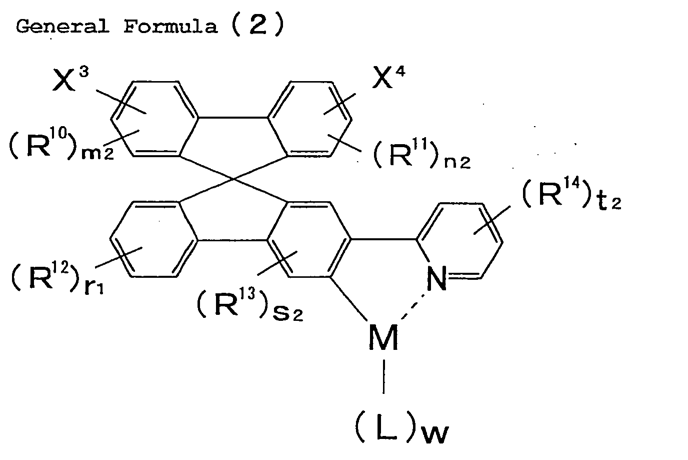 wherein X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹³ and R¹⁹ are, independently of each other, a fluorine atom, alkyl group or aryl group and may be the same or different from each other, with the proviso that these groups may be substituted or form a cyclic structure, M is a divalent to tetravalent metal atom, L is an organic ligand, m2 is an integer of 0 to 3, n2 is an integer of 0 to 3, r1 is an integer of 0 to 4, s2 is an integer of 0 to 2, t2 is an integer of 0 to 4, and w is an integer of 1 to 3.

13. A process for producing the metal complex-containing compound according to claim 12, which comprises steps of reacting a compound represented by the following general formula (2-1) with a compound represented by the following general formula (2-2) to obtain an intermediate reaction product, and reacting this intermediate reaction product with a compound represented by the following general formula (1-6): 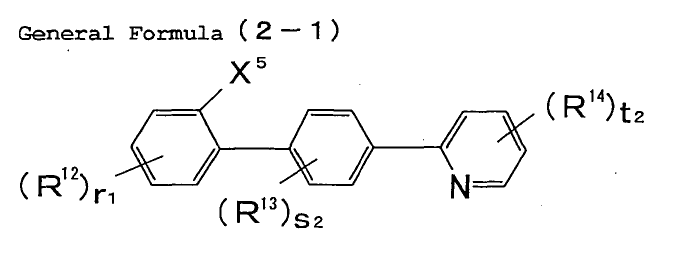 wherein X⁵ is a halogen atom, R¹² is a monovalent organic group, R¹³ and R¹⁴ are, independently of each other, a fluorine atom, alkyl group or aryl group and may be the same or different from each other, with the proviso that these groups may be substituted or form a cyclic structure, r1 is an integer of 0 to 4, s2 is an integer of 0 to 2, and t2 is an integer of 0 to 4; 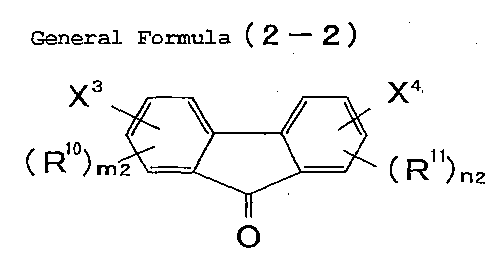 wherein X³ and X⁴ are, independently of each other, a reactive functional group and may be the same or different from each other, R¹⁰ and R¹¹ are, independently of each other, a monovalent organic group and may be the same or different from each other, m2 is an integer of 0 to 3, and n2 is an integer of 0 to 3; and
General formula (1-6) 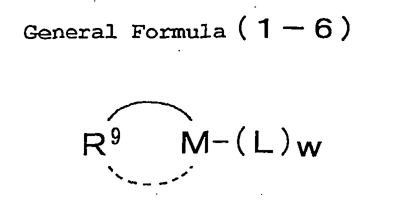 wherein R⁹ is a bidentate chelate ligand having 2 coordinating atoms, M is a divalent to tetravalent metal atom, L is an organic ligand, and w is an integer of 1 to 3.

14. The metal complex-containing compound according to claim 9, which is composed of a spirofluorene compound represented by the following general formula (3): 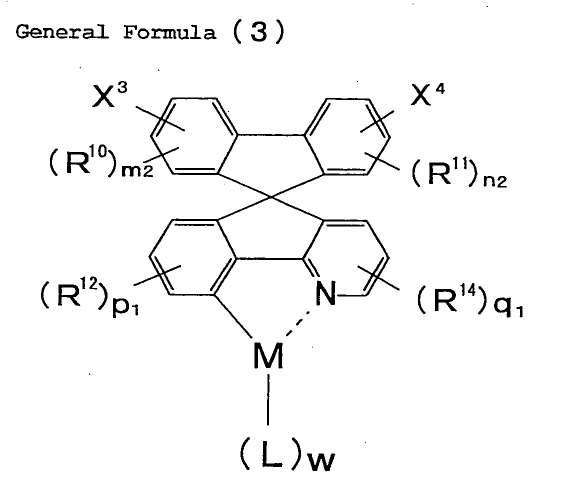 wherein X³ and X⁴ are, independently of each other, a reactive functional group and may be the same or different from each other, R¹⁰ and R¹¹ are, independently of each other, a monovalent organic group and may be the same or different from each other, R¹² is a monovalent organic group, R¹⁴ is a fluorine atom, alkyl group or aryl group, with the proviso that the group may be substituted or form a cyclic structure, M is a divalent to tetravalent metal atom, L is an organic ligand, m2 is an integer of 0 to 3, n2 is an integer of 0 to 3, p1 is an integer of 0 to 3, q1 is an integer of 0 to 3, and w is an integer of 1 to 3.

15. A process for producing the metal complex-containing compound according to claim 14, which comprises steps of reacting a compound represented by the following general formula (3-1) with a compound represented by the following general formula (2-2) to obtain an intermediate reaction product, and reacting this intermediate reaction product with a compound represented by the following general formula (1-6): 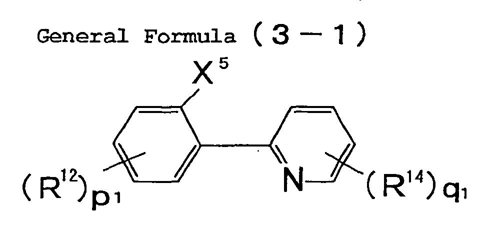 wherein X⁵ is a halogen atom, R¹² is a monovalent organic group, R¹⁴ is a fluorine atom, alkyl group or aryl group, with the proviso that the group may be substituted or form a cyclic structure, p1 is an integer of 0 to 3, and q1 is an integer of 0 to 3; 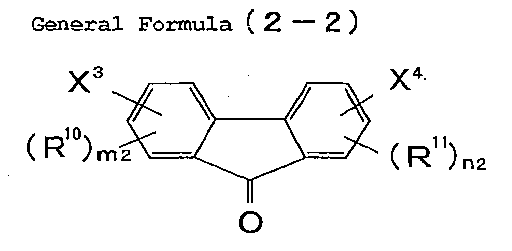 wherein X³ and X⁴ are, independently of each other, a reactive functional group and may be the same or different from each other, R¹⁰ and R¹¹ are, independently of each other, a monovalent organic group and may be the same or different from each other, m2 is an integer of 0 to 3, and n2 is an integer of 0 to 3; and 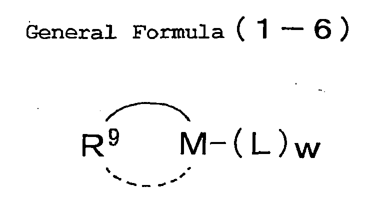 wherein R⁹ is a bidentate chelate ligand having 2 coordinating atoms, M is a divalent to tetravalent metal atom, L is an organic ligand, and w is an integer of 1 to 3

16. The metal complex-containing compound according to claim 9, which is composed of a fluorene compound represented by the following general formula (4): 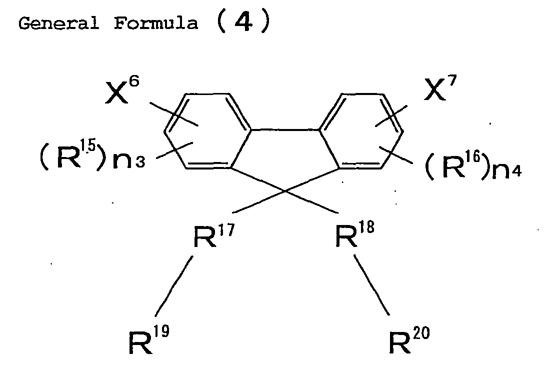 wherein X⁶ and X⁷ are, independently of each other, a halogenic functional group and may be the same or different from each other, R¹⁵ and R¹⁶ are, independently of each other, a monovalent organic group and may be the same or different from each other, R¹⁷ and R¹⁸ are single bonds or divalent organic groups and may be the same or different from each other, at least one of R¹⁹ and R²⁰ is a group having a structure represented by the following general formula (1-1) or general formula (1-2) and the other is a monovalent organic group or a group having a structure represented by the following general formula (1-1) or general formula (1-2), and R¹⁹ and R²⁰ may be the same or different from each other, n3 is an integer of 0 to 3, and n4 is an integer of 0 to 3: 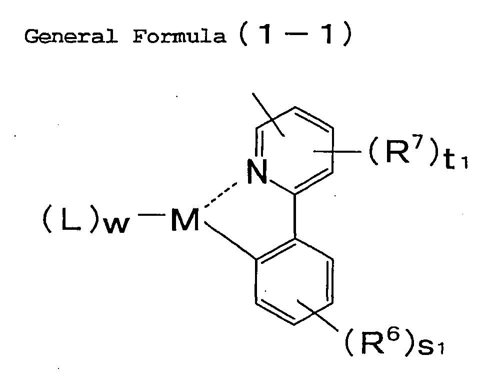 wherein R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, s1 is an integer of 0 to 4, t1 is an integer of 0 to 3, and w is an integer of 1 to 3; and 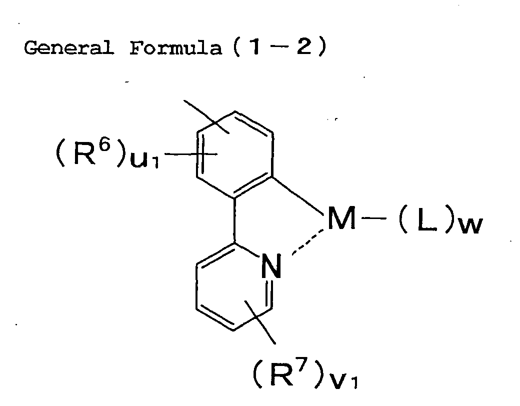 wherein R⁶ and R⁷ are, independently of each other, a fluorine atom, alkyl group or aryl group and may be the same or different from each other, with the proviso that these groups may be substituted or form a cyclic structure, M is a divalent to tetravalent metal atom, L is an organic ligand, u1 is an integer of 0 to 3, v1 is an integer of 0 to 4, and w is an integer of 1 to 3.

17. A process for producing the metal complex-containing compound according to claim 16, which comprises steps of reacting a compound represented by the following general formula (4-1) with a compound represented by the following general formula (4-2) to obtain an intermediate reaction product, and reacting this intermediate reaction product with a compound represented by the following general formula (1-6): 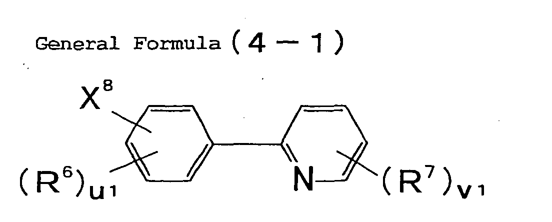 wherein X⁸ is a halogen atom, R⁶ and R⁷ are, independently of each other, a fluorine atom, alkyl group or aryl group and may be the same or different from each other, with the proviso that these groups may be substituted or form a cyclic structure, u1 is an integer of 0 to 3, and v1 is an integer of 0 to 4; 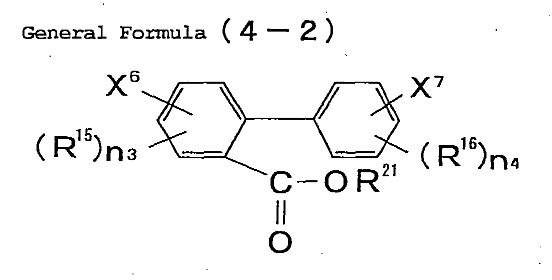 wherein X⁶ and X⁷ are, independently of each other, a halogenic functional group and may be the same or different from each other, R¹⁵ and R¹⁶ are, independently of each other, a monovalent organic group and may be the same or different from each other, R²¹ is a monovalent organic group, n3 is an integer of 0 to 3, and n4 is an integer of 0 to 3; and 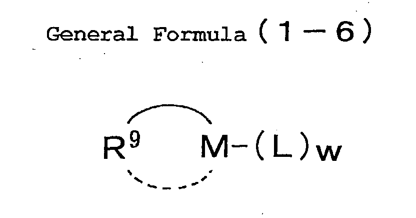 wherein R⁹ is a bidentate chelate ligand having 2 coordinating atoms, M is a divalent to tetravalent metal atom, L is an organic ligand, and w is an integer of 1 to 3

18. A process for producing the metal complex-containing compound according to claim 16, which comprises steps of reacting a compound represented by the following general formula (4-3) with a compound represented by the following general formula (4-4) to obtain a first intermediate reaction product, reacting this first intermediate reaction product with a halogen to obtain a second intermediate reaction product, and reacting this second intermediate reaction product with a compound represented by the following general formula (1-6): 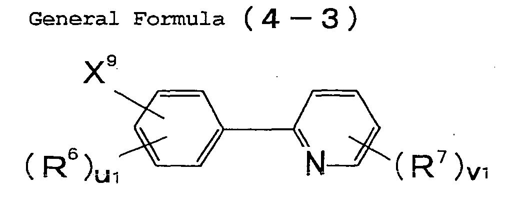 wherein R⁶ and R⁷ are, independently of each other, a fluorine atom, alkyl group or aryl group and may be the same or different from each other, with the proviso that these groups may be substituted or form a cyclic structure, X⁹ is a halogenic functional group or boron derivative functional group, u1 is an integer of 0 to 3, and v1 is an integer of 0 to 4; 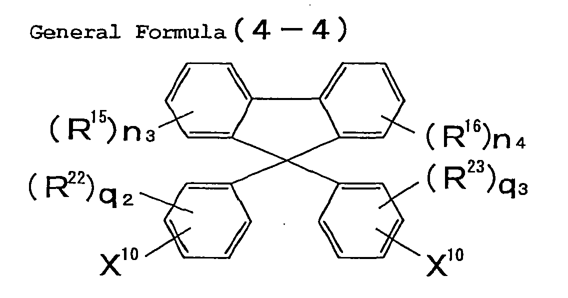 wherein X¹⁰ is a halogenic functional group or boron derivative functional group and is different from X⁹ in the above general formula (4-3) , R¹⁵ and R¹⁶ are, independently of each other, a monovalent organic group and may be the same or different from each other, R²² and R²³ are, independently of each other, a monovalent organic group and may be the same or different from each other, n3 is an integer of 0 to 3, n4 is an integer of 0 to 3, q2 is an integer of 0 to 4, and q3 is an integer of 0 to 4; and 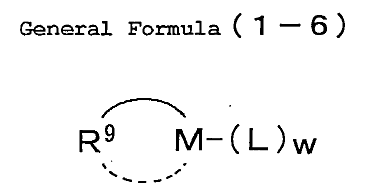 wherein R⁹ is a bidentate chelate ligand having 2 coordinating atoms, M is a divalent to tetravalent metal atom, L is an organic ligand, and w is an integer of 1 to 3.

19. A process for producing the metal complex-containing compound according to claim 16, which comprises steps of reacting a compound represented by the following general formula (4-1) with a compound represented by the following general formula (4-5) to obtain a first intermediate reaction product, reacting this first intermediate reaction product with a benzene derivative having 1 to 5 substituent groups each composed of a monovalent organic group to obtain a second intermediate reaction product, and reacting this second intermediate reaction product with a compound represented by the following general formula (1-6): 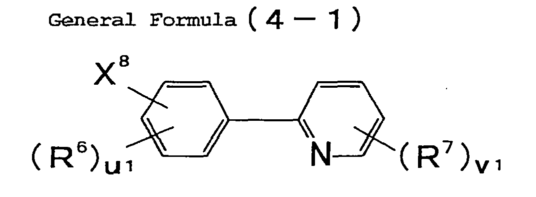 wherein X⁸ is a halogen atom, R⁶ and R⁷ are, independently of each other, a fluorine atom, alkyl group or aryl group and may be the same or different from each other, with the proviso that these groups may be substituted or form a cyclic structure, u1 is an integer of 0 to 3, and v1 is an integer of 0 to 4; 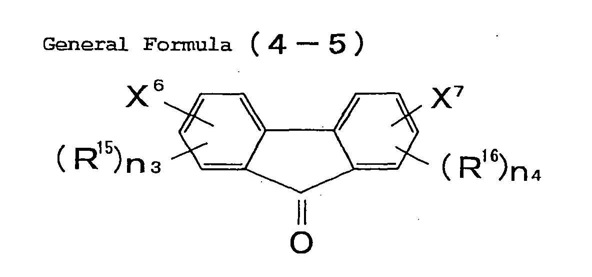 wherein X⁶ and X⁷ are, independently of each other, a halogenic functional group and may be the same or different from each other, R¹⁵ and R¹⁶ are, independently of each other, a monovalent organic group and may be the same or different from each other, n3 is an integer of 0 to 3, and n4 is an integer of 0 to 3; and 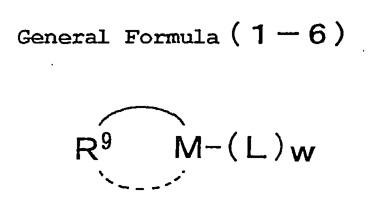 wherein R⁹ is a bidentate chelate ligand having 2 coordinating atoms, M is a divalent to tetravalent metal atom, L is an organic ligand, and w is an integer of 1 to 3.

20. A process for producing the metal complex-containing compound according to claim 16, which comprises steps of reacting a compound represented by the following general formula (1-4) with an organic dihalogenide in which halogen substituents are bonded to both terminals of its main chain to obtain a first intermediate reaction product, reacting this first intermediate reaction product with a compound represented by the following general formula (4-6) to obtain a second intermediate reaction product, and reacting this second intermediate reaction product with a compound represented by the following general formula (1-6) : 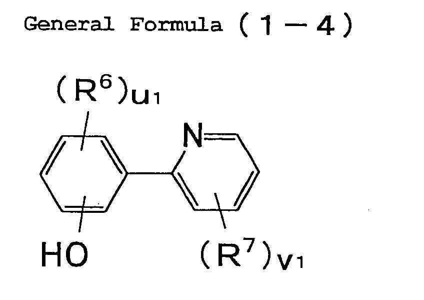 wherein R⁶ and R⁷ are, independently of each other, a fluorine atom, alkyl group or aryl group and may be the same or different from each other, with the proviso that these groups may be substituted or form a cyclic structure, v1 is an integer of 0 to 4, and u1 is an integer of 0 to 3; 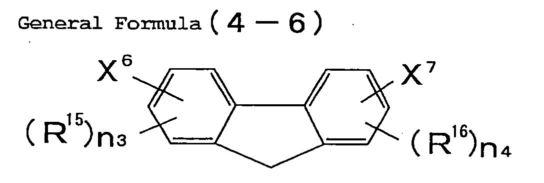 wherein X⁶ and X⁷ are, independently of each other, a halogenic functional group and may be the same or different from each other, R¹⁵ and R¹⁶ are, independently of each other, a monovalent organic group and may be the same or different from each other, n3 is an integer of 0 to 3, and n4 is an integer of 0 to 3; and 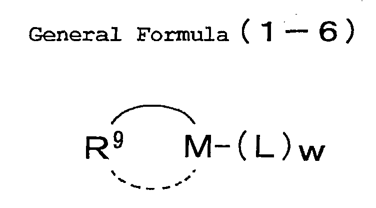 wherein R⁹ is a bidentate chelate ligand having 2 coordinating atoms, M is a divalent to tetravalent metal atom, L is an organic ligand, and w is an integer of 1 to 3.

21. A process for producing the metal complex-containing compound according to claim 16, which comprises steps of reacting a compound represented by the following general formula (4-7) with an organic dihalogenide in which halogen substituents are bonded to both terminals of its main chain to obtain a first intermediate reaction product, reacting this first intermediate reaction product with a compound represented by the following general formula (4-8) to obtain a second intermediate reaction product, reacting this second intermediate reaction product with a compound represented by the following general formula (4-6) to obtain a third intermediate reaction product, and reacting this third intermediate reaction product with a compound represented by the following general formula (1-6): 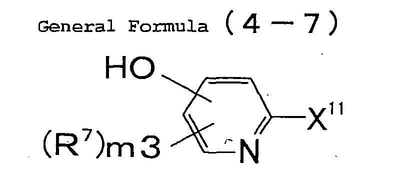 wherein R⁷ is a fluorine atom, alkyl group or aryl group, with the proviso that the group may be substituted or form a cyclic structure, X¹¹ is a halogenic functional group or boron derivative functional group, and m3 is an integer of 0 to 3; 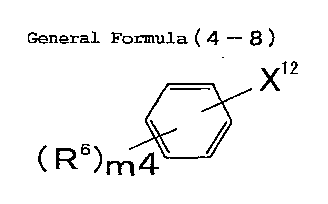 wherein R⁶ is a fluorine atom, alkyl group or aryl group, with the proviso that the group may be substituted or form a cyclic structure, X¹² is a halogenic functional group or boron derivative functional group and is different from X¹¹ in the above general formula (4-7), and m4 is an integer of 0 to 4; 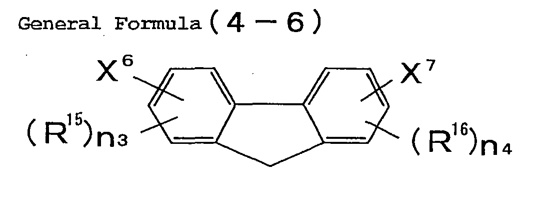 wherein X⁶ and X⁷ are, independently of each other, a halogenic functional group and may be the same or different from each other, R¹⁵ and R¹⁶ are, independently of each other, a monovalent organic group and may be the same or different from each other, n3 is an integer of 0 to 3, and n4 is an integer of 0 to 3; and 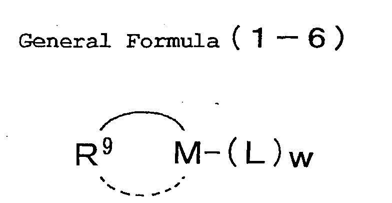 wherein R⁹ is a bidentate chelate ligand having 2 coordinating atoms, M is a divalent to tetravalent metal atom, L is an organic ligand, and w is an integer of 1 to 3.
